(19) Europäisches Patentamt
European Patent Office
Office européen des brevets

(11) Publication number: **0 355 927 B1**

# (12) EUROPEAN PATENT SPECIFICATION

(45) Date of publication of patent specification: **23.11.94**

(51) Int. Cl.5: **C08G 73/10**, C08G 73/12, C08F 283/04, G03F 7/26

(21) Application number: **89202128.8**

(22) Date of filing: **23.08.89**

## (54) A precursor of a low thermal stress polyimide and a photopolymerizable composition containing a polyimide precursor.

(30) Priority: **24.08.88 JP 208454/88**
**16.11.88 JP 287602/88**

(43) Date of publication of application:
**28.02.90 Bulletin 90/09**

(45) Publication of the grant of the patent:
**23.11.94 Bulletin 94/47**

(84) Designated Contracting States:
**CH DE FR GB IT LI NL**

(56) References cited:
**EP-A- 0 247 358**
**EP-A- 0 247 637**

(73) Proprietor: **Asahi Kasei Kogyo Kabushiki Kaisha**
**2-6, Dojimahama 1-chome**
**Kita-ku**
**Osaka-shi Osaka 530 (JP)**

(72) Inventor: **Ai, Hideo**
**351-1, Samejima**
**Fuji-shi Shizuoka-ken (JP)**
Inventor: **Takahashi, Hideaki**
**Endo Apartment A-44**
**68, Aoshima**
**Fuji-shi Shizuoka-ken (JP)**

(74) Representative: **Smulders, Theodorus A.H.J., Ir. et al**
**Vereenigde Octrooibureaux**
**Nieuwe Parklaan 97**
**NL-2587 BN 's-Gravenhage (NL)**



Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

Background of The Invention

### Field Of The Invention

The present invention relates to a precursor of a polyimide and a photopolymerizable composition containing a polyimide precursor. More particularly, the present invention is concerned with a novel polyimide precursor comprising a specific polyamic acid ester, polyamic amide or polyamic acid salt structure, derived from a tetracarboxylic acid compound and a specific diamine compound, which can be converted by heating to a polyimide having low thermal stress. Also, the present invention is concerned with a novel photopolymerizable composition comprising a specific form of this novel polyimide precursor having introduced thereinto an ethylenic double bond and a photopolymerization initiator. Not only this novel precursor but also the crosslinked precursor obtained by the photopolymerization of the novel photopolymerizable composition can be converted by heating to a polyimide resin which has high heat resistance, excellent mechanical properties and satisfactory adhesion to a substrate. The thermal expansion coefficient of the ultimate polyimide resin is low enough to be comparable to those of inorganic materials, so that composite structures comprising a substrate of an inorganic material having disposed thereon the polyimide resin are, unlikely to suffer from thermal stress. Therefore, the precursor and the photopolymerizable composition according to the present invention are advantageously utilized in the production of electrical and electronic components as described later. Moreover, the photopolymerizable composition of the present invention has excellent storage stability and hence is advantageously used as a material for efficiently forming fine patterns by photolithographic techniques.

### Discussion Of Related Art

The thermal expansion coefficients of organic polymers, including polyimide resins are generally 4 x $10^{-5}$ $K^{-1}$ or higher even at temperatures lower than the glass transition temperatures thereof. Such a coefficient value is much higher than those of metals and other inorganic materials. This difference in thermal expansion coefficient often brings about a serious problem in industry. For example, in the case of a polyimide resin which has extremely high heat resistance and hence is now increasingly used as a protective film for IC (integrated circuit) and LSI (large scale integrataed circuit) components, a composite structure (prepared, e.g., by applying such a polyimide resin to a substrate) is likely to suffer from various problems, such as deformation, film cracking or peeling and substrate breakage. These problems occur mainly because the substrate is composed of a metal or other inorganic material having a thermal expansion coefficient significantly lower than that of the polyimide resin and the difference in thermal expansion coefficient causes the composite structure to suffer from marked stress. In particular, when a polyimide resin solution is applied to a silicon wafer and heat-dried to provide IC or LSI components, the wafer is likely to warp. This warpage renders patterning impossible by photolithography, which must be performed in preparing IC or LSI components. Also, the warpage causes the formation of fine patterns to be extremely difficult. Especially when thermal stress due to difference in thermal expansion coefficient is large, problems, such as peeling of the protective film from the wafer substrate and rupture of the wafer substrate, are likely to occur. Further, in the case of a flexible printed circuit obtained by applying a flexible film to a metal foil-prepared circuit by means of coating or thermocompression bonding, a problem of curling arises. The curling is caused by thermal stress due to the difference in thermal expansion coefficient, which occurs during cooling to room temperature after curing and drying at high temperatures subsequent to coating or after thermocompression bonding at high temperatures.

In recent years, extensive efforts have been made to develop a precursor polymer which has photosensitivity and can be converted to a final polymer having desired heat resistance. Such a precursor polymer is especially desired for preparing electronic and optical components, because such a precursor polymer is useful as various functional films, e.g. a surface-protecting film, such as a passivation film, an $\alpha$-ray shield film and a junction coating; an insulation film for semiconductor devices, such as an insulation film disposed between a pair of layers of a multi-layer circuit; an oriented film for liquid crystal display elements; and an insulation film for thin-film magnetic heads or for multi-layer printed circuit boards. In this connection, reference is made to, for example, Kino Zairyo (published by CMC Kabushiki Kaisha, Japan), July issue, pages 9-19 (1983), and Photographic Science and Engineering (published by SPSE Society For Imaging Science And Technology, the United States), pages 303-309 (1979).

Various photosensitive compositions (which contain a polyimide precursor convertible to a polyimide having desirable heat resistance) useful for photolithography are known in the art. An example of such compositions (disclosed in U.S. Patent No. 3,957,512 and U.S. Patent Reissue No. 30,186) comprises a polymer prepared by introducing an active functional group, such as a group having an ethylenic double bond, into ester side chains of a polyamic acid ester which is a polyimide precursor, and a photopolymerization initiator. Another example of such compositions (disclosed in Japanese Patent Application Laid-Open Specifications No. 57-168,942, No. 54-145,794 and No. 59-160,140) comprises a mixture of a polyamic acid and an amine compound having an active functional group, such as a group having an ethylenic double bond. These compositions, however, have a disadvantage in that a polyimide formed by exposure to actinic radiation and heating of the compositions exhibits a high thermal expansion coefficient, not differing from other organic polymers, and hence cannot be free from the hereinbefore mentioned problems caused by a thermal stress due to difference in thermal expansion coefficient between a polymer film and a substrate of a metal or other inorganic material.

Recently, various proposals have been made for providing a polyimide having a low thermal expansion coefficient. Such proposals include those of Numata et al (see JP-A-60-152,786, JP-A-60-208,358, JP-A-60-243,120, JP-A-60-250,031 and JP-A-61-60,725), Matsuura et al (see JP-A-60-210,629, JP-A-60-210,894, JP-A-60-221,426, JP-A-60-221,427 and JP-A-61-69,833) and Numata, Kinjo, et al (see JP-A-61-175,035). In these proposals, it is inevitably necessary to orient the polyimide to obtain a desired thermal expansion coefficient. However, disadvantageously, orientation of the polyimide cannot be attained in a coating process. In addition, it is noted that the above-mentioned proposed polyimides having a low thermal expansion coefficient are generally prepared from a precursor of a polyamic acid which is not photosensitive. Accordingly, in order to accomplish patterning by photolithography, it is necessary to apply a photopolymerizable composition onto a polyimide coating, expose the composition through a photomask to actinic radiation, effecting development to wash-out the unexposed portions of the composition and etching the polyimide coating at portions in registry with the unexposed portions by means of hazardous hydrazine. To avoid this time-consuming and hazardous procedure, a precursor of a polyamic acid which is photosensitive is desired.

Polyimides generally have poor water resistance. To obviate this drawback, polyimides into which a heterocyclic group, such as an imidazolyl group and an oxazolyl group, has been introduced, have been proposed. With respect to such polyimides, reference is made to, for example, Japanese Patent Application Publication Specifications No. 45-24,593 and No. 46-120 (Yoda, Dokoshi et al); page 86 and subsequent pages of the book entitled "Thermal Decomposition and Heat Resistance of Polymers" and published by Baifukan, Japan; and US-A-4,087,409 and US-A-3,661,849 to J. Preston, B.M. Culbertson, et al. The polyimides disclosed in these references generally have a flexible molecular bond introduced to improve mechanical strength and heat resistance. Accordingly, these polyimides have a high thermal expansion coefficient, which causes the polyimides to suffer from the drawbacks described hereinbefore.

All of the above-mentioned polyimides proposed by Numata et al, Matsuura et al, Numata, Kinjo et al, Yoda, Dokoshi et al and Preston, Culbertson et al are generally obtained by heating a polyamic acid at a temperature suitable for the imidization of the polyamic acid. In this connection, it should be noted that the polyamic acid is likely to be hydrolyzed at the time of such heating. The hydrolysis causes a reduction in molecular weight, leading to a lowering in physical properties, such as mechanical strength and thermal expansion coefficient characteristics (see JP-A-61-181833). To cope with this problem, a polyamic acid having a high molecular weight is used. Since a polyamic acid having a high molecular weight gives a solution having a high viscosity, it is disadvantageous as a coating material from the viewpoint of ease in coating. The viscosity of the solution can be decreased by decreasing the polyamic acid concentration of the solution. However, with such a low concentration solution, it is difficult to form a film having desired thickness. These disadvantages are noted especially with respect to the above-mentioned polyimides having a low thermal expansion coefficient.

Moreover, the polyamic acids employed by Numata et al, Matsuura et al, Matsuura et al, Numata, Kinjo et al, Yoda, Dokoshi et al and Preston, Culbertson et al, are unstable in a solution and hence have poor storage stability. The polyamic acids are quickly hydrolyzed in a solution, thereby lowering the viscosity of the solution.

In EP-A-0 247 358 a copolymeric and amphiphilic polyimide precursor of the type of formula (I) and (II) as shown hereinbelow, is described.

This precursor can provide thin films by the Langmuir-Blodgett (LB) technique, and by ring closure of the obtained LB films, there can be obtained ultrathin films having good mechanical and physico-chemical properties.

EP-A 0 247 637 describes a copolymerized polyamic acid salt which is able to form a thin film by a LB method. These precursors bear units having two C(O)-ON(R)$_3$ groups coupled to a tetravalent moiety, wherein R is a hydrogen atom or a monovalent group having 1-30 carbon atoms.

Generally, the conventional polyimides have poor adhesion to a substrate of an inorganic material, such as glass and metal. In order to improve adhesion, attempts have been made to treat a substrate with a silane coupling agent or a chelating agent for titanium, aluminum, etc. However, this treatment cannot solve the problem of poor water resistance of adhesion between the polyimide and the inorganic material. This disadvantage is especially noted with respect to conventional polyimides having a low thermal expansion coefficient.

## Summary Of The Invention

In view of the current situation as described above, the present inventors have conducted extensive and intensive studies with a view toward developing a polyimide precursor and a polyimide precursor-containing photopolymerizable composition which are free from the above-described drawbacks of the prior art. Particularly, the inventors' studies have been directed to development of a polyimide precursor which exhibits not only a low viscosity even when used in the form of a solution of a high precursor concentration but also excellent storage stability, and which can be converted by heating to a polyimide having a low thermal expansion coefficient and exhibiting excellent water-resistant adhesion to a substrate of an inorganic material. The inventors' studies have also been directed to development of a photopolymerizable composition containing such a polyimide precursor, which is useful especially for forming a pattern by photolithography. As a result of these studies, it has unexpectedly been found that a novel polyimide precursor (comprising a specific polyamic acid ester, polyamic amide or polyamic acid salt structure, derived from a tetracarboxylic acid compound and a specific diamine compound) exhibits low viscosity (even when used in the form of a solution of a high precursor concentration) and excellent storage stability, and which is easily converted by heating to a polyimide having a low thermal expansion coefficient and exhibiting excellent water-resistant adhesion to a substrate of an inorganic material, thereby obviating the above-described drawback inevitably accompanying the conventional polyimide resins. The present invention is based on these novel findings.

Accordingly, it is an object of the present invention to provide a novel polyimide precursor which exhibits not only a low viscosity even when used in the form of a solution of a high precursor concentration but also excellent storage stability, and which can be converted by heating to a polyimide having a low thermal expansion coefficient and exhibiting excellent water-resistant adhesion to a substrate of an inorganic material.

It is another object of the present invention to provide a photopolymerizable composition containing a specific form of such a precursor having introduced thereinto an ethylenic double bond, and which is useful for efficiently forming (by photolithography) fine patterns of the polyimide having excellent properties.

It is a further object of the present invention to provide composite structures useful in the electric and electronic industries, respectively, produced from the above-mentioned precursor and photopolymerizable composition.

The foregoing and other objects, features and advantages of the present invention are apparent from the following detailed description and appended claims taken in connection with the accompanying drawings.

## Brief Description Of The Drawings

In the accompanying drawings:

Fig. 1 is a diagrammatic cross-sectional view of an LSI board having two aluminum circuit layers in which films of a polyimide prepared from the precursor or photopolymerizable composition of the present invention are provided as insulating films, which is one form of the composite structure of the present invention, produced in Example 55 described later; and

Fig. 2 (A) through Fig. 2 (I) are diagrammatic views illustrating the operation steps performed in the production of a copper-polyimide multi-layer circuit which is produced in Example 56 described later.

## Detailed Description Of The Invention

In one aspect of the present invention, there is provided a precursor of a low thermal stress polyimide comprising recurring units represented by at least one formula selected from the group consisting of:

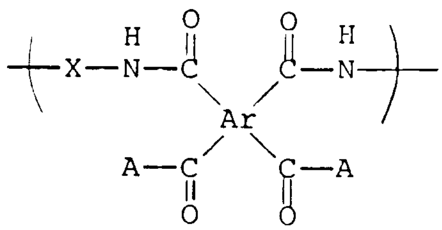

(I) , and

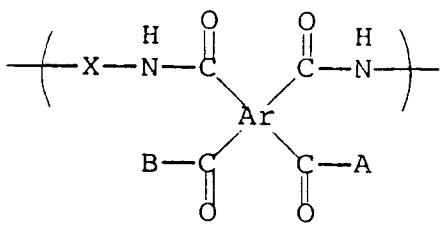

(II)

wherein Ar represents a tetravalent aromatic group having 6 to 30 carbon atoms,

X represents at least one divalent organic group having 6 to 30 carbon atoms, and each of A and B independently represents a group selected from the group consisting of:

$-OR^1$,

$$-\overset{H}{N}R^1,$$

$-O^{\ominus}R^{2\oplus}$ and -OH,

wherein each of $R^1$ and $R^2$ independently represents an organic group having 1 to 20 carbon atoms,

provided that A and B are not simultaneously -OH;

at least 20 mole % of the recurring units being units represented by at least one formula selected from the group consisting of:

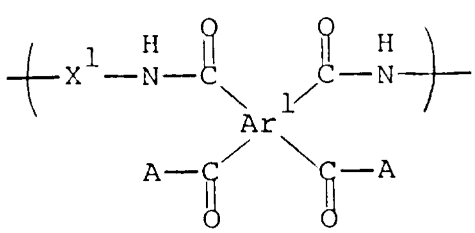

(III) , and

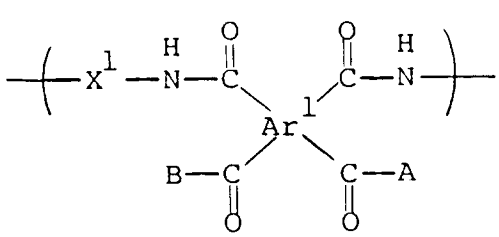

(IV)

wherein $Ar^1$ represents a tetravalent aromatic group selected from the group consisting of:

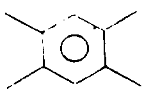, 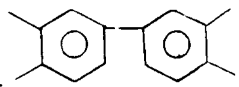 and 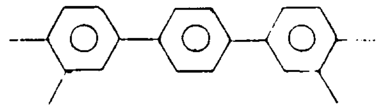 ,

A and B are as defined above, and $X^1$ represents at least one divalent group selected from the group consisting of:

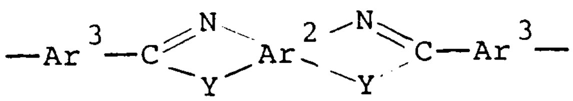 and

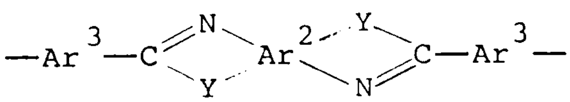 ,

wherein $Ar^2$ represents a tetravalent aromatic group selected from the group consisting of:

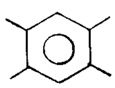 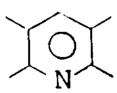 and 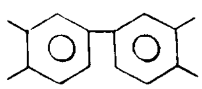 ,

$Ar^3$ represents a divalent aromatic group selected from the group consisting of:

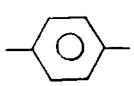, 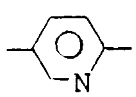 and 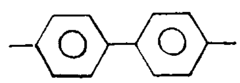 ,

and

Y represents a divalent group selected from the group consisting of -O-, -S-,

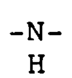 and 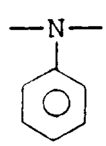 ;

the precursor having a reduced viscosity of from 10 to 200 ml/g as measured at 30 °C with respect to a 1.0 g/dl solution of the precursor in N-methylpyrrolidone.

As mentioned above, the precursor of the present invention comprises recurring units represented by at least one formula selected from the group consisting of formulae (I) and (II). In formulae (I) and (II), Ar represents a tetravalent aromatic group having 6 to 30 carbon atoms. Representative examples of Ar include a tetravalent aromatic polycyclic hydrocarbon residue, such as tetravalent benzene, naphthalene and anthracene groups; a tetravalent heterocyclic group, such as pyridine and thiophene groups; and a tetravalent group represented by the formula:

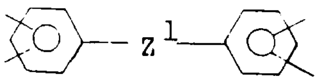 (II-1)

wherein $Z^1$ is selected from the group consisting of $-(CH_2)_{\ell}-$ in which $\ell$ is 0 or 1,

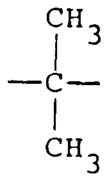 , 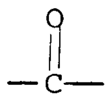 , —S—, 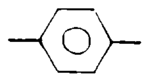 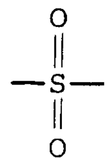 , —O—,

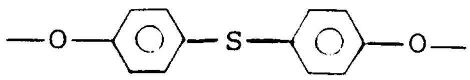 and

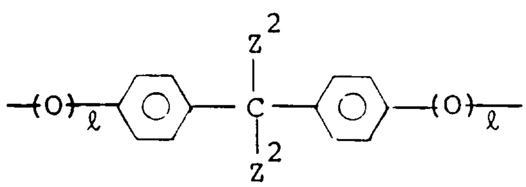 ,

in which $\ell$ is as defined above and $Z^2$ represents $-CH_3$ or $-CF_3$. Of the above-mentioned tetravalent groups,

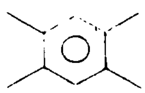 , 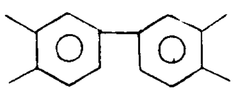 and 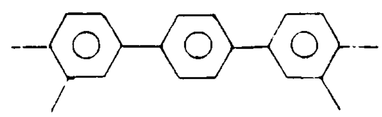

are preferred.

In formulae (I) and (II), X represents at least one divalent organic group having 6 to 30 carbon atoms. Representative examples of X include the groups of formula $X^1$ indicated above and the groups represented by the formulae:

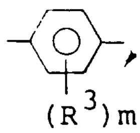, 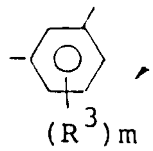, 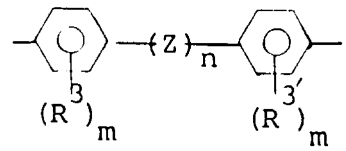, 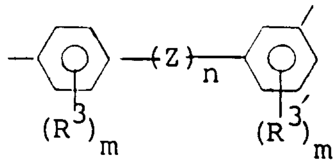

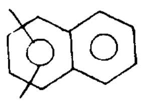, 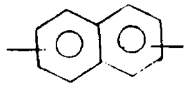, 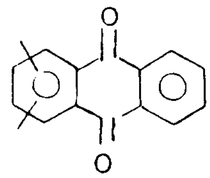, 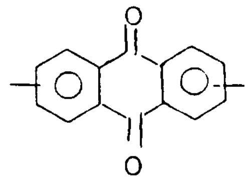,

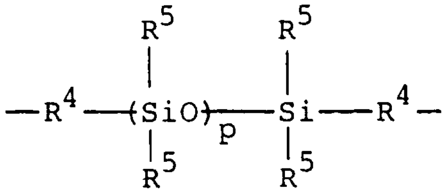 and 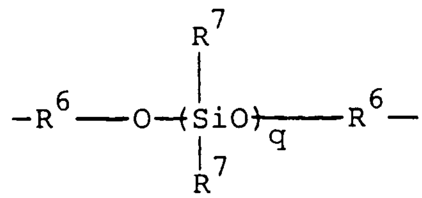,

wherein each of $R^3$ and $R^{3'}$ independently represents a monovalent group selected from the group consisting of an alkyl group, an alkoxy group, a fluorinated alkyl group and a fluorinated alkoxy group (each having 1 to 5 carbon atoms) or a fluorine atom;

Z represents a divalent group selected from the group consisting of:

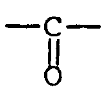, 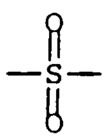, —O—, 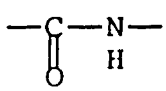, —$CH_2$—, 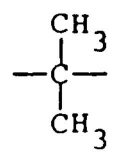, 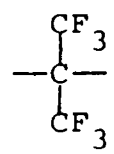,

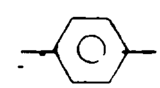, 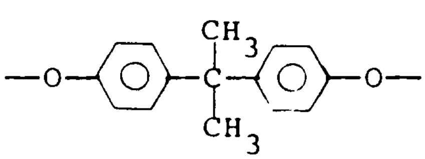, 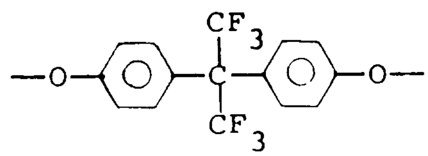

and 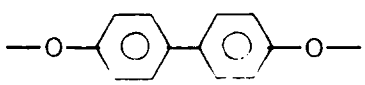;

each of $R^4$ and $R^6$ independently represents a divalent hydrocarbon residue having 1 to 14 carbon atoms;

each of $R^5$ and $R^7$ independently represents a monovalent hydrocarbon residue having 1 to 16 carbon atoms; and

m is an integer of from 0 to 4, n is an integer of 0 or 1, and each of p and q is independently an integer equal to or greater than 1, preferably from 1 to 50.

In the present invention, at least 20 mole %, preferably at least 50 mole %, of the entire recurring units are units represented by at least one formula selected from the group consisting of formulae (III) and (IV). When the proportion of the units represented by at least one formula selected from the group consisting of formulae (III) and (IV) is less than 20 mole %, the final polyimide disadvantageously has a high thermal expansion coefficient, poor mechanical strength and poor water resistance of adhesion.

In formulae (III) and (IV), $Ar^1$ represents a tetravalent aromatic group selected from the group consisting of:

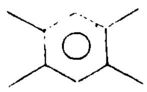, 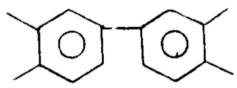 and 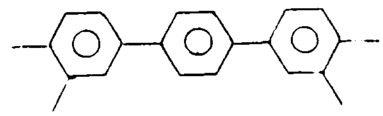,

and $X^1$ represents at least one divalent group selected from the group consisting of:

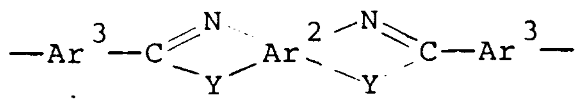 and

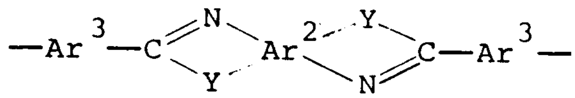,

wherein $Ar^2$ represents a tetravalent aromatic group selected from the group consisting of:

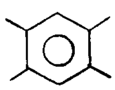, 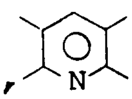 and 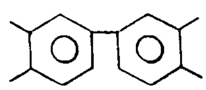,

$Ar^3$ represents a divalent aromatic group selected from the group consisting of:

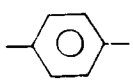, 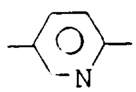 and 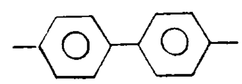,

and

Y represents a divalent group selected from the group consisting of -O-, -S-,

$-\underset{H}{N}-$ and 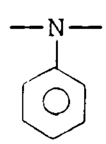.

From the viewpoint of the desired excellent solubility and storage stability of a polyimide precursor which can be converted to a polyimide having excellent water-resistant adhesion and mechanical strength, it is preferred that the unit of formula (III) be selected from the group consisting of:

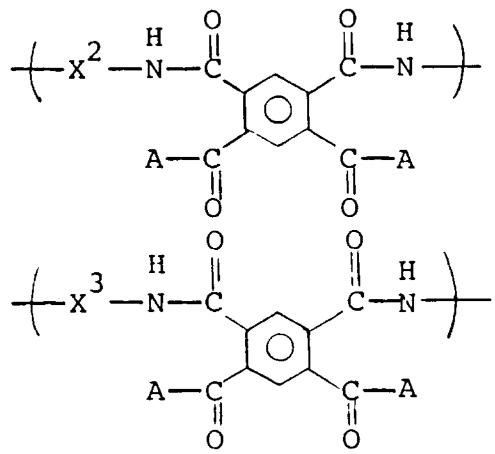

(III-1)

(III-2)

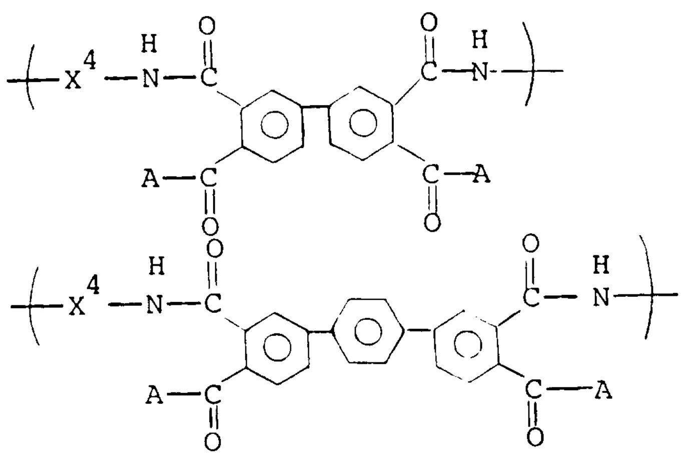

(III-3), and

(III-4)

wherein A and B are as defined above,
$X^2$ represents at least one divalent group selected from the group consisting of:

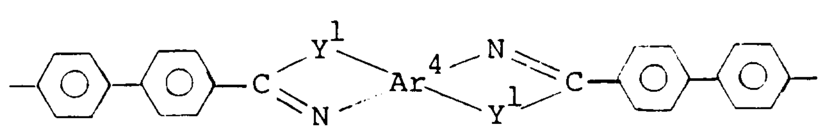

and

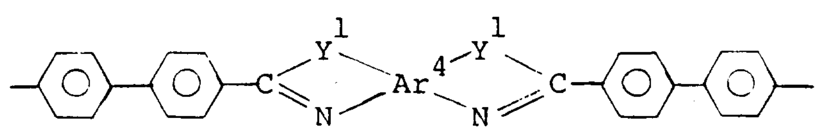

,

wherein $Ar^4$ represents a tetravalent group selected from the group consisting of:

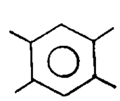

and

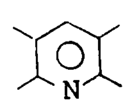

, and

$Y^1$ represents a divalent group selected from the group consisting of:
-O-, -S- and

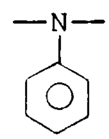 ;

$X^3$ represents at least one divalent group selected from the group consisting of:

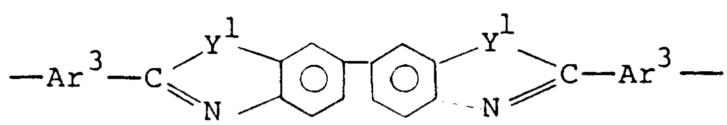 and

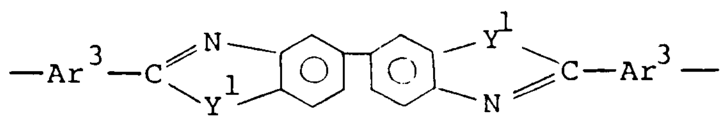

wherein $Ar^3$ and $Y^1$ are as defined above, and $X^4$ represents at least one divalent group selected from the group consisting of:

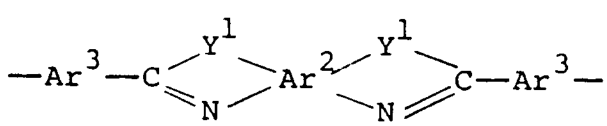 and

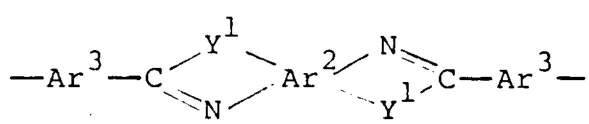

wherein $Ar^2$, $Ar^3$ and $Y^1$ are as defined above.

Also, from the viewpoint of the desired excellent solubility and storage stability of a polyimide precursor which can be converted to a polyimide having excellent water-resistant adhesion and mechanical strength, it is preferred that the unit of formula (IV) be selected from the group consisting of:

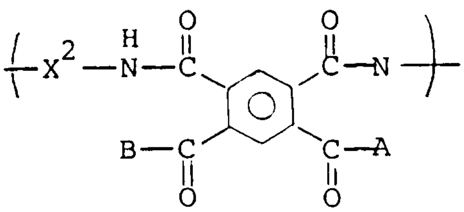

(IV-1)

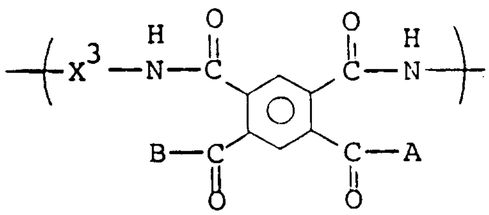

(IV-2)

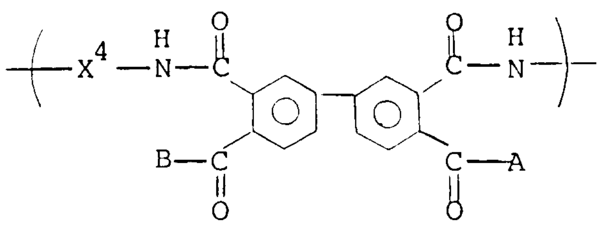

(IV-3), and

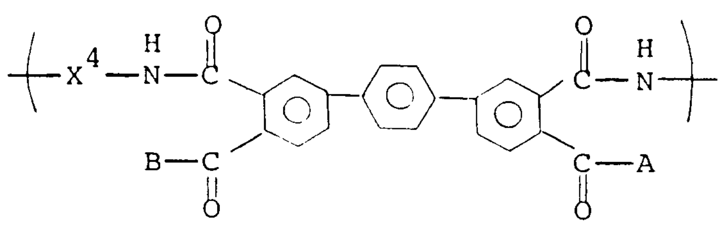

(IV-4)

wherein A, B, $X^2$, $X^3$ and $X^4$ are as defined above.

In formulae (I) to (IV), each of A and B independently represents a group selected from the group consisting of:

$-OR^1$,

$$-\overset{H}{N}R^1,$$

$-O^{\ominus}R^{2\oplus}$ and -OH,

wherein each of $R^1$ and $R^2$ independently represents an organic group having 1 to 20 carbon atoms, provided that A and B are not simultaneously -OH.

From the viewpoint of the desired excellent solubility in a solvent and excellent storage stability of a precursor it is preferred that each of A and B independently represents $-OR^1$.

Representative examples of the above-mentioned $R^1$ include an alkyl group and an alkoxyalkyl group each having 1 to 20 carbon atoms, a phenyl group, a benzyl group and a group selected from the group consisting of:

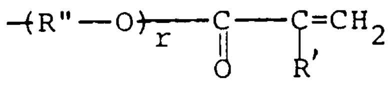 (I-1)

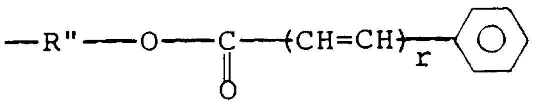 (I-2)

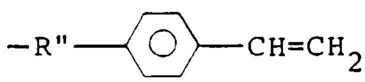 (I-3)

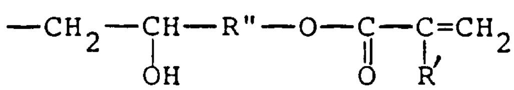 (I-4)

$—R''—CH=CH_2$ (I-5) , and

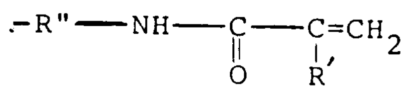 (I-6)

wherein R' represents a hydrogen atom or a methyl group, R'' represents an alkylene group having 1 to 3 carbon atoms, and r is an integer of 1 or 2.

When the polyimide precursor is used for providing a photopolymerizable composition, the groups of formulae (I-1) to (I-6) are preferred as $R^1$ from the viewpoint of the desired photopolymerizability of the resultant photopolymerizable composition. Of these, the groups of formulae (I-1) and (I-4) are most preferred as $R^1$.

In particular, $R^1$ may be selected from a methyl group, an ethyl group, an n-propyl group, an isopropyl group, an n-butyl group, an isobutyl group, a phenyl group, a benzyl group, a 2-methoxyethyl group, a 3-methoxy-1-propyl group, a 2,3-dimethoxy-1-propyl group,

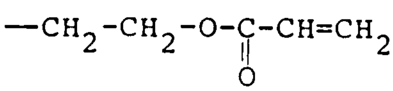 , 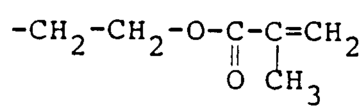 ,

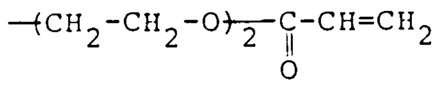, 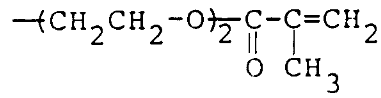,

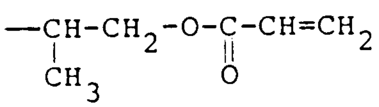, 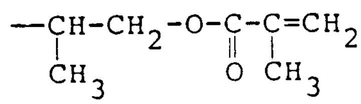,

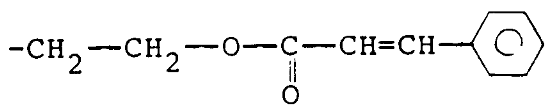,

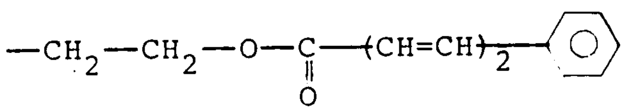,

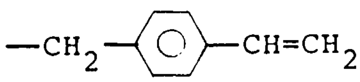,

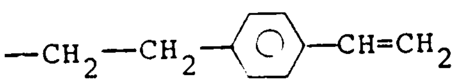,

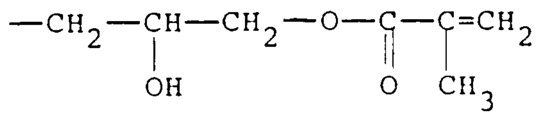,

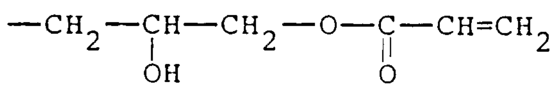,

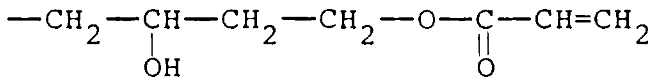,

$-CH_2-CH=CH_2$,

$-CH_2-CH_2-CH=CH_2$,

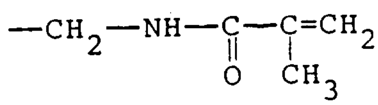 and

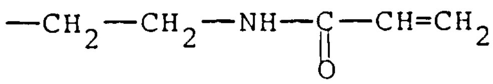.

Of the above-indicated groups, a 2-methoxyethyl group, a 3-methoxy-1-propyl group and a 2,3-dimethoxy-1-propyl group are preferred, because a precursor which has a high solubility in an organic solvent and hence can advantageously be formulated into a coating material can be produced. On the other hand, when the polyimide precursor is used for providing a photopolymerizable composition, from the viewpoint of the desired excellent storage stability and photopolymerizability of the resultant photopolymerizable composition, the following groups are preferred as $R^1$:

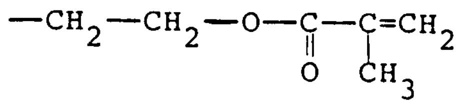,

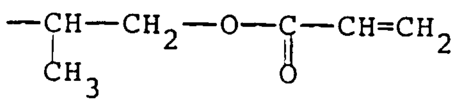,

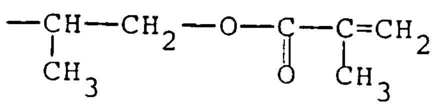,

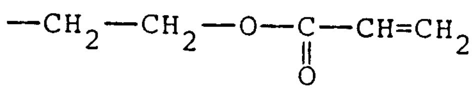,

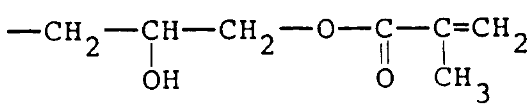 and

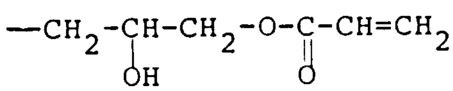 .

In formulae (I) to (IV), representative examples of $R^{2\oplus}$ include the groups represented by the formulae:

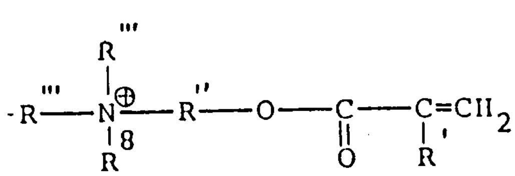 (I-7) and

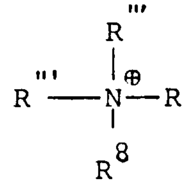

(I-8)

wherein R represents an alkyl group or an alkoxyalkyl group each having 1 to 15 carbon atoms, each of R' and $R^8$ independently represents a hydrogen atom or a methyl group, R'' is an alkylene group having 1 to 3 carbon atoms, and R''' is a methyl group or an ethyl group.

When the polyimide precursor is used for providing a photopolymerizable composition, the group of formula (I-7) is preferred as $R^{2\oplus}$ from the viewpoint of the desired photopolymerizability of the resultant composition. Representative examples of groups of formula (I-7) include:

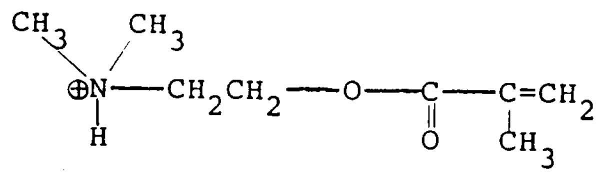

,

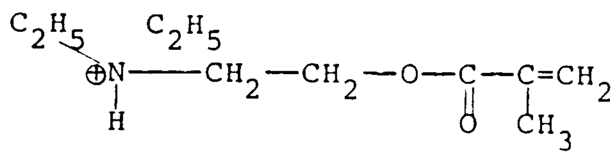

and

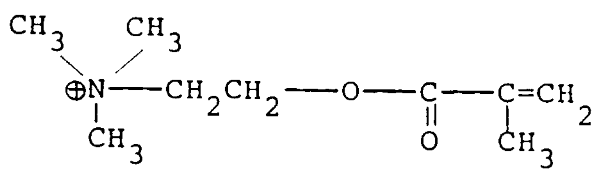

.

The precursor of the present invention has a reduced viscosity of from 10 to 200 ml/g as measured at 30 °C with respect to a 1.0 g/dl solution of the precursor in N-methylpyrrolidone. When the reduced viscosity of the precursor is less than 10 ml/g as measured at 30 °C with respect to a 1.0 g/dl solution of the precursor in N-methylpyrrolidone, the precursor cannot provide a low thermal stress polyimide having a sufficient mechanical strength. On the other hand, when the reduced viscosity of the precursor exceeds 200 ml/g as measured at 30 °C with respect to a 1.0 g/dl solution of the precursor in N-methylpyrrolidone, a solution of the precursor in a solvent has such a high viscosity that coating of the solution becomes difficult. Further, such a high viscosity is likely to cause the development after exposure and the formation of fine patterns to be difficult when the precursor is used as a photopolymerizable component of a photopolymerizable composition.

In the present invention, X and/or Ar of the unit of formula (I) may be identical with or different from X and/or Ar of the unit of formula (II). Likewise, $X^1$ and/or $Ar^1$ of the unit of formula (III) may be identical with or different from $X^1$ and/or $Ar^1$ of the unit of formula (IV). When a precursor in which X and/or Ar are/is the same in both the units of formulae (I) and (II), and $X^1$ and/or $Ar^1$ are/is the same in both the units of formulae (III) and (IV) has unsatisfactory properties, it is possible to improve the properties by performing copolymerization such that the resultant precursor comprises units of formulae (I) and (II) which have different X and/or Ar and units of the formulae (III) and (IV) which have different $X^1$ and/or $Ar^1$. In place of such copolymerization, it is also possible to improve the properties by performing blending of precursors

which have different X and/or Ar and/or have different $X^1$ and/or $Ar^1$.

The precursor of the present invention may be applied to a substrate and heated to convert the precursor to a polyimide corresponding thereto, thereby producing a composite structure as described later. The heating is generally conducted at a temperature of 150° to 500 °C. Representative examples of substrates include those made of a metal, a glass, a silicon or silicon carbide semiconductor material, a compound semiconductor material, a metal oxide insulating material and silicon nitride; and also include a copper-clad glass-epoxy laminate and the like.

If desired, the precursor of the present invention may be mixed with a silane compound to improve the adhesion of the ultimate polyimide to a substrate of an inorganic material. Representative examples of silane compounds include γ-aminopropylmethyldimethoxysilane, γ-aminopropylmethyldiethoxysilane, γ-aminopropyltrimethoxysilane, γ-aminopropyltriethoxysilane, N-β-aminoethyl-γ-aminopropyldimethoxysilane, N-β-aminoethyl-γ-aminopropylmethyldiethoxysilane, N-β-aminoethyl-γ-aminopropyltrimethoxysilane, N-β-aminoethyl-γ-aminopropyltriethoxysilane, γ-glycidoxypropylmethyldimethoxysilane, γ-glycidoxypropylmethyldiethoxysilane, γ-mercaptopropylmethyldimethoxysilane, dimethoxy-3-mercaptopropylmethylsilane, γ-mercaptopropylmethyldiethoxysilane, 3-methacryloxypropyldimethoxymethylsilane, 3-methacryloxypropyldiethoxymethylsilane, 3-methacryloxypropyltrimethoxysilane, 3-methacryloxypropyltriethoxysilane, dimethoxymethyl-3-piperidinopropylsilane, diethoxy-3-glycidoxypropylmethylsilane, diethoxymethyl-3-piperidinopropylsilane, N-(3-dimethoxymethylsilylpropyl)succinimide, N-(3-diethoxymethylsilylpropyl)-succinimide, phenyldimethoxymethylsilane and phenyldiethoxymethylsilane.

The amount of silane compound is generally in the range of from 0.05 to 10 % by weight, preferably from 0.1 to 5 % by weight, based on the weight of the precursor.

One form of a precursor according to the present invention, in which the organic group of each of $R^1$ and $R^2$ of each of the units of formulae (I) through (IV) has an ethylenic double bond and which has a reduced viscosity of from 10 to 100 ml/g, is advantageously used for preparing a photopolymerizable composition together with at least one photopolymerization initiator.

Therefore, in another aspect of the present invention, there is provided a photopolymerizable composition comprising:

(a) a precursor of a low thermal stress polyimide comprising recurring units represented by the formula:

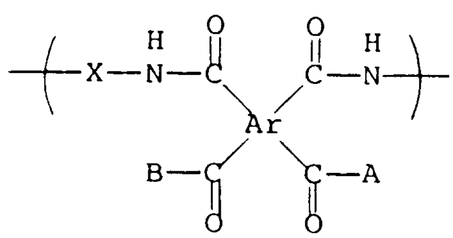

(II)

wherein Ar represents a tetravalent aromatic group having 6 to 30 carbon atoms, X represents at least one divalent organic group having 6 to 30 carbon atoms, and each of A and B independently represents a group selected from the group consisting of:

$-OR^1$,

$$-\overset{H}{N}R^1,$$

$-O^{\ominus}R^{2\oplus}$ and -OH,

wherein each of $R^1$ and $R^2$ independently represents an organic group having 1 to 20 carbon atoms and containing an ethylenic double bond,

provided that A and B are not simultaneously -OH; at least 20 mole % of the recurring units being units represented by the formula:

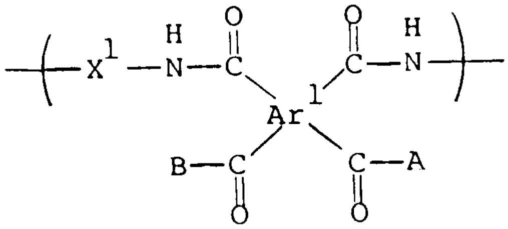

(IV)

wherein $Ar^1$ represents a tetravalent aromatic group selected from the group consisting of:

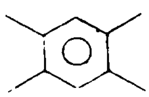 , 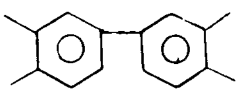 and 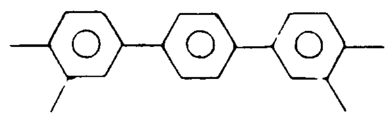 ,

A and B are as defined above, and
$X^1$ represents at least one divalent group selected from the group consisting of:

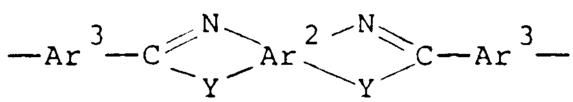 , and

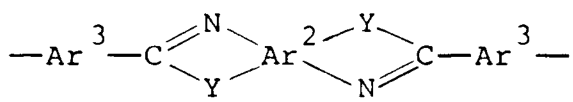 ,

wherein $Ar^2$ represents a tetravalent aromatic group selected from the group consisting of:

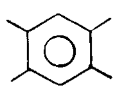 , 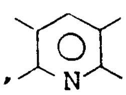 and 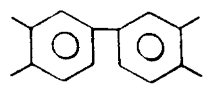 ,

$Ar^3$ represents a divalent aromatic group selected from the group consisting of:

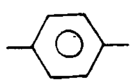 , 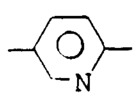 and 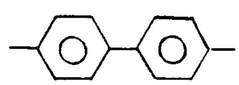 ,

and

Y represents a divalent group selected from the, group consisting of -O-, -S-,

$-\underset{H}{N}-$ and 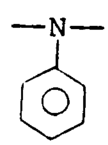 ;

the precursor having a reduced viscosity of from 10 to 100 as measured at 30 °C with respect to a 1.0 g/dl solution of the precursor in N-methylpyrrolidone, and

(b) at least one photopolymerization initiator.

In the photopolymerizable composition of the present invention, it is essential that the organic group of each of $R^1$ and $R^2$ of each of the units of formulae (I) through (IV) of the precursor has an ethylenic double bond and the precursor has a reduced viscosity of from 10 to 100 ml/g. Such organic groups are described hereinbefore. The incorporation of the ethylenic double bond is essential for obtaining the desired photosensitivity of the composition, and the viscosity is essentially as low as 10 to 100 ml/g for facilitating the coating of the composition.

Representative examples of photopolymerization initiators to be used for the photopolymerizable composition of the present invention include anthraquinone; anthraquinone derivatives, such as 2-methylanthraquinone and 2-ethylanthraquinone; benzoin; benzoin derivatives, such as benzoin methyl ether and benzoin butyl ether; thioxanthone derivatives, such as chlorothioxanthone and diisopropyl thioxanthone; benzophenone; benzophenone derivatives, such as 4,4'-dichlorobenzophenone, Michler's ketone [4,4'-bis-(dimethylamino)benzophenone], 4,4'-bis(diethylamino)benzophenone, dibenzosuberone, anthrone and methyl bianthranyl o-benzoyl benzoate; benzil; benzil derivatives, such as benzil dimethyl ketal and benzil-β-methoxyethyl acetal; acetophenone derivatives, such as p-dimethylaminoacetophenone, p-t-butyltrichloroacetophenone, 2-hydroxy-2-methylpropiophenone and 2,2-diethoxyacetophenone; and oximes represented by formula (V):

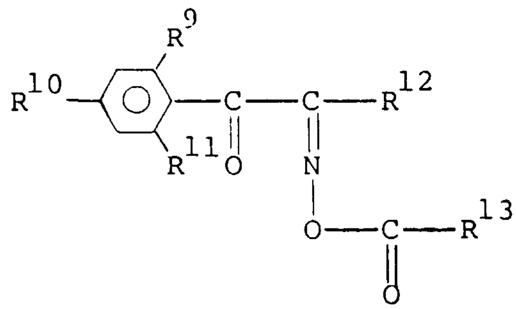

(V)

wherein each of $R^9$, $R^{10}$ and $R^{11}$ independently represents a hydrogen atom, an alkyl group having 1 to 6 carbon atoms, an alkoxy group having 1 to 6 carbon atoms or a nitro group; $R^{12}$ represents an aromatic acyl group having 7 to 11 carbon atoms, an aliphatic acyl group having 2 to 7 carbon atoms, an alkoxycarbonyl group having 2 to 7 carbon atoms, an aromatic sulfonyl group having 6 to 10 carbon atoms or an aliphatic sulfonyl group having 1 to 6 carbon atoms; and $R^{13}$ represents an alkyl group having 1 to 6 carbon atoms, an alkoxy group having 1 to 6 carbon atoms, an aromatic group having 6 to 10 carbon atoms or an aryloxy group having 6 to 10 carbon atoms.

Of these photopolymerization initiators, oxime photopolymerization initiators are especially preferred from the viewpoint of the desired photosensitivity of the final photopolymerizable composition. Representative examples of oxime photopolymerization initiators include

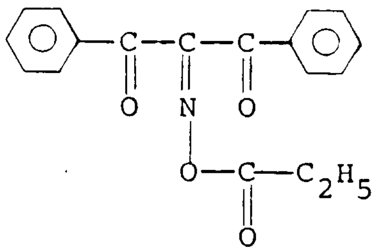 , 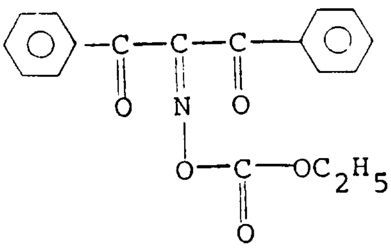 ,

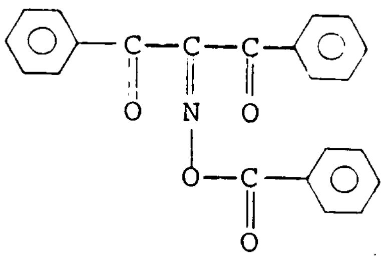 , 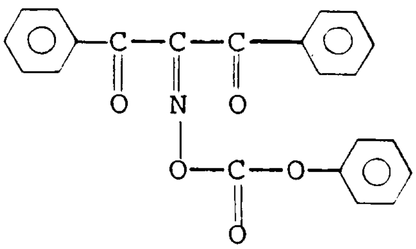 ,

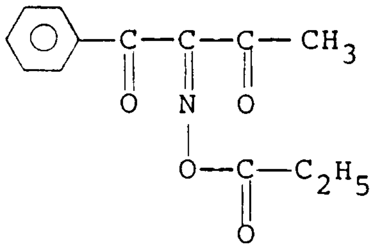
,
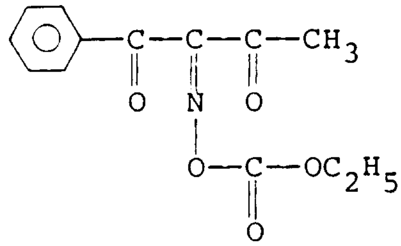
,

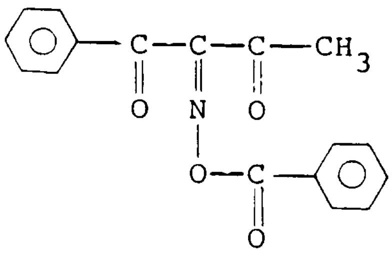
,
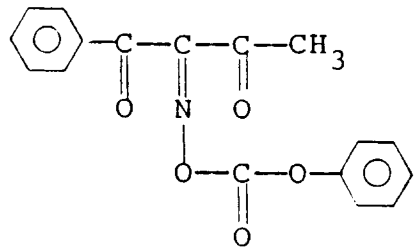
,

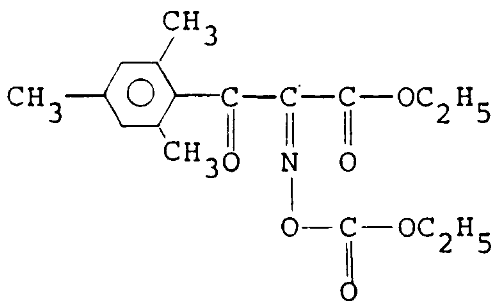
,
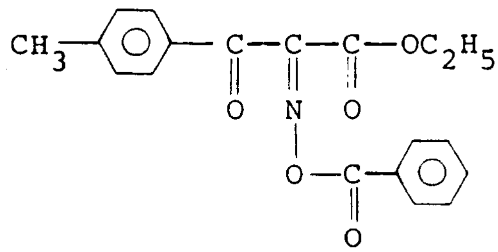
,

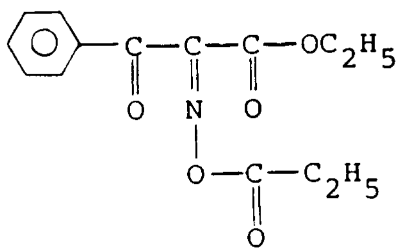
,
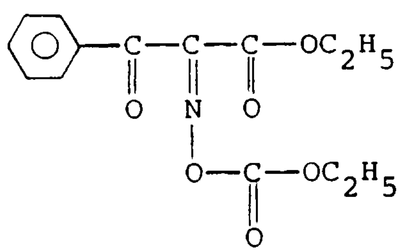
,

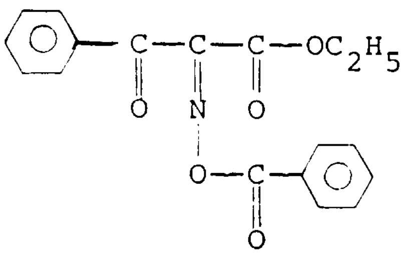 , 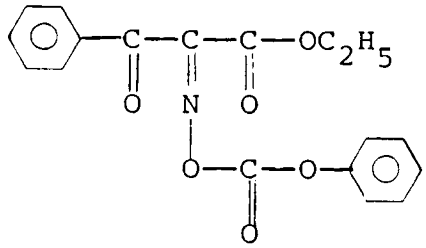 ,

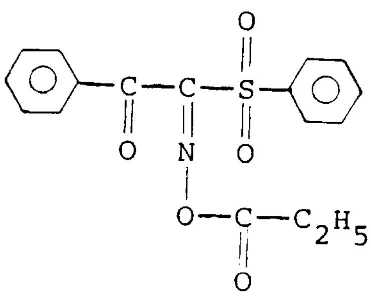 , 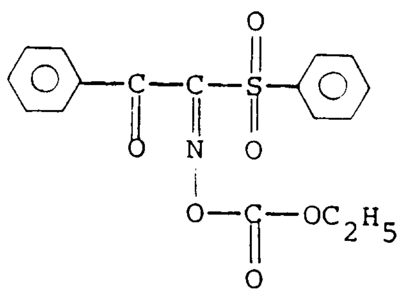 ,

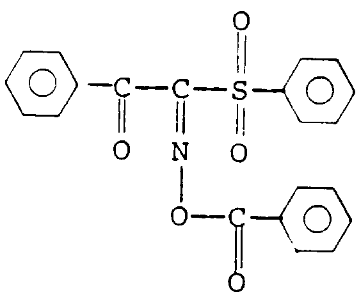 , 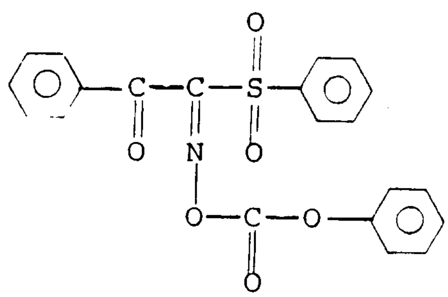 ,

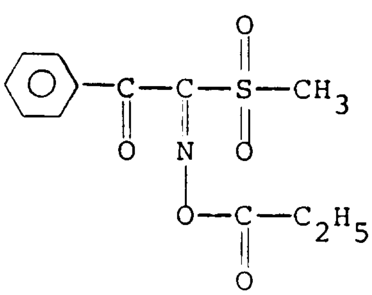 , 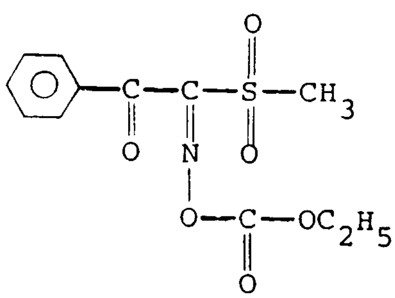 ,

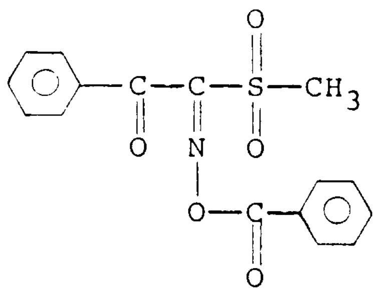

,

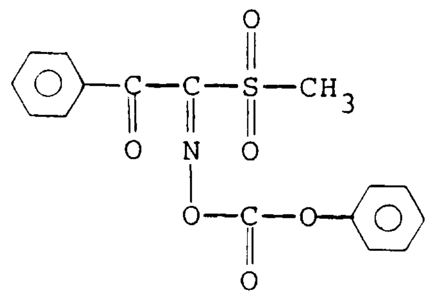

,

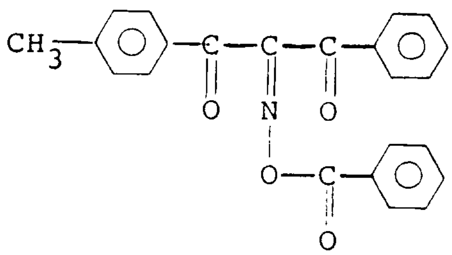

,

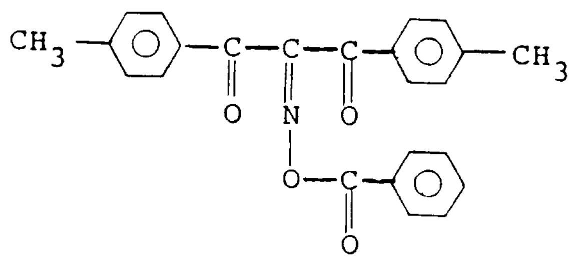

,

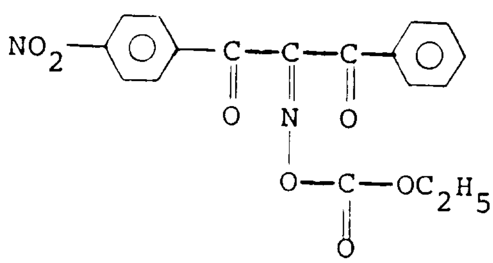

,

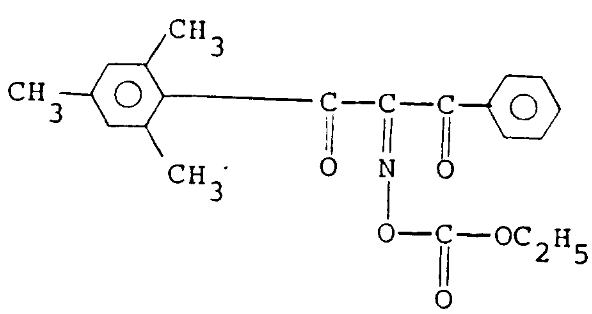

,

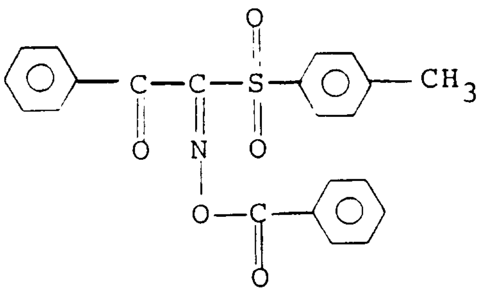
,
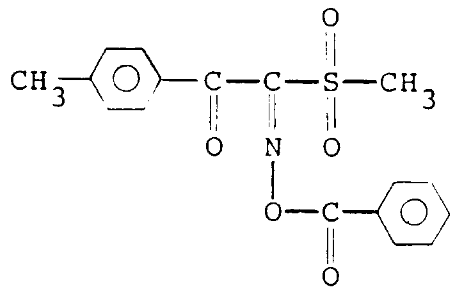
,

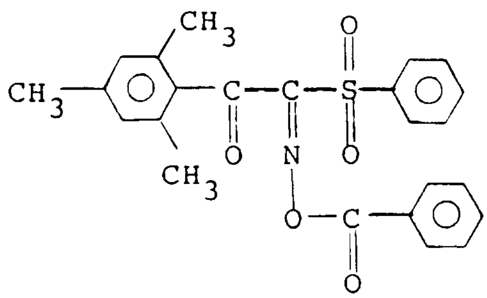
,
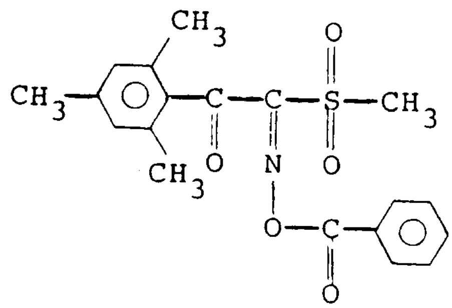
,

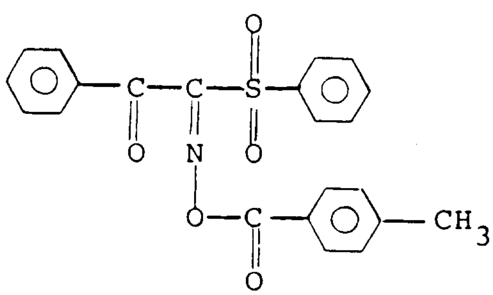
,
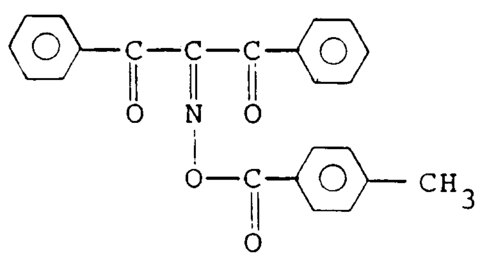
,

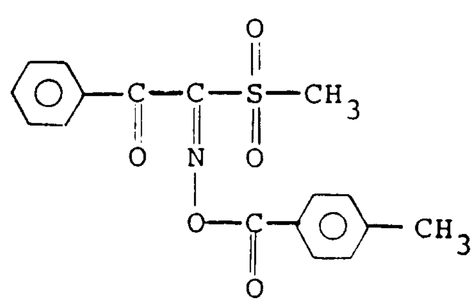
and
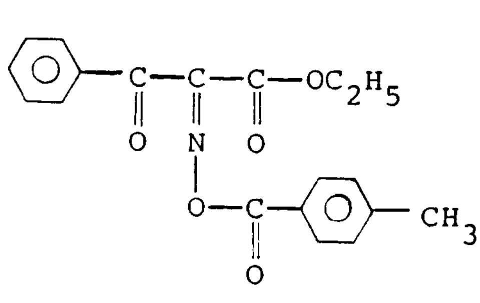
.

However, oxime photopolymerization initiators are by no means restricted to these specific examples.

The photopolymerization initiators may be used individually or in combination. There is no particular restriction with respect to the amount of photopolymerization initiator. However, the amount of photopolymerization initiator is preferably in the range of from 0.1 to 20 % by weight, based on the weight of the precursor. When the amount of photopolymerization initiator is too small, the photosensitivity of the composition is unsatisfactory. On the other hand, when the amount of photopolymerization initiator is too large, the properties of the ultimate film prepared from the photopolymerizable composition become poor.

If desired, the photopolymerizable composition of the present invention may contain a monomer having a molecular weight of from 80 to 1000 and having a terminal ethylenically unsaturated group which facilitates photopolymerization reaction. The terminal ethylenically unsaturated group of the monomer is preferably represented by the formula:

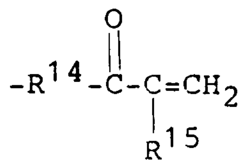

wherein $R^{14}$ represents -O- or -NH- and $R^{15}$ represents a hydrogen atom or a methyl group.

Representative examples of such monomers having a terminal ethylenically unsaturated group include 2-ethylhexyl acrylate or methacrylate, 2-hydroxyethyl acrylate or methacrylate, carbitol acrylate or methacrylate, tetrahydrofurfuryl acrylate or methacrylate, isobornyl acrylate or methacrylate, 1,6-hexanediol diacrylate or dimethacrylate, neopentyl glycol diacrylate or dimethacrylate, ethylene glycol diacrylate or dimethacrylate, polyethylene glycol diacrylate or dimethacrylate, pentacrythritol diacrylate or dimethacrylate, trimethylol propane triacrylate or trimethacrylate, pentaerythritol triacrylate or trimethacrylate, dipentaerythritol hexaacrylate or hexamethacrylate, tetramethylolmethane tetraacrylate or tetramethacrylate, tetraethylene glycol diacrylate or dimethacrylate, nonaethylene glycol diacrylate or dimethacrylate, N-vinyl-2-pyrrolidone, methylenebisacrylamide, methylenebismethacrylamide, N-methylolacrylamide and N-methylolmethacrylamide. Of these compounds, those having 2 or more carbon-carbon double bonds are preferred.

There is no particular restriction with respect to the amount of the monomer having a terminal ethylenically unsaturated group. However, the amount is preferably in the range of from 1 to 20 % by weight, based on the weight of the precursor.

The photopolymerizable composition of the present invention may also contain a photosensitizer which improves the photosensitivity of the composition.

Representative examples of photosensitizers include Michler's ketone, 4,4'-bis-(diethylamino)-benzophenone, 2,5-bis-(4'-diethylaminobenzal)-cyclopentanone, 2,6-bis-(4'-diethylaminobenzal)-cyclohexanone, 2,6-bis-(4'-dimethylaminobenzal)-4-methyl-cyclohexanone, 2,6-bis-(4'-diethylaminobenzal)-4-methyl-cyclohexanone, 4,4'-bis-(dimethylamino)-chalcone, 4,4'-bis-(diethylamino)-chalcone, p-dimethylaminocinnamylideneindanone, p-dimethylaminobenzylideneindanone, 2-(p-dimethylaminophenylvinylene)-benzothiazole, 2-(p-dimethylaminophenylvinylene)-isonaphthothiazole, 1,3-bis-(4'-dimethylaminobenzal)-acetone, 1,3-bis-(4'-diethylaminobenzal)-acetone, 4-dimethylaminoacetophenone, 4-morpholinoacetophenone, 4-dimethylaminobenzophenone, 4-morpholinobenzophenone, N-phenyldiethanolamine, N-p-tolyldiethanolamine, N-p-tolyldiethylamine, and coumarin compounds represented by the following formulae (1) to (5):

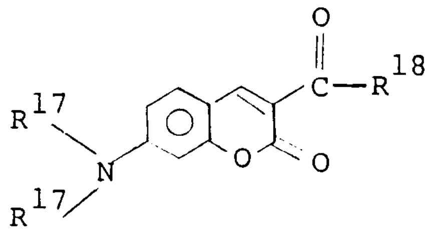

(1)

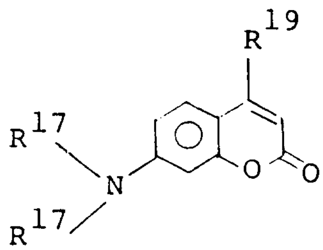

(2)

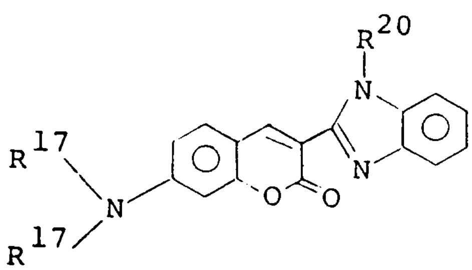

(3)

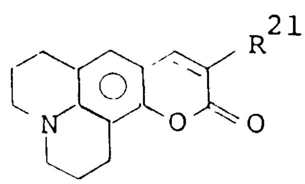

(4) and

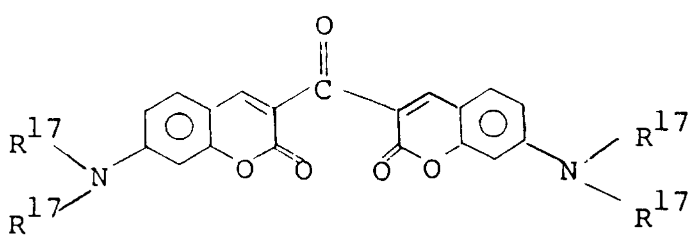

(5)

wherein $R^{17}$ represents a methyl group or an ethyl group, $R^{18}$ represents an aliphatic hydrocarbon residue having 1 to 4 carbon atoms, an aromatic hydrocarbon residue having 6 to 10 carbon atoms or an alkoxy group having 1 to 7 carbon atoms, $R^{19}$ represents a methyl group, an ethyl group or a trifluoromethyl group, $R^{20}$ represents a hydrogen atom or a methyl group, and $R^{21}$ represents an ethoxycarbonyl group, a cyano group, a t-butoxycarbonyl group, a carboxyl group or an acetyl group. Preferred examples of $R^{18}$ include a methyl group, an ethyl group, an isopropyl group, a phenyl group, a tolyl group, a methoxy group, an ethoxy group, a n-propoxy group, an isopropoxy group, a n-butoxy group, an isobutoxy group, a tert-butoxy group and a benzyloxy group. Particularly preferred coumarin compounds are those represented by the above mentioned formula (1) wherein $R^{18}$ is an alkoxy group having 1 to 7 carbon atoms. Specifically, representative examples of particularly preferred coumarin compounds include

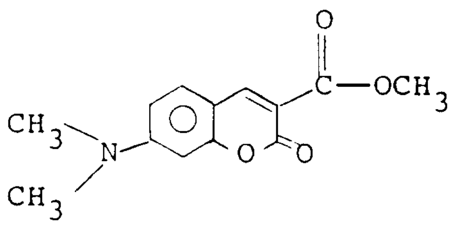 , 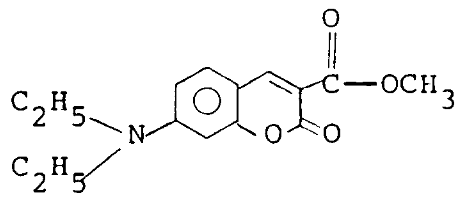 ,

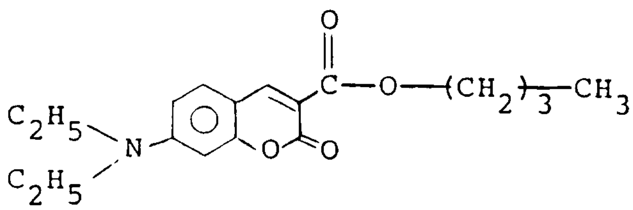 ,

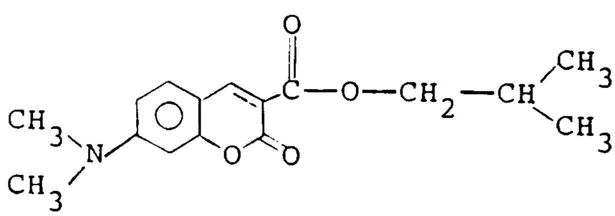 ,

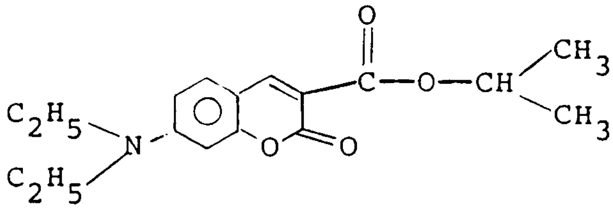 ,

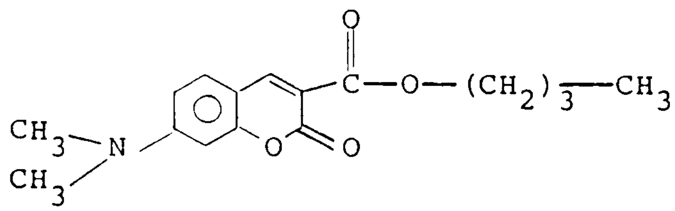 ,

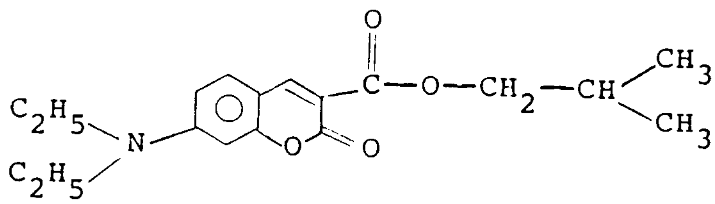 ,

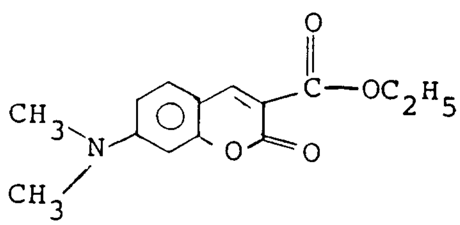 , 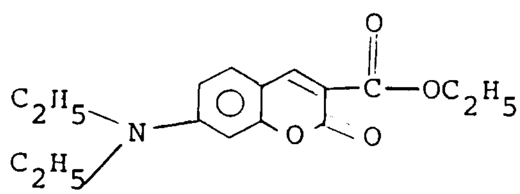 ,

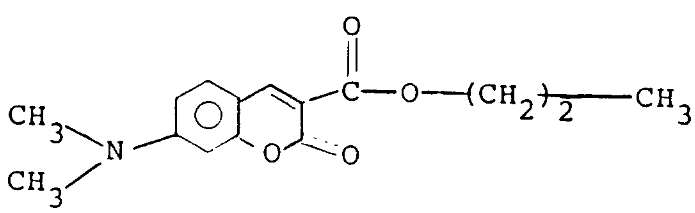 and

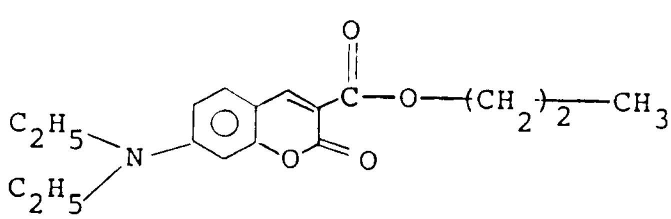 .

If desired, the photopolymerizable composition of the present invention may further contain a mercaptan compound which is capable of providing the composition with improved photosensitivity. Representative examples of mercaptan compounds include 2-mercaptobenzimidazole, 2-mercaptobenzothiazole, 1-phenyl-5-mercapto-1H-tetrazole, 2-mercaptothiazole, 2-mercapto-4-phenylthiazole, 2-amino-5-mercapto-1,3,4-thiazole, 2-mercaptoimidazole, 2-mercapto-5-methyl-1,3,4-thiadiazole, 5-mercapto-1-methyl-1H-tetrazole, 2,4,6-trimercapto-s-triazine, 2-dibutylamino-4,6-dimercapto-s-triazine, 2,5-dimercapto-1,3,4-thiadiazole, 5-mercapto-1,3,4-thiadiazole, 1-ethyl-5-mercapto-1,2,3,4-tetrazole, 2-mercapto-6-nitrothiazole, 2-mercaptobenzoxazole, 4-phenyl-2-mercaptothiazole, mercaptopyridine, 2-mercaptoquinoline, 1-methyl-2-mercaptoimidazole and 2-mercapto-β-naphthothiazole. The amount of mercaptan compound is generally up to 10 % by weight, preferably up to 5 % by weight, based on the weight of the precursor.

Moreover, the photopolymerizable composition may contain a stabilizer. The use of the stabilizer contributes to further improvement in the storage stability of the photopolymerizable composition. Representative examples of stabilizers include hydroquinone, N-nitrosodiphenylamine, p-tert-butylcatechol, phenothiazine, N-phenylnaphtylamine and 2,6-di-tert-butyl-p-methylphenol. However, the stabilizer is not restricted to these specific examples.

The precursor of the present invention may be in the form of a polyamic acid ester, a polyamic amide, a polyamic salt or a mixture thereof. The precursor may partially contain a polyamic acid structure.

There is no particular restriction with respect to the method for producing the precursor of the present invention. However, the precursor in the form of a polyamic acid ester, a polyamic amide or a mixture thereof is generally produced by reacting a tetracarboxylic dianhydride with an alcohol and/or an amine to form a tetracarboxylic acid diester and/or a tetracarboxylic acid diamide, and then subjecting the tetracarboxylic acid diester and/or the tetracarboxylic acid diamide to condensation reaction with a diamine, i.e., condensation reaction of a dicarboxylic acid with diamine, thereby obtaining a polyamic acid ester and/or a polyamic amide.

Various methods for conducting the condensation reaction have been proposed. For example, it has been proposed to form an acid chloride for conducting the condensation reaction (see U.S. Patent Reissue No. 30,186), and it has been proposed to form an active ester intermediate for conducting the condensation reaction (see Polymer Theses, vol. 38, No. 11, page 787). Further, U.S. Patents No. 4,645,823 and No. 4,754,016 disclose a method using an organic dehydrating condensation agent. Of these methods, those disclosed in U.S. Patents No. 4,645,823 and No. 4,754,016 are preferred, because a polyamic acid ester or a polyamic amide containing less amounts of ionic impurities, such as a chlorine ion, can be prepared according to the method of U.S. Patent No. 4,645,823 and because side reaction scarcely occurs in the method according to U.S. Patent No. 4,754,016.

Other methods for producing a polyamic acid ester have been proposed. For example, Japanese Patent Application Laid-Open Specification No. 60-26033 (Dutch patent application No. 8302338) discloses a method for producing a polyamic acid ester which comprises reacting a tetracarboxylic dianhydride with a diamine to form a polyamic acid, and reacting the polyamic acid with a specific activated alcohol to obtain a polyamic acid ester. U.S. Patent No. 4,311,785 discloses a method for producing a polyamic acid ester which comprises preparing a polyamic acid, and adding an epoxy compound to the polyamic acid to obtain a polyamic acid ester.

Various methods for producing a polyamic amide having an unsaturated double bond in the form of an amide bond have been proposed. For example, U.S. Patent No. 527,581 discloses a method for producing a polyamic amide which comprises providing a polyamic acid, and reacting the polyamic acid with an isocyanate to obtain a polyamic amide having an unsaturated double bond in the form of an amide bond.

The polyamic acid salt of the present invention can also be prepared according to various methods. For example, a polyamic acid salt can be simply prepared by reacting a tetracarboxylic dianhydride with a diamine to form a polyamic acid and then reacting the polyamic acid with a tetraalkyl ammonium halide.

The terminal groups of the polymer obtained by the above-mentioned methods are residues of a tetracarboxylic acid and/or a diamine as a starting material, or derivatives of the residues. Representative examples of terminal groups include

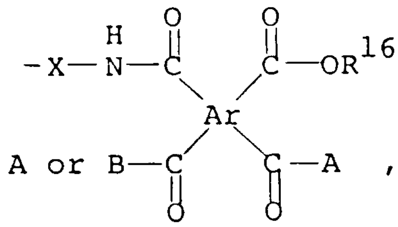,
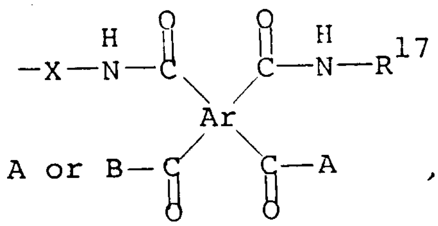,

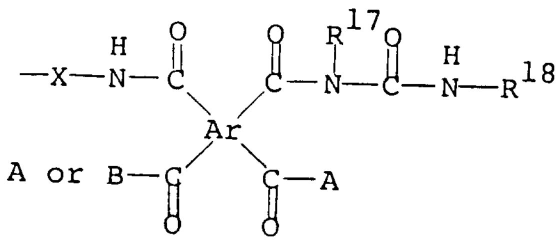,

$-X-NH_2$, 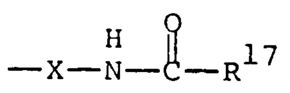,

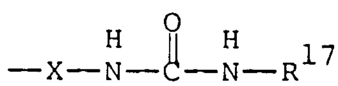 and 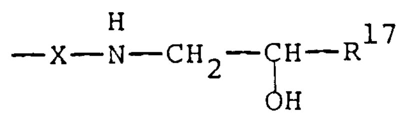.

wherein Ar, X, A and B have the same meanings as defined above, $R^{16}$ represents a hydrogen atom or a monovalent organic group and each of $R^{17}$ and $R^{18}$ independently represents a monovalent organic group.

When a group selected from the group consisting of:

-C≡N, -C≡CH,

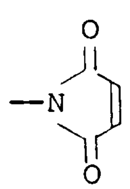 and 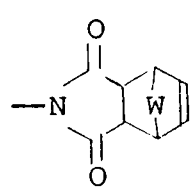

wherein W represents -O-, $-CH_2-$ or

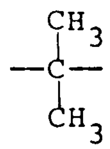

is introduced into the precursor of the present invention as a terminal group, the molecular weight of an ultimate polyimide produced by heat curing the precursor can be increased.

The tetracarboxylic acid (as a starting material of the precursor of the present invention) is used generally in the form of its derivative, such as a half ester; preferably in the form of an anhydride. For forming the units represented by formulae [III] and [IV], the tetracarboxylic acid derivatives used are pyromellitic dianhydride, biphenyl-3,4,3',4'-tetracarboxylic dianhydride or p-terphenyl-3,4,3'',4''-tetracarboxylic dianhydride. For forming the units represented by formulae [I] and [II], use is made of a tetracarboxylic acid derivative selected from the above-mentioned acid anhydrides, and derivatives and anhydrides of other tetracarboxylic acids having an aromatic polycyclic hydrocarbon residue, such as benzene, naphthalene and anthracene groups; a heterocyclic group, such as pyridine and thiophene groups; and a group represented by formula (II-1). Representative examples of other tetracarboxylic acids include 2,3,3',4'-tetracarboxydiphenyl, 2,3,3',4'-tetracarboxydiphenyl ether, 3,3',4,4'-tetracarboxybenzophenone, 2,3,3',4'-tetracarboxybenzophenone, 2,3,6,7-tetracarboxynaphthalene, 1,4,5,8-tetracarboxynaphthalene, 2,3,6,7-tetracarboxynaphthalene, 3,3',4,4'-tetracarboxydiphenylmethane, 2,2-bis(3,4-dicarboxyphenyl)hexafluoropropane, 3,3',4,4'-tetracarboxydiphenyl sulfone, 3,4,9,10-tetracarboxyperylene, 2,2-bis[4-(3,4-dicarboxyphenoxy)-phenyl]propane and 2,2-bis[4-(3,4-dicarboxyphenoxy)phenyl]hexafluoro propane.

For forming the units represented by formulae (III) and (IV), the starting diamine is one represented by the formula: $H_2N-X^1-NH_2$

wherein $X^1$ represents at least one divalent group selected from the group consisting of:

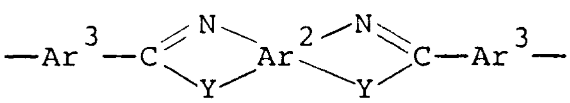 and

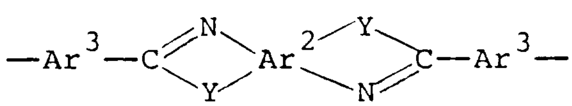

wherein $Ar^2$ represents a tetravalent aromatic group selected from the group consisting of:

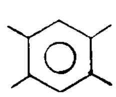, 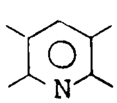 and 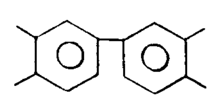

$Ar^3$ represents a divalent aromatic group selected from the group consisting of:

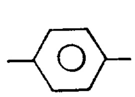, 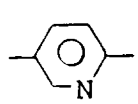 and 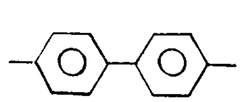,

and

Y represents a divalent group selected from the group consisting of -O-, -S-,

$-\underset{\text{H}}{\text{N}}-$ and 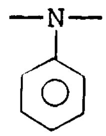 .

For forming the units represented by formulae (III-1) to (III-4) and (IV-1) to (IV-4), the starting diamines are those represented by the formulae: $H_2N\text{-}X^2\text{-}NH_2$, $H_2N\text{-}X^3\text{-}NH_2$ and $H_2N\text{-}X^4\text{-}NH_2$

wherein $X^2$ represents at least one divalent group selected from the group consisting of:

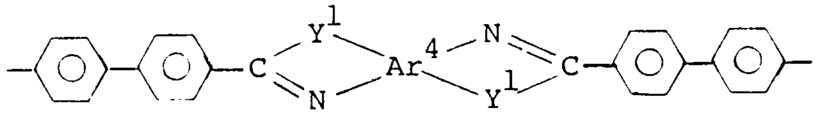 and

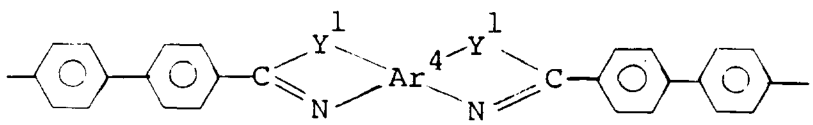 ,

wherein $Ar^4$ represents a tetravalent group selected from the group consisting of:

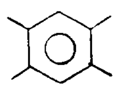 and 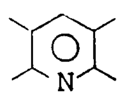 ,

and

$Y^1$ represents a divalent group selected from the group consisting of:

-O-, -S- and

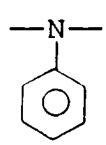 ;

wherein $X^3$ represents at least one divalent group selected from the group consisting of:

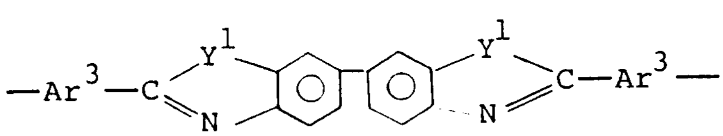 and

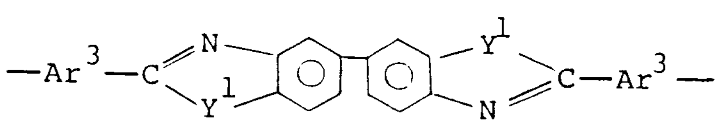

wherein $Ar^3$ and $Y^1$ are as defined above; and

wherein $X^4$ represents at least one divalent group selected from the group consisting of:

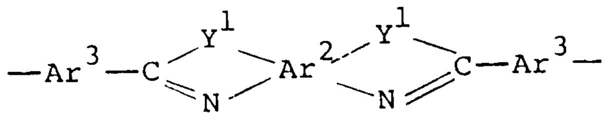 and

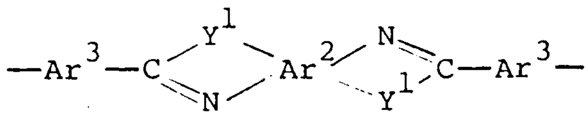

wherein $Ar^2$, $Ar^3$ and $Y^1$ are as defined above.

Representative examples of diamines represented by the formula: $H_2N-X^2-NH_2$ include

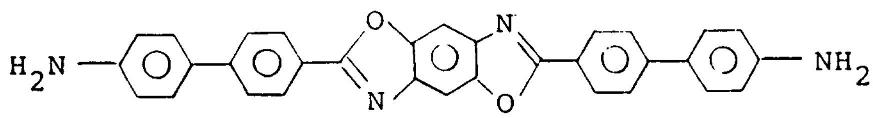 ,

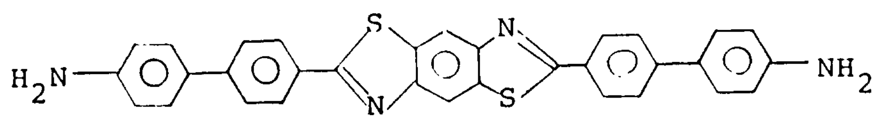 ,

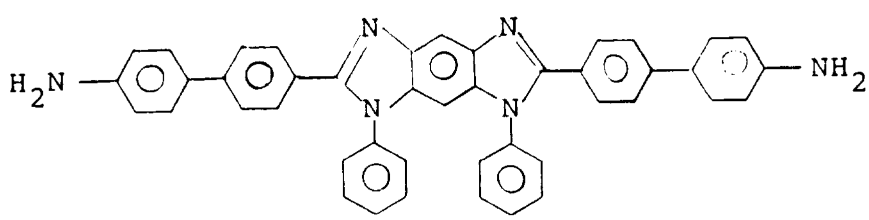 ,

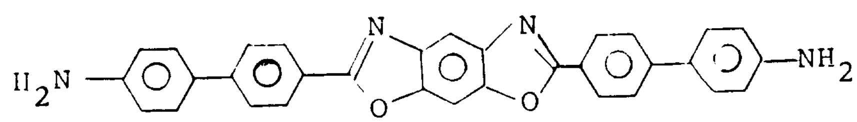 ,

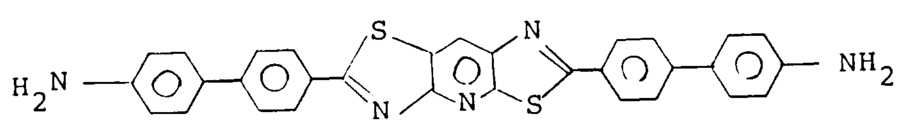 and

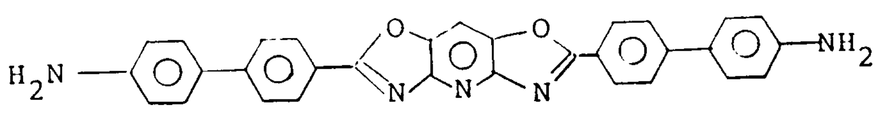 .

Representative examples of diamines represented by the formula: $H_2N-X^3-NH_2$ include

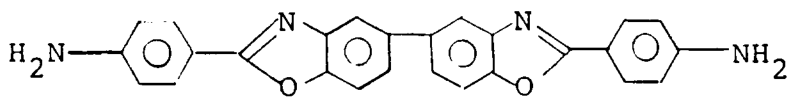

,

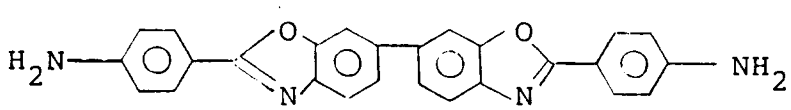

,

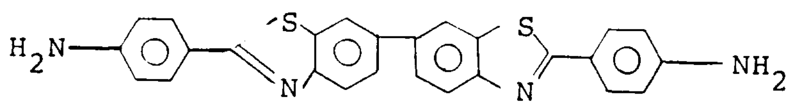

,

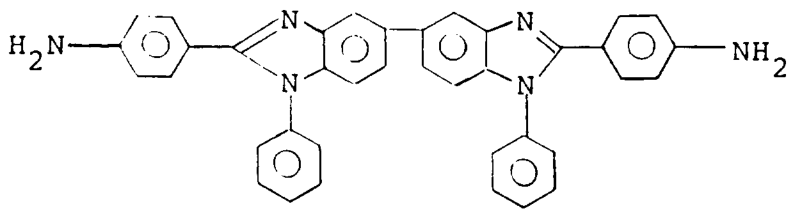

,

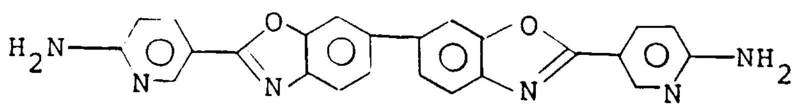

,

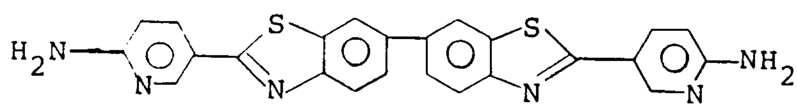

,

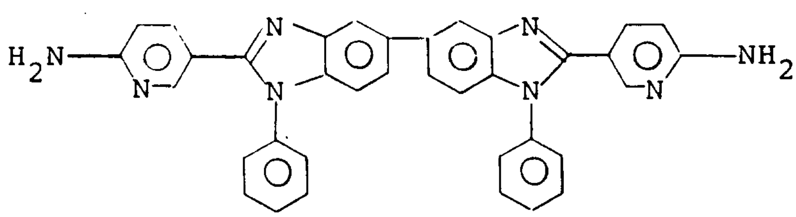

,

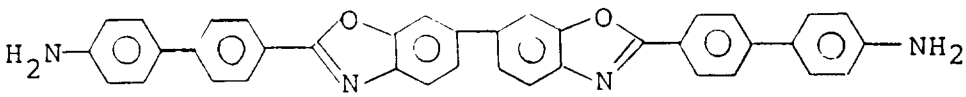 ,

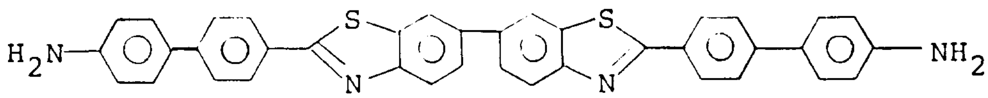 ,

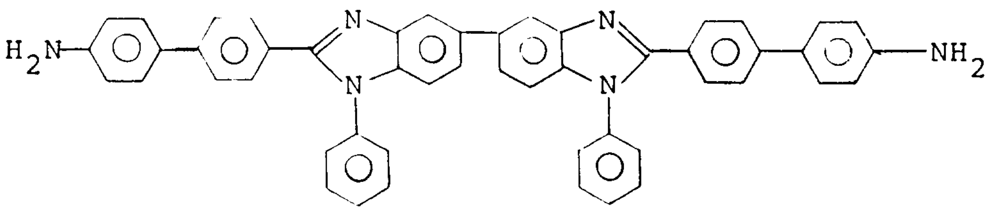 and

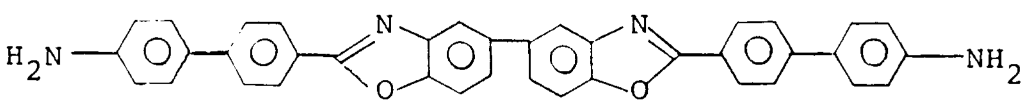 .

Representative examples of diamines represented by the formula: $H_2N\text{-}X^4\text{-}NH_2$ include

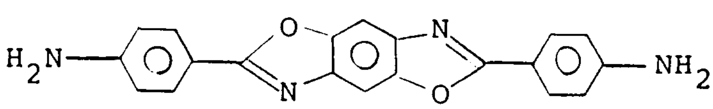 ,

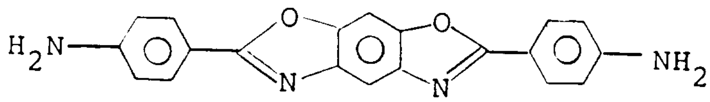

,

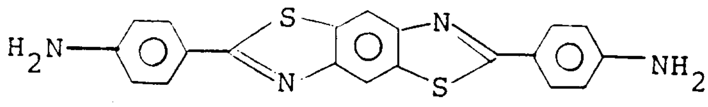

,

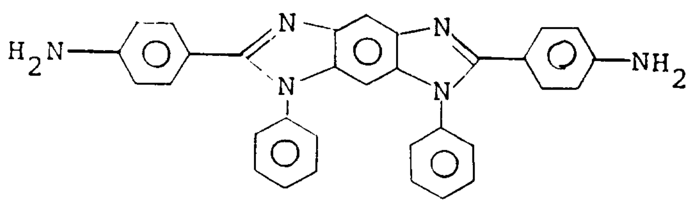

,

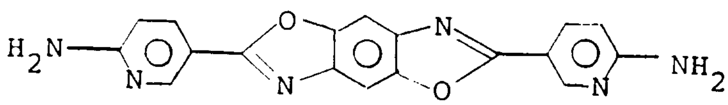

,

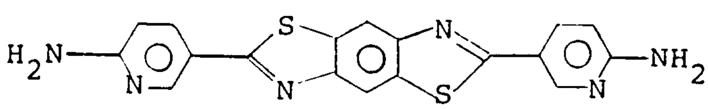

,

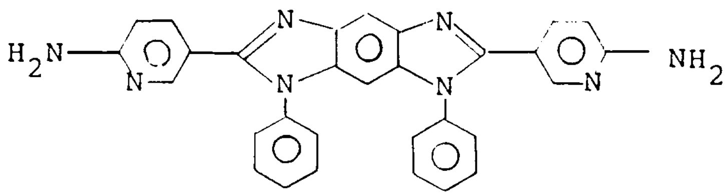
,

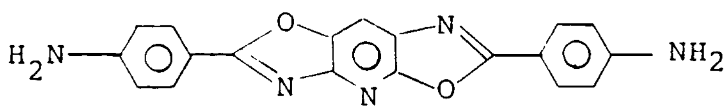
,

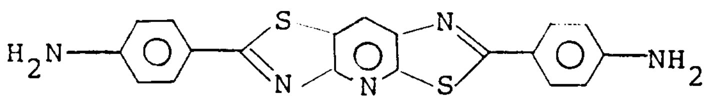
and

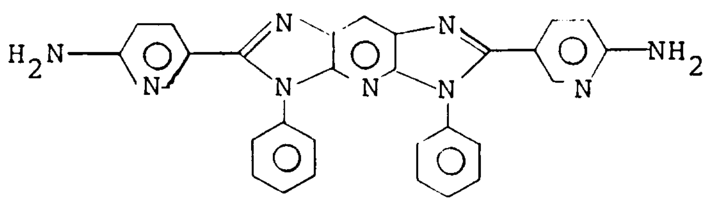
,

and diamines which have been mentioned as representative examples of diamines represented by the formulae: $H_2N\text{-}X^2\text{-}NH_2$ and $H_2N\text{-}X^3\text{-}NH_2$.

Representative examples of diamines represented by the formula: $H_2N\text{-}X^1\text{-}NH_2$ for forming the units of formulae (III) and (IV) include not only the diamines mentioned as representative examples of the diamines represented by the formula: $H_2N\text{-}X^2\text{-}NH_2$, $H_2N\text{-}X^3\text{-}NH_2$ and $H_2N\text{-}X^4\text{-}NH_2$ but also the diamines of the following formulae:

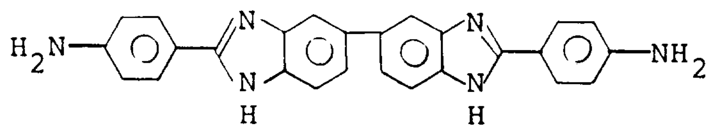 ,

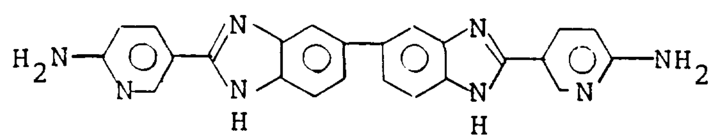 ,

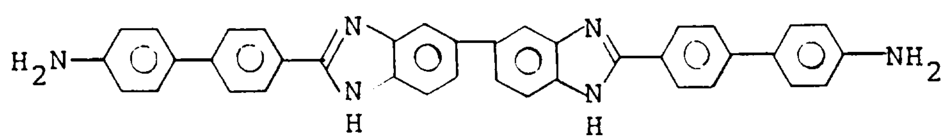 ,

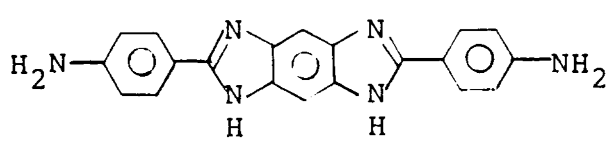 ,

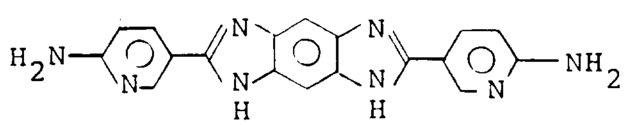 ,

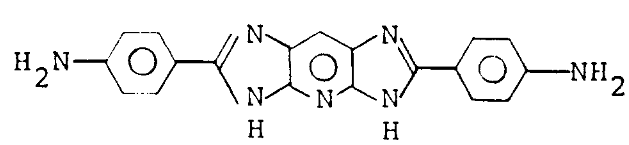 and

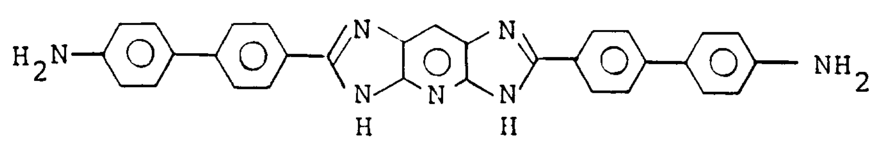 .

These heterocyclic group-containing diamines can be prepared by the methods described in, for example, Makromol. Chem. 77, page 33 (1964), Polymer, 11, page 297 (1970) and J. Polymer Science, A-1, 16, pages 1831 and 2275 (1978). Of the various methods described in these references, the method using a polyphosphoric acid as a solvent and a dehydrating condensation agent is particularly preferred because the desired diamine can be produced in one step.

One of the reactions for producing the desired diamine takes place as follows.

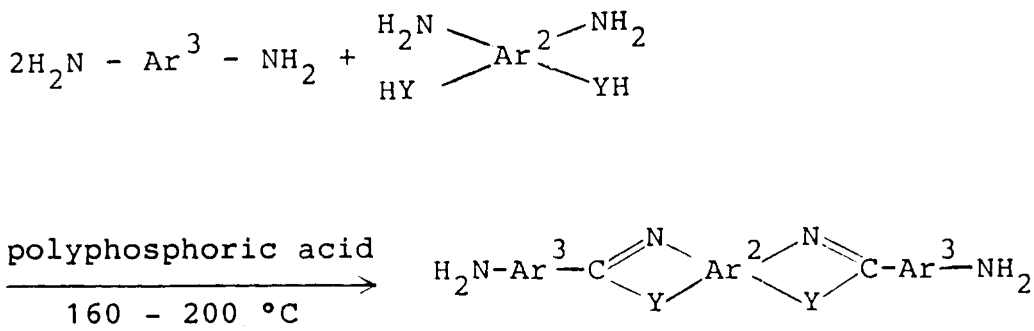


wherein $Ar^2$, $Ar^3$ and Y are as defined above.

The diamine derivative of the formula:

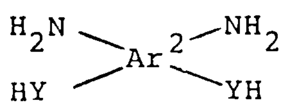

as a starting material of the above-mentioned reaction can be produced by the method according to U.S. Patent No. 590,292.

Representative examples of diamines of the formula: $H_2N\text{-}X\text{-}NH_2$ for forming the units of formulae (I) and (II) include not only the diamines mentioned as representative examples of the diamines of the formula: $H_2N\text{-}X^1\text{-}NH_2$ for forming the units of formulae (III) and (IV) but also other diamines, such as p-phenylenediamine, m-phenyldiamine, 2,5-diaminotoluene, 2,5-dimethyl-p-phenylenediamine, 2,6-dimethyl-p-phenylenediamine, diaminodurene, 2,4-diaminotoluene, 2,6-diaminotoluene, 1,5-diaminonaphthalene, 2,6-diaminonaphthalene, 4,4''-diaminoterphenyl, 4,4'''-diaminoquaterphenyl, 4,4'-diaminodiphenylmethane, 4,4'-diaminodiphenyl ether, diaminodiphenylsulfone, 2,2-bis(p-aminophenyl)propane, 2,2-bis(p-aminophenyl)-hexafluoropropane, 3,3'-dimethylbenzidine, 3,3'-dimethoxybenzidine, 3,3'-dimethyl-4,4'-diaminodiphenyl ether, 3,3'-dimethyl-4,4'-diaminodiphenylmethane, 1,4-bis(p-aminophenoxy)benzene, 4,4'-bis(p-aminophenoxy)biphenyl, 2,2-bis[4-(p-aminophenoxy)phenyl]propane, diaminoanthraquinone, 4,4'-bis(3-aminophenoxyphenyl)diphenyl sulfone, 1,3-bis(anilino)hexafluoropropane, 1,4-bis(anilino)octafluorobutane, 1,5-bis(anilino) decafluoropentane, 2,2-bis[4-(p-aminophenoxy)phenyl]hexafluoropropane, 2,2-bis[4-(3-aminophenoxy)phenyl]hexafluoropropane, 2,2-bis[4-(4-aminophenoxy)-3,5-dimethylphenyl]-hexafluoropropane, 2,2-bis[4-(4-aminophenoxy)-3,5-ditrifluoromethylphenyl] hexafluoropropane, p-bis(4-amino-2-trifluoromethylphenoxy)benzene, 4,4'-bis(4-amino-2-trifluoromethylphenoxy)biphenyl, 4,4'-bis(4-amino-3-trifluoromethylphenoxy)biphenyl, 4,4'-bis(4-amino-2-trifluoromethylphenoxy)diphenyl sulfone, 4,4'-bis(3-amino-5-trifluoromethylphenoxy)diphenyl sulfone and 2,2-bis[4-(4-amino-3-trifluoromethylphenoxy)phenyl] hexafluoropropane.

As the starting diamine, a silicone diamine may be employed. Representative examples of silicone diamines include those which are represented by the formulae:

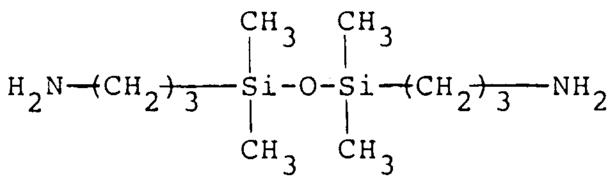,

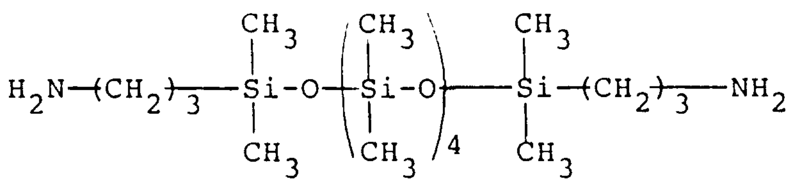,

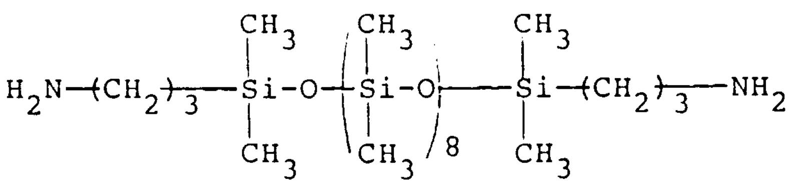,

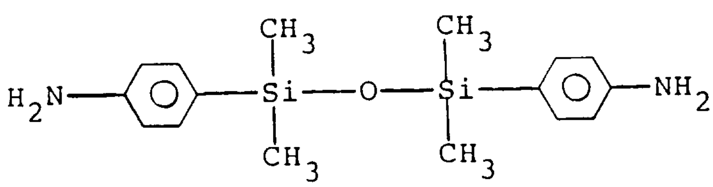,

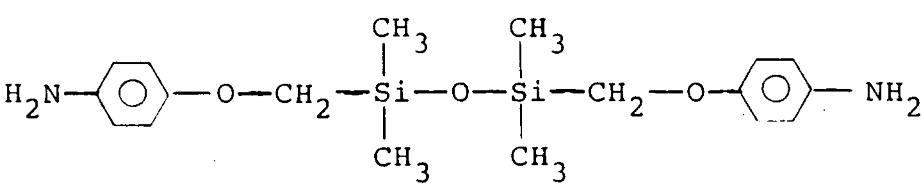 and

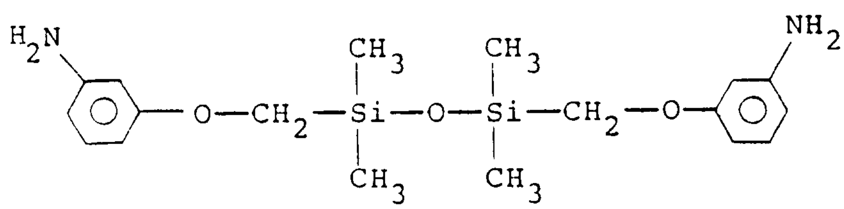.

When it is intended to prepare a precursor of the present invention wherein A or B of the units of the formulae (I) and (II) is $-OR^1$, an alcohol is used as a starting material, which is represented by the formula: $R^1$-OH wherein $R^1$ represents an organic group having 1 to 20 carbon atoms. As the alcohol of the formula:

$R^1$-OH, an alcohol having an ether bond, such as 2-methoxyethanol, 2-ethoxyethanol, 3-methoxy-1-propanol or 2,3-dimethoxy-1-propanol is preferred. Further, an alcohol containing at least one carbon-carbon double bond may be used. As the alcohol containing at least one carbon-carbon double bond, an alcohol represented by formula (I-1) is preferred. Representative examples of alcohols represented by formula (I-1) include 2-hydroxyethyl acrylate, 2-hydroxyethyl methacrylate, 2-hydroxypropyl acrylate and 2-hydroxypropyl methacrylate.

For producing the precursor of the present invention, an epoxy compound corresponding to the monovalent group of formula (I-4) may be used instead of the above-mentioned alcohol. Representative examples of epoxy compounds include glycidyl methacrylate and glycidyl acrylate.

The precursor of the present invention in which A or B of the units of formulae (I) and (II) is

$$-\overset{H}{N}R^1$$

can be prepared by reacting an amine compound corresponding to a monovalent group selected from the groups (I-1) to (I-6) with a tetracarboxylic acid and a diamine. However, it is preferred to produce the precursor in which A or B of the units of formulae (I) and (II) is

$$-\overset{H}{\underset{}{N}}R^1$$

by a method which comprises preparing a polyamic acid and then reacting the polyamic acid with an isocyanate compound instead of the amine compound. As the isocyanate compound, methacryloyloxyethyl isocyanate and acryloyloxyethyl isocyanate which contain at least one carbon-carbon double bond are preferred, because these isocyanates are capable of imparting improved photosensitivity to the precursor.

The photopolymerizable composition of the present invention is useful for producing a composite structure as described later. A process for producing a composite structure comprises:

(1) applying the photopolymerizable composition of the present invention to a substrate as mentioned hereinbefore;

(2) image-wise exposing to actinic radiation the photosensitive element on its side of the photopolymerizable composition through an image-bearing transparency to crosslink the precursor of the exposed portion of the composition while leaving the precursor of the non-exposed portion of the composition non-crosslinked, thereby converting the photopolymerizable composition layer to a layer having photoinsolubilized image portions comprising the crosslinked precursor and non-photoinsolubilized image portions comprising the non-crosslinked precursor;

(3) washing out the non-photoinsolubilized image portions with a developer; and

(4) heating the substrate having thereon the photoinsolubilized image portions composed of the crosslinked precursor to imidize said crosslinked precursor.

The photopolymerizable composition of the present invention optionally contains a silane compound as mentioned with respect to the further improvement of the precursor of the present invention in the adhesion of the ultimate polyimide film to a substrate. The amount of silane compound is generally in the range of from 0.05 to 10 % by weight, preferably from 0.1 to 5 % by weight, based on the weight of the precursor. The silane compound may be added to the photopolymerizable composition of the present invention. Alternatively, the silane compound may be added to the precursor of the present invention and then the resultant mixture is mixed with the photopolymerization initiator to obtain a photopolymerizable composition of the present invention.

In general, the precursor and the photopolymerizable composition of the present invention are dissolved in a solvent to obtain a solution and then the solution is applied to a substrate. As the solvent, polar solvents, such as N-methylpyrrolidone, dimethylacetamide, dimethyl sulfoxide, $\gamma$-butyrolactone, cyclohexanone, cyclopentanone, tetrahydrofurane and dioxane are preferred. If desired, other solvents may be used in combination with the above-mentioned polar solvent for improvement in, e.g., coating properties. These solvents are optionally used as a solvent of the reaction system for producing the precursor of the present invention. When solvent is used in the production of the precursor, the resultant reaction mixture per se can be applied to a substrate. The solution of the precursor or photopolymerizable composition is generally filtered prior to use for, e.g., coating. The solution is optionally applied to a substrate by a coating method using a spin coater, a bar coater, a blade coater, a roll coater or the like; a screen printing method; a

dipping method; a spraying method or the like. Examples of substrates include those made of a metal, a glass, a silicon or silicon carbide semiconductor material, a compound semiconductor material, a metal oxide insulating material and silicon nitride; and also include a copper-clad glass-epoxy laminate, etc.

The coating layer on the substrate is dried by an appropriate method, e.g., air-drying, heating or vacuum drying, thereby obtaining a preliminary element. The thus obtained element is subjected to photolithography. That is, first, the element is exposed to actinic rays through a photomask. Representative examples of actinic rays include ultraviolet rays, x-rays and electron rays. Of these, ultraviolet rays are preferred. As a light source of actinic rays for the exposure, use is made of a low pressure mercury lamp, a high pressure mercury lamp, an extra-high pressure mercury lamp, a halogen lamp or the like. Of these light sources, an ultra-high pressure mercury lamp is preferred. Further, a g-line stepper which is an exposure device selectively using the g-line (wave length: 436 nm) of an extra-high pressure mercury lamp for exposure is preferably employed.

It is preferred to conduct the exposure in a nitrogen atmosphere.

After exposure, development is carried out by removing unexposed portions of the photopolymerizable composition with a developer by dipping or spraying. Representative examples of developers include aprotic polar solvents, such as $\gamma$-butyrolactone, N-methylpyrrolidone, N-acetyl-2-pyrrolidone, N,N-dimethylformamide, N,N-dimethylacetamide, dimethyl sulfoxide, hexamethylphosphorotriamide and N-benzyl-2-pyrrolidone. The solvents can be used individually or in combination with a secondary solvent. Representative examples of secondary solvents include alcohols, such as ethanol and isopropanol; aromatic hydrocarbons, such as toluene and xylene; ketones, such as methyl ethyl ketone and methyl isobutyl ketone; esters, such as ethyl acetate and methyl propionate; and ethers, such as tetrahydrofuran and dioxane. Further, it is preferred to rinse the developed pattern with the above-described secondary solvent immediately after the development. In this way, the desired fine pattern can be obtained from the photopolymerizable composition.

After drying, the element is heated at a temperature of 150 °C to 500 °C to convert the polymer of the pattern to a heat resistant polyimide.

Representative examples of composite structures include:

(i) an LSI having a multi-layer circuit in which a plurality of circuit layers having an insulating polyimide layer disposed between the mutually adjacent circuit layers is superimposed on a chip of silicon, gallium arsenide or the like;

(ii) a semiconductor element comprising an LSI chip and, superimposed thereon, a passivation film or an $\alpha$-ray shielding film which is formed of a polyimide

(iii) a multi-layer circuit board comprising a plurality of substrates of silicon, alumina, silicon carbide, zircon, beryllia, sapphire or the like having an insulating layer of a polyimide disposed therebetween;

(iv) a liquid crystal display comprising a glass plate and a layer of the low thermal stress polyimide formed thereon as a crystal liquid orientating layer;

(v) a printed circuit board comprising a metal plate and a polyimide-based printed circuit formed thereon;

(vi) a polyimide-based magnetic recording medium, such as a magnetic tape, a magnetic disc or the like; and

(vii) a polyimide-based substrate for an amorphous solar battery.

Since a layer of low thermal stress polyimide obtained by heating the precursor of the present invention has a low thermal expansion coefficient as compared to that of conventional organic materials, the layer does not substantially undergo a thermal stress which has conventionally been likely to occur due to the difference between the thermal expansion coefficient of the layer of the polyimide and that of substrate of an inorganic material on which the layer is formed. The layer of the low thermal stress polyimide also has excellent water resistance of adhesion and excellent mechanical properties. Therefore, the precursor of the present invention is advantageously used in various fields, e.g., the fields of the electric or electronic materials and semiconductors. The precursor of the present invention has a high solubility in an organic solvent and good storage properties in the form of a solution. Therefore, the precursor of the present invention has remarkably improved processability.

Further, using the photopolymerizable composition of the present invention, a fine pattern of the low thermal stress polyimide can readily be formed on a substrate by a simple method comprising coating the photopolymerizable composition on a substrate, exposing the resultant coating layer to actinic rays through a photomask and heat curing the exposed portion of the coating layer to form a pattern.

Required starting materials are known or are conventionally prepared from available materials.

Detailed Description Of Preferred Embodiments

The present invention will now be described in more detail with reference to the following Examples and Comparative Examples which should not be construed to be limiting the scope of the present invention.

The precursors, photopolymerization initiators, and additives, such as monoiners, photosensitizers, mercaptan compounds, silane compounds and photopolymerization inhibitors, which here employed in the Use Examples and Comparative Use Examples of the precursors, are indicated in Table 1.

In Table 1, a reduced viscosity (viscosity number) (hereinafter often referred to as "VN") is shown, which is an index for showing the molecular weight of a precursor. The reduced viscosity is measured by the method described below:

1 g of a precursor is dissolved in 100 ml of N-methylpyrrolidone (hereinafter often referred to as "NMP") to obtain a solution having a precursor concentration (C) of 1 (g/dl). 10 ml of the thus obtained solution is put into an Ostwald viscometer and the time required for the solution to drop down is measured and taken as $\eta$ (sec.). Separately, 10 ml of NMP per se is put into an Ostwald viscometer and the time required for the NMP to drop down is measured and taken as $\eta_0$(sec). The VN of the precursor is calculated from the formula:

$$VN = \frac{1}{C} \frac{(\eta - \eta_0)}{\eta_0} [ml/g].$$

[Preparation Examples and Comparative Preparation Examples of Precursors]

The precursors which were used in the Use Examples and Comparative Use Examples and described in Table 1 were synthesized as follows.

Into a flask (provided with a thermometer, a stirrer and a drying tube) were introduced a tetracarboxylic dianhydride and an alcohol, individually in amounts indicated in Table 1 (1-1), and was also introduced N,N'-dimethylacetamide in a volume 2.5 times that of the carboxylic anhydride, and further 20.6 g of pyridine was added while stirring at room temperature. The stirring was continued for 16 hours at room temperature, and a solution prepared by dissolving 54.2 g of dicyclohexyl carbodiimide in 27 ml of N,N-dimethylacetamide was added while cooling with ice over a period of 10 minutes and then a suspension prepared by suspending a diamine indicated in Table 1 (1-1) in a double volume of N,N-dimethylacetamide, was added in 20 minutes. The temperature of the resultant mixture was elevated gradually up to room temperature and the mixture was stirred for 2 hours, and then 5 ml of ethanol was added, followed by stirring for 1 hour. The insoluble product in the resultant reaction mixture was filtered off, and the resultant solution was added to 4 ℓ of ethanol to obtain a precipitate. The precipitate was washed by ethanol and vacuum-dried, thereby obtaining a yellow powder of a precursor. The VNs of the thus obtained precursors are also shown in Table 1 (1-1).

The precursors shown in Table 1 (1-2) were synthesized in the method described below. Into a flask provided with a thermometer, a stirrer and a drying tube were introduced a diamine indicated in Table 1 (1-2) and 330 g of N,N-dimethylacetamide, thereby dissolving the diamine. Then, the acid anhydride indicated in Table 1 (1-2) which was in a powdery form was added little by little over a period of 15 minutes, followed by stirring at room temperature for 3 hours. Then, 1.5 g of 2-hydroxyethyl methacrylate was added to the reaction mixture and stirred for 2 hours at room temperature, thereby bonding the methacrylate to the terminal anhydride groups remaining unreacted. 65 g of glycidyl methacrylate, 0.7 g of benzyldimethylamine and 0.05 g of hydroquinone were added thereto and heated at 50° to 60 °C for 23 hours while stirring, and then the resultant reaction mixture was added dropwise to 4 ℓ of ethanol while vigorously stirring, to form a precipitate. The precipitate was isolated by filtration with suction and dried under vacuum at room temperature, thereby obtaining a precursor. The VNs of the thus obtained precursors are shown in Table 1 (1-2).

Substantially the same procedure for the synthesis of the precursors of Table 1 (1-2) was repeated except that the amount of glycidyl methacrylate was changed to 18.5 g, thereby obtaining precursors shown in Table 1 (1-3).

The precursors shown in Table 1 (1-4) were synthesized by the method described below.

Into a flask (provided with a thermometer, a stirrer and a drying tube) were introduced a diamine indicated in Table 1 (1-4) and 330 g of N,N-dimethylacetamide, thereby dissolving the diamine. Then, the

acid anhydride indicated in Table 1 (1-4) which was in a powdery form was added thereto little by little over a period of 15 minutes, followed by stirring at room temperature for 3 hours. Then, 1.5 g of 2-hydroxyethyl methacrylate was added to the reaction mixture and stirred for 2 hours at room temperature, thereby bonding the methacrylate to the terminal anhydride groups remaining unreacted. 12.1 g of 2-isocyanatoethyl methacrylate was added and reacted at room temperature for 24 hours while stirring, and then the resultant reaction mixture was added dropwise to 4 ℓ of ethanol while vigorously stirring, to form a precipitate. The precipitate was isolated by filtration with suction and dried under vacuum at room temperature, thereby obtaining a precursor. The VNs of the thus obtained precursors are shown in Table 1 (1-4).

The precursor solutions (varnish) shown in Table 1 (1-5) were synthesized by the method described below.

Into a flask (provided with a thermometer, a stirrer and a drying tube) was introduced a diamine indicated in Table 1 (1-5), and NMP was added thereto, so that the precursor concentration became 30 % with respect to each of precursors P-1(A), P-5(A), P-10(A) and P-19(A), and the precursor concentration became 10 % with respect to each of precursors P-1(AM), P-42(AM) and P-47(AM), followed by stirring, thereby obtaining a solution. Then, the tetracarboxylic dianhydride indicated in Table 1 (1-5) was added thereto while stirring, and the resultant reaction mixture was reacted at room temperature for about 6 hours while stirring, thereby obtaining the varnish indicated in Table 1 (1-5). The VN of each precursor obtained subjecting each varnish to reprecipitation in ethanol are shown in Table 1 (1-5).

The abbreviations for the tetracarboxylic anhydrides, diamines and alcohols used in the Examples and Comparative Examples are as set forth below.

The code numbers for the photopolymerization initiators, monomers, photosensitizers, mercaptans, silanes and stabilizers used in the Examples and Comparative Examples are shown in Tables 1(2) through 1(7).

| | | |
|---|---|---|
| Tetracarboxylic dianhydride | PMDA | 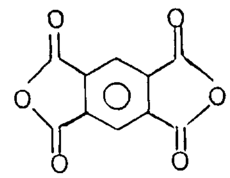 |
| | BPDA | 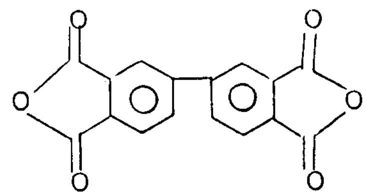 |
| | TPDA | 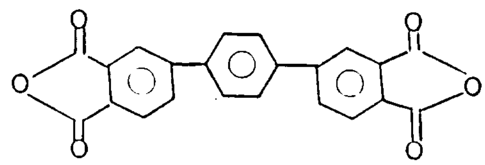 |
| | BTDA | 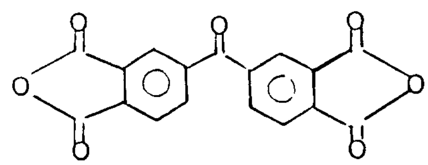 |
| | OXDA | 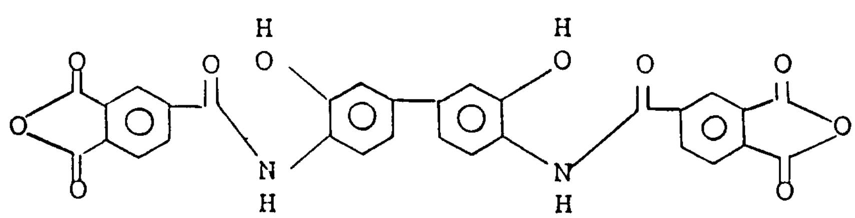 |

| | | |
|---|---|---|
| Diamine | BO-1 | 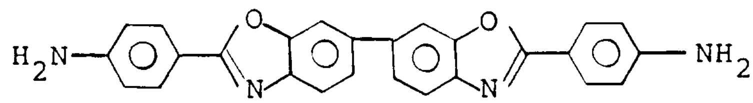 |
| | BO-2 | 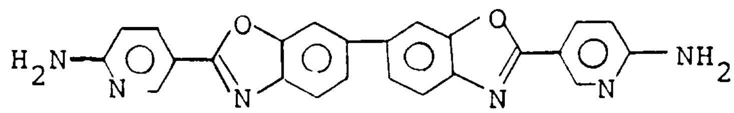 |
| | BO-3 | 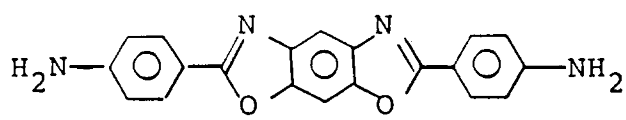 |
| | BO-4 | 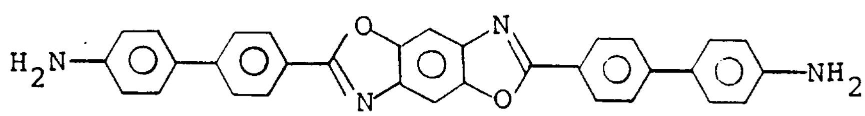 |
| | BO-5 | 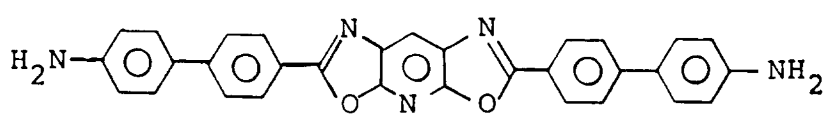 |
| | BT-1 | 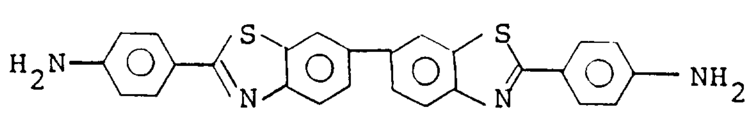 |

| | | |
|---|---|---|
| Diamine | BT-2 | 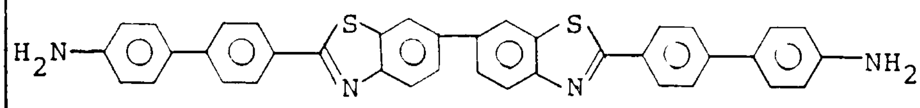 |
| | BT-3 | 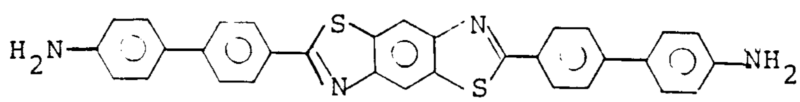 |
| | BT-4 | 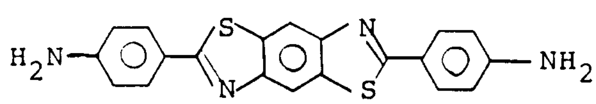 |
| | PBI-1 | 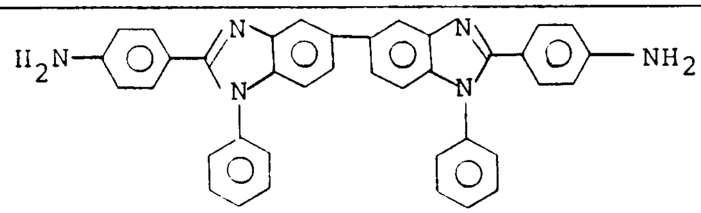 |
| | PBI-2 | 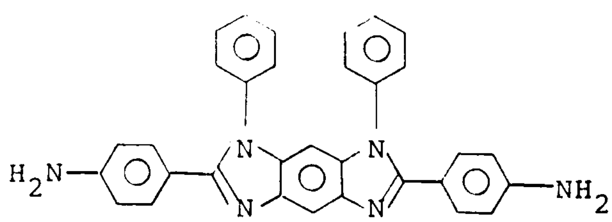 |
| | PBI-3 | 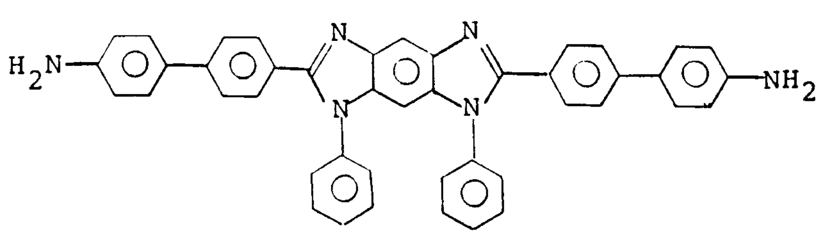 |

| | | |
|---|---|---|
| Diamine | BI-1 | 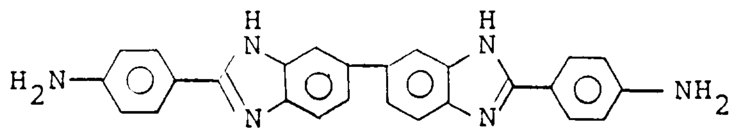 |
| | DA-1 | 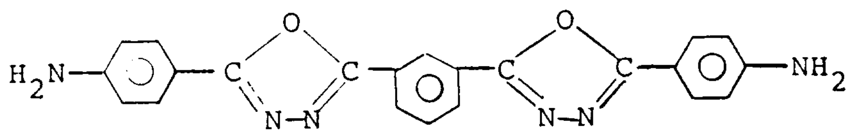 |
| | OX-1 | 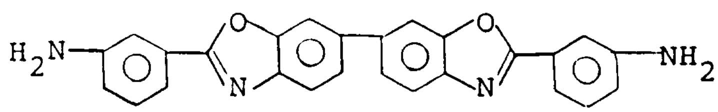 |
| | OX-2 | 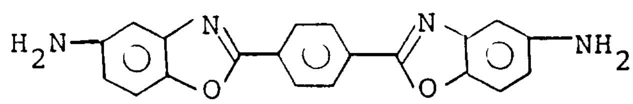 |
| | P-PD | 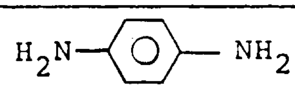 |
| | PX | 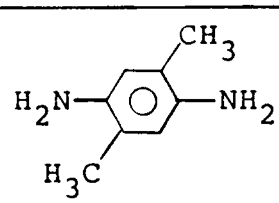 |
| | TOL | 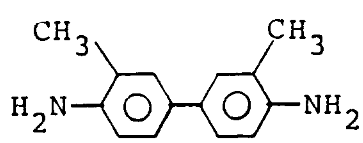 |

| | | |
|---|---|---|
| Diamine | ODA | 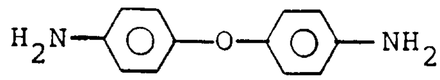 |
| | DAPP | 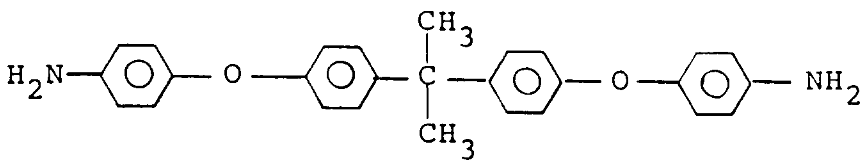 |
| Alcohol | HEMA | 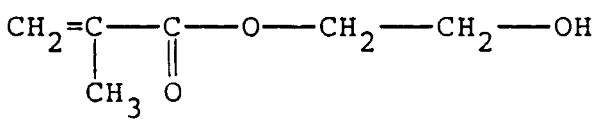 |
| | HPMA | 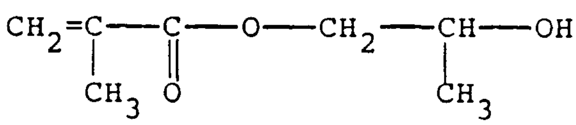 |
| | HEA | 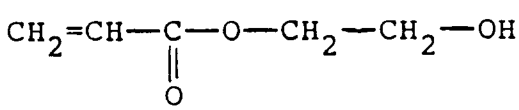 |
| | MEO | $CH_3—O—CH_2—CH_2—OH$ |

Table 1 (1-1)

| Precursor No. | Tetracarboxylic dianhydride (mole) g | Diamine (mole) g | Alcohol (mole) g | VN (ml/g) |
|---|---|---|---|---|
| P-1 | PMDA (0.13) 28.4 | BO-1 (0.12) 50.2 | HEMA (0.26) 34.0 | 34.9 |
| P-2 | " | BO-2 (0.12) 50.4 | " | 29.1 |
| P-3 | " | BO-4 (0.12) 59.3 | " | 33.5 |
| P-4 | " | BO-5 (0.12) 59.4 | " | 31.0 |
| P-5 | " | BT-1 (0.12) 53.8 | " | 33.3 |
| P-6 | " | BT-2 (0.12) 72.2 | " | 32.3 |
| P-7 | " | BT-3 (0.12) 63.1 | " | 32.0 |
| P-8 | " | PBI-1 (0.12) 68.2 | " | 32.1 |
| P-9 | " | PBI-3 (0.12) 77.3 | " | 30.5 |
| P-10 | BPDA (0.13) 38.2 | BO-3 (0.12) 41.0 | " | 26.3 |
| P-11 | " | BT-4 (0.12) 44.9 | " | 27.0 |

| Precursor No. | Tetracarboxylic dianhydride (mole) g | Diamine (mole) g | Alcohol (mole) g | VN (ml/g) |
|---|---|---|---|---|
| P-12 | BPDA (0.13) 38.2 | PBI-2 (0.12) 59.0 | HEMA (0.26) 34.0 | 25.0 |
| P-13 | " | PBI-3 (0.12) 77.3 | " | 24.9 |
| P-14 | " | BO-4 (0.12) 59.3 | " | 28.4 |
| P-15 | " | BT-3 (0.12) 63.1 | " | 29.0 |
| P-16 | TPDA (0.13) 48.1 | BO-1 (0.12) 50.2 | " | 36.2 |
| P-17 | " | BO-3 (0.12) 41.0 | " | 30.5 |
| P-18 | " | BT-1 (0.12) 53.8 | " | 35.3 |
| P-19 | " | BT-4 (0.12) 44.9 | " | 29.1 |
| P-20 | PMDA (0.13) 28.4 | BO-1 (0.096) 40.1 TOL (0.024) 5.1 | " | 32.3 |
| P-21 | " | BT-1 (0.096) 43.0 PX (0.024) 3.3 | " | 31.0 |

| Precursor No. | Tetracarboxylic dianhydride (mole) g | Diamine (mole) g | Alcohol (mole) g | VN (ml/g) |
|---|---|---|---|---|
| P-22 | PMDA (0.13) 28.4 | PBI-2 (0.096) 47.2 ODA (0.024) 4.8 | HEMA (0.26) 34.0 | 28.9 |
| P-23 | " | BO-3 (0.096) 32.3 ODA (0.024) 4.8 | " | 31.1 |
| P-24 | BPDA (0.13) 38.2 | BO-1 (0.06) 25.1 p-PD (0.06) 6.5 | " | 28.5 |
| P-25 | " | BO-2 (0.06) 25.2 TOL (0.06) 12.7 | " | 25.0 |
| P-26 | " | BT-2 (0.06) 36.1 p-PD (0.06) 6.5 | " | 27.1 |
| P-27 | " | p-PD (0.096) 10.4 BO-1 (0.024) 10.0 | " | 28.3 |

| Precursor No. | Tetracarboxylic dianhydride (mole) g | Diamine (mole) g | Alcohol (mole) g | VN (ml/g) |
|---|---|---|---|---|
| P-28 | BPDA (0.13) 38.2 | PX (0.096) 13.1 BT-2 (0.024) 14.4 | HEMA (0.26) 34.0 | 26.0 |
| P-29 | TPDA (0.13) 48.1 | BO-1 (0.06) 25.1 p-PD (0.06) 6.5 | " | 30.2 |
| P-30 | " | p-PD (0.096) 10.4 BO-1 (0.029) 10.0 | " | 29.5 |
| P-31 | PMDA (0.03) 6.5 BPDA (0.10) 29.4 | BO-3 (0.12) 41.0 | " | 28.5 |
| P-32 | PMDA (0.09) 19.6 TPDA (0.04) 14.8 | BT-4 (0.12) 41.0 | " | 30.1 |
| P-33 | PMDA (0.11) 24.0 OXDA (0.02) 10.6 | BO-3 (0.12) 41.0 | " | 32.4 |

| Precursor No. | Tetracarboxylic dianhydride (mole) g | Diamine (mole) g | Alcohol (mole) g | VN (ml/g) |
|---|---|---|---|---|
| P-34 | PMDA (0.13) 28.4 | BO-1 (0.06) 25.1 BO-3 (0.06) 20.5 | HEMA (0.26) 34.0 | 33.0 |
| P-35 | " | BO-1 (0.12) 50.2 | HPMA (0.26) 37.5 | 36.2 |
| P-36 | " | BT-1 (0.12) 53.8 | " | 34.3 |
| P-37 | " | BO-1 (0.12) 50.2 | HEA (0.26) 30.2 | 27.0 |
| P-38 | " | BT-1 (0.12) 53.8 | " | 29.5 |
| P-39 | " | BO-1 (0.12) 50.2 | HEMA (0.19) 24.8 HEA (0.07) 8.2 | 36.5 |
| P-40 | " | BI-1 (0.12) 50.0 | HEMA (0.26) 34.0 | 31.4 |
| P-41 | " | PX (0.12) 16.3 | " | 27.2 |
| P-42 | " | TOL (0.12) 25.5 | " | 29.0 |

| Precursor No. | Tetracarboxylic dianhydride (mole) g | Diamine (mole) g | Alcohol (mole) g | VN (ml/g) |
|---|---|---|---|---|
| P-43 | PMDA (0.13) 28.4 | p-PD (0.114) 12.3 ODA (0.006) 1.2 | HEMA (0.26) 34.0 | 29.7 |
| P-44 | " | ODA (0.12) 24.0 | " | 30.2 |
| P-45 | " | DAPP (0.12) 49.3 | " | 30.0 |
| P-46 | BTDA (0.13) 41.9 | p-PD (0.12) 13.0 | " | 32.1 |
| P-47 | " | OX-2 (0.12) 41.0 | " | 33.4 |
| P-48 | PMDA (0.13) 28.4 | " | " | 28.9 |
| P-49 | " | DA-1 (0.12) 47.5 | " | 29.3 |
| P-50 | " | OX-1 (0.12) 50.3 | " | 30.1 |
| P-51 | OXDA (0.13) 68.6 | p-PD (0.12) 13.0 | " | 29.8 |

| Precursor No. | Tetracarboxylic dianhydride (mole) g | Diamine (mole) g | Alcohol (mole) g | VN (ml/g) |
|---|---|---|---|---|
| P-52 | PMDA (0.13) 28.4 | BO-1 (0.12) 50.2 | MEO (0.26) 19.8 | 36.3 |
| P-53 | " | BO-4 (0.12) 59.3 | " | 35.1 |
| P-54 | " | ODA (0.12) 24.0 | " | 33.4 |
| P-55 | BTDA (0.13) 41.9 | p-PD (0.12) 13.0 | " | 33.9 |

Table 1 (1-2)

| Precursor No. | Tetracarboxylic dianhydride (mole) g | Diamine (mole) g | VN (ml/g) |
|---|---|---|---|
| P-1 (E) | PMDA (0.10) 21.8 | BO-1 (0.09) 37.6 | 45.2 |
| P-5 (E) | " | BT-1 (0.09) 40.3 | 48.3 |
| P-1 (EM) | PMDA (0.15) 32.8 | BO-1 (0.14) 58.6 | 85.1 |

Table 1 (1-3)

| Precursor No. | Tetracarboxylic dianhydride (mole) g | Diamine (mole) g | VN (ml/g) |
|---|---|---|---|
| P-1 (EA) | PMDA (0.10) 21.8 | BO-1 (0.09) 37.6 | 66.0 |
| P-5 (EA) | " | BT-1 (0.09) 40.3 | 69.3 |
| P-1 (EAM) | PMDA (0.15) 32.8 | BO-1 (0.14) 58.6 | 113.0 |

Table 1 (1-4)

| Precursor No. | Tetracarboxylic dianhydride (mole) g | Diamine (mole) g | VN (ml/g) |
|---|---|---|---|
| P-3 (EI) | PMDA (0.10) 21.8 | BO-4 (0.09) 44.5 | 70.5 |
| P-9 (EI) | TPDA (0.10) 37.0 | PBI-3 (0.09) 58.0 | 78.1 |
| P-3 (EIM) | PMDA (0.15) 32.7 | BO-4 (0.14) 69.2 | 124.1 |

Table 1 (1-5)

| Precursor No. | Tetracarboxylic dianhydride (mole) g | Diamine (mole) g | VN (ml/g) |
|---|---|---|---|
| P-1 (A) | PMDA (0.05) 10.9 | BO-1 (0.04) 16.7 | 38.6 |
| P-5 (A) | " | BT-1 (0.04) 17.9 | 39.1 |
| P-10 (A) | BPDA (0.05) 14.7 | BO-3 (0.04) 13.7 | 35.5 |
| P-19 (A) | TPDA (0.05) 18.5 | BT-4 (0.04) 15.0 | 40.4 |
| P-1 (AM) | PMDA (0.2) 43.7 | BO-1 (0.19) 79.5 | 190.2 |
| P-42 (AM) | " | TOL (0.19) 40.4 | 188.6 |
| P-47 (AM) | BTDA (0.2) 64.5 | OX-2 (0.19) 64.9 | 195.1 |

Table 1 (2)

| Photopolymerization Initiator No. | Formula |
|---|---|
| K-1 | 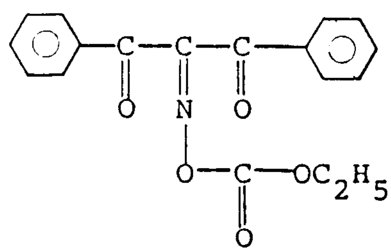 |
| K-2 | 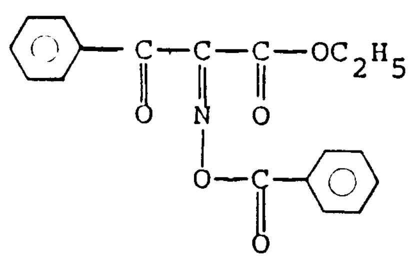 |
| K-3 | 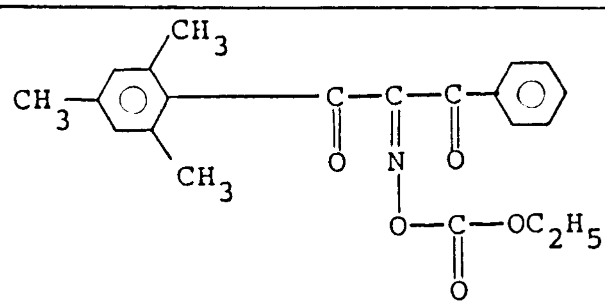 |

Table 1 (3)

| Monomer No. | Name |
|---|---|
| M-1 | trimethylolpropane triacrylate |
| M-2 | tetraethylene glycol diacrylate |
| M-3 | methylene bisacrylamide |

Table 1 (4)

| Photo-sensitizer No. | Formula |
|---|---|
| B-1 | 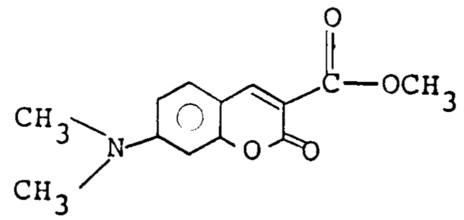 |
| B-2 | 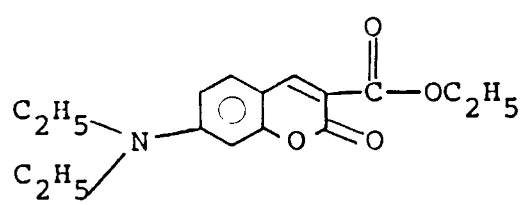 |
| B-3 | 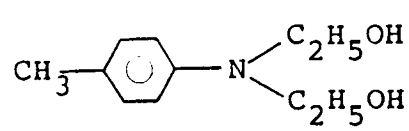 |

Table 1 (5)

| Mercaptan No. | Name |
|---|---|
| A-1 | 2-mercaptobenzimidazole |
| A-2 | 1-phenyl-5-mercapto-1H-tetrazol |
| A-3 | 2-mercaptobenzthiazol |

Table 1 (6)

| Silane No. | Name |
|---|---|
| D-1 | 3-methacryloxypropyltrimethoxysilane |
| D-2 | 3-methacryloxypropyldimethoxymethylsilane |
| D-3 | diethoxy-3-glycidoxypropylmethylsilane |

Table 1 (7)

| Stabilizer | Name |
|---|---|
| Z-1 | N-nitrosodiphenylamine |
| Z-2 | P-tert-butylcatechol |

[Use Examples and Comparative Use Examples of Precursors]

Examples 1 to 44 and 49 and Comparative Examples 1 to 13

To 100 parts by weight of the precursor indicated in Table 2 were added additives indicated in Table 2 together with individual amounts thereof in parentheses. The resultant mixture was dissolved in 150 parts by weight of N-methylpyrrolidone to obtain a solution of a photopolymerizable resin composition. The solution was spin-coated on a silicon wafer at 2,000 r.p.m. for 30 seconds and dried in air at 70 °C for 90 minutes to obtain a uniform coating film having a thickness of about 20 µm.

Then, the coated silicon wafer was exposed through a photomask bearing a test pattern to g-line using a g-line stepper, FPA 1550 MII manufactured and sold by Canon Inc., Japan (illuminance at the surface of the silicon wafer: 520 mW/cm$^2$). The exposed silicon wafer was left to stand at room temperature for 1 hour, developed with a mixed solvent of N-methylpyrrolidone and isopropyl alcohol (at a volume ratio of 3/1) using a spray type developing machine, rinsed with isopropyl alcohol and dried. The photosensitivity was determined from the exposure dose which clearly resolved the 20 µm line and the inter-line spacing in the test pattern. The smaller exposure dose means that the photosensitivity is higher.

The results thus obtained are shown in Table 2.

The photopolymerizable composition of the present invention not only can form a pattern in the same manner as in the case of the conventional photopolymerizable composition comprising a polyimide precursor, but also is excellent in the sharpness of the pattern formed as compared to that of the conventional photopolymerizable composition. Further, as apparent from the results, even without the addition of a photosensitizer, the photopolymerizable composition of the present invention has sensitivity to actinic radiation (g-line).

Examples 45 to 48 and Comparative Examples 14 and 15

In substantially the same manner as described in Examples 1 to 44, each of the photopolymerizable compositions comprising precursors and additives as indicated in Table 2 was coated on a silicon wafer and

dried, thereby obtaining a coating film having a thickness of about 10 μm. After exposure under substantially the same conditions as in Examples 1 to 44, development was performed using a mixture of 3 % aqueous choline solution, isopropyl alcohol and diethylene glycol dimethyl ether (at a volume ratio of 70/5/25). Then, rinse was conducted by means of water, thereby obtaining a pattern.

The results are shown in Table 2. As is apparent from the results, with respect to the photopolymerizable composition of the present invention, development can be performed by means of an alkaline solution.

From the results of Examples 1 to 49 and Comparative Examples 1 to 15, it is noted that both in the case of development by means of a solvent and in the case of development by means of an alkaline solution, the greater the reduced viscosity of the precursor, the lower the developability becomes. Table 2 shows that from the viewpoint of developability, the preferred reduced viscosity is smaller than 80 (ml/g), and that when the reduced viscosity of the precursor is greater than 100 (ml/g), development cannot be performed.

Examples 50 and 51

To the photopolymerizable compositions obtained in Examples 45 and 47 was further added N,N'-dimethylaminoethyl methacrylate in amounts of 11.0 g and 19.2 g, respectively. The properties of the photopolymerizable compositions were measured in the same manner as in Examples 1 to 44, and the sensitivity was found to be 560 $mJ/cm^2$ in each case.

Table 2 (1)

| Example | Pre-cursor | Photopoly-merization Initiator | Monomer | Photosen-sitizer | Mercaptan Compound | Silane Compound | Stabilizer | Photosen-sitivity ($mJ/cm^2$) |
|---|---|---|---|---|---|---|---|---|
| 1 | P-1 | K-1 (3) | -- | -- | -- | -- | -- | 620 |
| 2 | " | K-1 (3) | M-1 (6) | B-1 (0.4) | A-1 (2) | D-1 (2) | Z-1 (0.1) | 560 |
| 3 | P-2 | K-2 (3) | " | B-3 (2) | " | " | " | " |
| 4 | P-3 | " | " | B-2 (0.4) | -- | " | " | 580 |
| 5 | P-4 | K-3 (3) | M-2 (6) | " | A-2 (2) | " | Z-2 (0.1) | 540 |
| 6 | P-5 | " | " | -- | " | D-2 (2) | " | 560 |
| 7 | P-6 | K-1 (4) | -- | -- | -- | " | " | 620 |
| 8 | P-7 | " | M-2 (6) | B-2 (0.4)<br>B-3 (2) | A-2 (2) | " | " | 540 |
| 9 | P-8 | " | " | " | " | " | Z-1 (0.1) | " |

Table 2 (2)

| Example | Pre-cursor | Photopoly-merization Initiator | Monomer | Photosen-sitizer | Mercaptan Compound | Silane Compound | Stabiliz-er | Photosen-sitivity (mJ/cm$^2$) |
|---|---|---|---|---|---|---|---|---|
| 10 | P-9 | K-1 (3) | M-2 (6) | B-2 (0.4) | A-2 (2) | D-1 (2) | Z-1 (0.2) | 560 |
| 11 | P-10 | " | " | " | " | " | " | " |
| 12 | P-11 | " | M-3 (6) | " | " | " | " | 580 |
| 13 | P-12 | " | " | B-1 (0.4)<br>B-3 (2) | " | " | " | 560 |
| 14 | P-13 | " | " | " | " | " | Z-2 (0.1) | " |
| 15 | P-14 | " | M-2 (6) | B-1 (0.4) | " | D-2 (2) | " | " |
| 16 | P-15 | " | " | " | " | " | " | " |
| 17 | P-16 | K-3 (3) | " | " | " | " | " | " |
| 18 | P-17 | " | " | " | " | " | " | " |

Table 2 (3)

| Example | Pre-cursor | Photopoly-merization Initiator | Monomer | Photosen-sitizer | Mercaptan Compound | Silane Compound | Stabiliz-er | Photosen-sitivity (mJ/cm$^2$) |
|---|---|---|---|---|---|---|---|---|
| 19 | P-18 | K-2 (3) | M-2 (6) | B-2 (0.4)<br>B-3 (2) | -- | D-3 (2) | Z-2 (0.1) | 580 |
| 20 | P-19 | " | " | " | -- | " | " | " |
| 21 | P-20 | " | " | " | -- | " | " | " |
| 22 | P-21 | " | " | " | -- | " | Z-1 (0.1) | " |
| 23 | P-22 | " | " | " | -- | " | " | " |
| 24 | P-23 | " | " | " | -- | " | " | " |
| 25 | P-24 | K-1 (3) | " | " | A-3 (2) | D-1 (2) | " | 560 |
| 26 | P-25 | " | " | " | " | " | " | " |
| 27 | P-26 | " | " | " | " | " | " | " |

Table 2 (4)

| Example | Pre-cursor | Photopoly-merization Initiator | Monomer | Photosen-sitizer | Mercaptan Compound | Silane Compound | Stabiliz-er | Photosen-sitivity ($mJ/cm^2$) |
|---|---|---|---|---|---|---|---|---|
| 28 | P-27 | K-1 (3) | M-1 (6) | B-1 (0.4)<br>B-3 (2) | A-2 (2) | D-2 (2) | Z-2 (0.1) | 560 |
| 29 | P-28 | " | " | " | " | " | " | " |
| 30 | P-29 | K-3 (3) | M-2 (6) | " | " | " | " | " |
| 31 | P-30 | " | " | " | " | " | " | " |
| 32 | P-31 | " | " | " | " | " | " | " |
| 33 | P-32 | " | " | " | " | " | Z-1 (0.1) | " |
| 34 | P-33 | " | " | " | " | " | " | " |
| 35 | P-34 | " | " | B-3 (2) | " | " | " | " |
| 36 | P-35 | " | " | " | " | " | " | " |

Table 2 (5)

| Example | Pre-cursor | Photopolymerization Initiator | Monomer | Photosensitizer | Mercaptan Compound | Silane Compound | Stabilizer | Photosensitivity ($mJ/cm^2$) |
|---|---|---|---|---|---|---|---|---|
| 37 | P-36 | K-3 (3) | M-3 (6) | B-2 (0.4) | A-3 (2) | D-1 (2) | Z-1 (0.1) | 560 |
| 38 | P-37 | K-1 (3) | " | " | " | " | " | " |
| 39 | P-38 | " | " | " | " | " | " | 540 |
| 40 | P-39 | " | M-2 (6) | " | " | " | Z-2 (0.1) | " |
| 41 | P-40 | " | " | " | " | " | " | 560 |
| 42 | P-1 (E) | K-3 (3) | " | B-1 (0.4)<br>B-3 (2) | -- | D-2 (2) | " | " |
| 43 | P-5 (E) | " | " | " | -- | " | " | " |
| 44 | P-1 (EM) | " | " | " | -- | " | " | *580 |
| 45 | P-1 (EA) | " | " | " | A-2 (2) | " | " | 660 |

Note *: Since 20μm lines were not resolved, evaluation was made with respect to 30μm lines and spacings.

Table 2 (6)

| Example | Pre-cursor | Photopoly-merization Initiator | Monomer | Photosen-sitizer | Mercaptan Compound | Silane Compound | Stabiliz-er | Photosen-sitivity ($mJ/cm^2$) |
|---|---|---|---|---|---|---|---|---|
| 46 | P-5 (EA) | K-3 (3) | M-2 (6) | B-2 (0.4)<br>B-3 (2) | A-2 (2) | D-1 (2) | Z-2 (0.1) | 620 |
| 47 | P-3 (EI) | " | " | " | " | " | " | 600 |
| 48 | P-9 (EI) | " | " | " | " | " | " | 620 |
| 49 | P-1 (70)*<br>P-37(30)* | " | " | " | " | " | " | 560 |
| | | | | | | | | |
| | | | | | | | | |
| | | | | | | | | |
| | | | | | | | | |
| | | | | | | | | |

Note*: Numerals in parentheses indicate proportions (% by weight) of precursors.

Table 2 (7)

| Comparative Example | Precursor | Photopolymerization Initiator | Monomer | Photosensitizer | Mercaptan Compound | Silane Compound | Stabilizer | Photosensitivity (mJ/cm$^2$) |
|---|---|---|---|---|---|---|---|---|
| 1 | P-41 | K-1 (3) | M-1 (6) | B-1 (0.4) | A-1 (2) | D-1 (2) | Z-1 (0.1) | 560 |
| 2 | P-41 | " | " | -- | " | " | " | > 1000 |
| 3 | P-42 | " | -- | -- | -- | -- | -- | > 1000 |
| 4 | P-42 | K-2 (3) | M-2 (6) | B-1 (0.4) | A-2 (2) | D-1 (2) | Z-1 (0.1) | 560 |
| 5 | P-43 | " | " | " | " | " | " | " |
| 6 | P-44 | " | " | " | " | " | " | " |
| 7 | P-45 | " | " | " | " | " | " | " |
| 8 | P-46 | K-3 (3) | M-3 (6) | B-2 (0.4)<br>B-3 (2) | A-3 (2) | D-3 (2) | Z-2 (0.1) | 550 |
| 9 | P-47 | " | " | " | " | " | " | " |

Table 2 (8)

| Comparative Example | Precursor | Photopolymerization Initiator | Monomer | Photosensitizer | Mercaptan Compound | Silane Compound | Stabilizer | Photosensitivity ($mJ/cm^2$) |
|---|---|---|---|---|---|---|---|---|
| 10 | P-48 | K-1 (3) | M-2 (6) | B-1 (0.4)<br>B-3 (2) | A-1 (2) | D-2 (2) | Z-1 (0.1) | 550 |
| 11 | P-49 | " | " | " | " | " | " | " |
| 12 | P-50 | " | " | " | " | " | " | " |
| 13 | P-51 | " | " | " | " | " | " | " |
| 14 | P-1 (EAM) | K-3 (3) | " | B-2 (0.4)<br>B-3 (2) | A-2 (2) | D-1 (2) | Z-2 (0.1) | cannot be developed |
| 15 | P-3 (EIM) | " | " | " | " | " | " | " |
| | | | | | | | | |
| | | | | | | | | |
| | | | | | | | | |

[Evaluation of the properties of a coating film]

Measurement of mechanical strength of films prepared from photopolymerizable compositions-Method I

Each of the photopolymerizable compositions obtained in Examples 1 to 49 and Comparative Examples 1 to 13 was coated in a thickness of about 30 µm on an aluminum disk having a thickness of 0.5 mm and a diameter of 7.5 cm by means of a spin coater, while rotating the disk. The resultant coating layer of the composition was dried at 70 °C for 1 hour and cooled. Then, the coating layer was exposed through a photomask bearing a dumbbell image (comprising an intermediate slender rectangular portion of 3 mm in width and 200 mm in length and a pair of wider end portions respectively extending from both ends of the rectangular portion) to actinic rays from an extra-high pressure mercury lamp (8 $mW/cm^2$) for 120 minutes, and developed with an organic solvent or an alkaline solution. The thus obtained product, consisting of the disk and having thereon a dumbbell pattern of photoinsolubilized precursor, was heated under a stream of nitrogen first at 140 °C for 2 hours and then at 450 °C for 2 hours, thereby converting the photoinsolubilized precursor, to a polyimide. The product was immersed in 3N hydrochloric acid, thereby dissolving the aluminum disk while leaving the polyimide dumbbell pattern, washed with water and dried at 70 °C for 8 hours. Thus, a test specimen was obtained. The test specimen was subjected to measurement of each of the tensile strength at break, tensile elongation at break and tensile modulus of elasticity using a tensile machine (TENSILON, UTM-II-Type 20 manufactured and sold by Toyo Baldwin Co., Ltd., Japan), in which the dumbbell pattern speciman was set by clamping the wider end portions of the specimen and then stretching.

Measurement of mechanical strength of films prepared from non-photopolymerizable precursor varnishes and non-photopolymerizable compositions-Method II

With respect to each of precursor varnishes obtained by dissolving 100 parts by weight of each of precursors P-52 to P-55 indicated in Table 1 in 150 parts by weight of NMP and stirring well, the varnishes indicated in Table 1 (1-5) and the compositions of Comparative Examples 14 and 15, coating films were prepared and the mechanical strengths of the coating films were measured according to the following procedure.

Each of the varnishes and compositions was coated on a glass plate in a uniform thickness by means of a spin coater and dried at 80 to 100 °C for 30 to 60 minutes, to thereby obtain a film. The film was heated first at 140 °C for 2 hours and then at 400 °C for 2 hours. Thus, a polyimide film having a thickness of about 15 µm was obtained. From the film, a strip-form specimen having a width of 3 mm and a length of 80 mm was cut out. The mechanical strength of the specimen was measured in the same manner as described in "measurement of mechanical strength of tilms prepared from photopolymerizable compositions-Method I" above.

Evaluation of water resistance of adhesion with respect to films prepared from photopolymerizable compositions-Method I

Each of the photopolymerizable compositions obtained in Examples 1 to 49 and Comparative Examples 1 to 13 was individually coated on a silicon wafer having a 7.6 cm (3-inch) diameter by means of a spin coater while rotating the silicon wafer, and dried at 70 °C for 1 hour, thereby obtaining a coating film having a thickness of about 30 µm. This film was exposed through a photomask bearing a 1.5 mm square-lattice image to actinic rays from an extra-high pressure mercury lamp (8 $mW/mm^2$) for 120 sec under a stream of nitrogen. Subsequently, the development and heat treatment were performed in substantially the same manner as described in "measurement of mechanical strength for films prepared from photopolymerizable compositions-Method I" above, thereby obtaining a silicon wafer having formed thereon a lattice pattern of a polyimide film, as a sample to be used for evaluation of water resistance of the adhesion between the silicon wafer and the polyimide film. This sample was allowed to stand still for 100 hours in an atmosphere in which the temperature was 133 °C, the pressure was 3 atm and the humidity was 100 %, and then subjected to a tape peeling test in accordance with JIS (Japanese Industrial Standard) D0202 using an adhesive tape (Scotch® mending tape manufactured and sold by Sumitomo 3M, Japan). The ratio of the number of lattices remaining after the peeling test to the original number of lattices was determined.

Evaluation of water resistance of adhesion with respect to films prepared from non-photopolymerizable precursor varnishes-Method II

The precursor varnishes indicated in Table 1 (1-5) and the varnishes prepared by dissolving precursors P-52 to P-55 in NMP as mentioned hereinbefore were individually coated on a silicon wafer having a diameter of 7.6 cm (3 inches) by means of a spin coater while rotating the silicon wafer, and dried at 70 °C for 1 hour. As the silicon wafer, use was made of one prepared by spin coating a 0.2 % methanol solution of $\gamma$-aminopropyldimethoxymethylsilane on a silicon wafer substrate at 5,000 rpm for 30 seconds, followed by heating at 150 °C for 10 minutes using a hot plate. The resultant coating film was heated first at 140 °C for 2 hours and then at 400 °C for 2 hours, thereby obtaining a polyimide coating film having a thickness of about 15 $\mu$m. A 5 mm square-lattice pattern was formed in the coating film by means of a cutter, thereby obtaining a sample for evaluation of water resistance of the adhesion. The sample was subjected to evaluation of the water resistance of the adhesion in substantially the same manner as described in "evaluation of water resistance of adhesion with respect to films prepared from photopolymerizable compositions-Method I" above.

Measurement of residual stress

The photopolymerizable compositions obtained in Examples 1 to 49 and Comparative Examples 1 to 13, the precursor varnishes indicated in Table 1 (1-5) and the precursor varnishes prepared by dissolving precursors P-52 to P-55 in NMP as mentioned above were individually coated on a silicon wafer having a thickness of 370 $\mu$m and a diameter of 7.6 cm (3 inches) to have a coating thickness of 10 to 15 $\mu$m, while rotating the wafer. When the non-photopolymerizable varnishes were employed, use was made of a silicon wafer treated with silane in the same manner as described in "evaluation of water resistance of adhesion with respect to films prepared from photopolymerizable compositions-Method I" above. The resultant coating layer was dried first at 90 °C for 1 hour, and then heated at 140 °C for 2 hours and further at 400 °C for 2 hours, followed by cooling. Thus, a polyimide coating film was formed on the wafer. By the above heating, the wafer was curved to have an arch form. With respect to the center portion (3 cm in diameter) of the wafer on the non-coated side thereof, the degree of curving was measured by means of a contact type surface roughness tester (model DEKTAK II A manufactured and sold by Sloan Technology Co., U.S.A.). That is, the height($\mu$m) at the center of the curve of the arch was measured by the above-mentioned tester and designated $\Delta$. Residual stress $\delta$ can be calculated from formula (1) shown below:

$$\text{Residual stress } \delta = \underline{\frac{E}{3(1-V)} \cdot \frac{TS^2}{\frac{D^2}{2}}} \cdot \frac{\Delta}{T} \quad \ldots\ldots\ldots\ldots (1)$$

wherein E is the Young's modulus of the silicon wafer; V is the Poisson's ratio of the silicon wafer; D is the diameter of the center portion (30 mm); TS is the thickness(mm) of the silicon wafer; and T is the thickness($\mu$m) of a coating film (after heat treatment).

In the above formula, the underlined portion is a value specific to a silicon wafer, and hence in the present measurement this value is a constant(k). Therefore, the residual stress $\delta$ can be expressed by formula (2) below:

$$\delta = K \cdot \frac{\Delta}{T} \quad (2)$$

wherein K is calculated to be 3.91 [Kg/mm$^2$].

The coating film was grooved in the depth of just the entire thickness of the film and the thickness (T) of the coating film was measured by means of the contact type surface roughness tester as mentioned above. Residual stress $\delta$ was calculated from formula (2) based on the values of T, $\Delta$ and K.

In the evaluation of properties described hereinbefore, in the case of samples from precursor varnishes P-1(AM), P-42(AM) and P-47(AM), multilayer coating was needed to obtain a predetermined thickness.

Evaluation of storage stability

The photopolymerizable compositions and precursor varnishes as used in the evaluation of residual stress were stored at room temperature for 2 weeks, and the changes in viscosity were determined. The viscosities were measured at 23 °C by means of an E-type viscometer.

Results of the Evaluation Tests and Observations Thereof

The results are shown in Table 3 (1) through (7). In Table 3, the description "brittle" in the column of elongation at break means that the sample was too brittle to be measured with respect to elongation at break. In the column of viscosity change, "+" means an increase in viscosity and "-" means a decrease in viscosity.

As apparent from the results of the measurements, with respect to the polyimide coating films formed from the precursor varnish comprising the precursor of the present invention and formed from the photopolymerizable composition of the present invention, the residual stress values are advantageously extremely small, as compared to those of the coating films formed from conventional precursors and compositions. Further, the coating films prepared from the precursor of the present invention and frown the photopolymerizable composition of the present invention are extremely less brittle as compared to conventional low thermal stress polyimides.

Moreover, in the present invention, although a precursor containing an imidazole ring is affected by water to some extent, polyimides containing other types of heterocyclic rings are extremely excellent in water resistance of adhesion. The precursor and the photopolymerizable composition according to the present invention are extremely stable to hydrolysis as compared to the conventional polyamic acids.

As is apparent from the above, the present precursor and composition yields a polyimide having properties superior to those of the polyimide from conventional polyamic acids.

Table 3 (1)

| Example No. | Pre-cursor | Tensile strength at break ($kg/mm^2$) | Elongation at break (%) | Tensile modulus ($kg/mm^2$) | Water resistance of adhesion | Residual stress ($kg/mm^2$) | Viscosity change (%) |
|---|---|---|---|---|---|---|---|
| 1,2 | P-1 | 13.0 | 4.5 | 380 | 100/100 | 1.6 | +1.1 |
| 3 | P-2 | 12.6 | 3.8 | 375 | 100/100 | 1.5 | +2.1 |
| 4 | P-3 | 13.0 | 4.1 | 388 | 100/100 | 1.1 | +1.4 |
| 5 | P-4 | 13.1 | 3.9 | 385 | 100/100 | 1.2 | +2.5 |
| 6 | P-5 | 12.9 | 4.3 | 376 | 100/100 | 1.6 | +1.3 |
| 7 | P-6 | 13.9 | 4.4 | 378 | 100/100 | 1.7 | +1.7 |
| 8 | P-7 | 12.9 | 3.8 | 389 | 100/100 | 1.3 | +1.5 |
| 9 | P-8 | 13.2 | 4.2 | 410 | 100/100 | 2.0 | +3.3 |
| 10 | P-9 | 13.3 | 4.0 | 394 | 100/100 | 1.3 | +2.9 |
| 11 | P-10 | 12.9 | 3.9 | 379 | 100/100 | 1.6 | +1.0 |

Table 3 (2)

| Example No. | Pre-cursor | Tensile strength at break ($kg/mm^2$) | Elongation at break (%) | Tensile modulus ($kg/mm^2$) | Water resistance of adhesion | Residual stress ($kg/mm^2$) | Viscosity change (%) |
|---|---|---|---|---|---|---|---|
| 12 | P-11 | 12.7 | 3.8 | 382 | 100/100 | 1.7 | +1.3 |
| 13 | P-12 | 12.7 | 4.0 | 390 | 100/100 | 2.0 | +2.3 |
| 14 | P-13 | 13.0 | 3.7 | 390 | 100/100 | 1.8 | +2.0 |
| 15 | P-14 | 13.3 | 4.1 | 388 | 100/100 | 1.7 | +1.1 |
| 16 | P-15 | 13.2 | 3.9 | 385 | 100/100 | 1.7 | +1.5 |
| 17 | P-16 | 14.2 | 4.1 | 413 | 100/100 | 1.7 | +1.0 |
| 18 | P-17 | 13.8 | 3.8 | 450 | 100/100 | 1.5 | +1.2 |
| 19 | P-18 | 14.0 | 4.0 | 409 | 100/100 | 1.8 | +1.0 |
| 20 | P-19 | 13.7 | 3.6 | 437 | 100/100 | 1.6 | +1.1 |
| 21 | P-20 | 13.5 | 4.6 | 390 | 100/100 | 1.6 | +1.4 |

Table 3 (3)

| Example No. | Pre-cursor | Tensile strength at break ($kg/mm^2$) | Elongation at break (%) | Tensile modulus ($kg/mm^2$) | Water resistance of adhesion | Residual stress ($kg/mm^2$) | Viscosity change (%) |
|---|---|---|---|---|---|---|---|
| 22 | P-21 | 13.0 | 3.6 | 395 | 100/100 | 1.5 | +1.3 |
| 23 | P-22 | 12.2 | 3.0 | 430 | 100/100 | 1.6 | +1.7 |
| 24 | P-23 | 12.8 | 3.5 | 420 | 100/100 | 1.7 | +1.1 |
| 25 | P-24 | 12.2 | 3.8 | 398 | 100/100 | 2.0 | +1.4 |
| 26 | P-25 | 12.6 | 3.9 | 381 | 100/100 | 1.9 | +1.8 |
| 27 | P-26 | 12.8 | 3.9 | 390 | 100/100 | 1.9 | +1.5 |
| 28 | P-27 | 13.4 | 4.3 | 361 | 100/100 | 2.1 | +1.0 |
| 29 | P-28 | 13.3 | 4.3 | 360 | 100/100 | 2.0 | +1.9 |
| 30 | P-29 | 13.0 | 3.7 | 423 | 100/100 | 2.2 | +1.7 |
| 31 | P-30 | 13.9 | 4.0 | 399 | 100/100 | 2.3 | +1.3 |

Table 3 (4)

| Example No. | Pre-cursor | Tensile strength at break ($kg/mm^2$) | Elongation at break (%) | Tensile modulus ($kg/mm^2$) | Water resistance of adhesion | Residual stress ($kg/mm^2$) | Viscosity change (%) |
|---|---|---|---|---|---|---|---|
| 32 | P-31 | 13.2 | 3.8 | 398 | 100/100 | 1.4 | +1.1 |
| 33 | P-32 | 13.5 | 3.6 | 435 | 100/100 | 1.5 | +1.3 |
| 34 | P-33 | 13.3 | 3.2 | 403 | 100/100 | 1.4 | +1.4 |
| 35 | P-34 | 13.0 | 4.0 | 400 | 100/100 | 1.3 | +1.1 |
| 36 | P-35 | 13.2 | 4.5 | 390 | 100/100 | 1.5 | +1.0 |
| 37 | P-36 | 13.1 | 4.4 | 380 | 100/100 | 1.6 | +1.1 |
| 38 | P-37 | 12.2 | 3.0 | 371 | 100/100 | 2.0 | +1.9 |
| 39 | P-38 | 12.7 | 3.2 | 375 | 100/100 | 1.9 | +2.0 |
| 40 | P-39 | 14.0 | 4.5 | 388 | 100/100 | 1.4 | +1.4 |
| 41 | P-40 | 12.9 | 4.1 | 377 | 80/100 | 1.4 | +6.0 |

Table 3 (5)

| Comparative Example No. | Pre-cursor | Tensile strength at break ($kg/mm^2$) | Elongation at break (%) | Tensile modulus ($kg/mm^2$) | Water resistance of adhesion | Residual stress ($kg/mm^2$) | Viscosity change (%) |
|---|---|---|---|---|---|---|---|
| 1,2 | P-41 | -- | brittle | -- | 0/100 | 1.8 | precursor precipitated |
| 3,4 | P-42 | 8.3 | 2.3 | 470 | 40/100 | 2.0 | +1.2 |
| 5 | P-43 | -- | brittle | -- | 0/100 | 1.8 | precursor precipitated |
| 6 | P-44 | 13.1 | 4.0 | 350 | 80/100 | 4.5 | +1.3 |
| 7 | P-45 | 13.5 | 4.3 | 340 | 100/100 | 4.9 | +1.1 |
| 8 | P-46 | 13.8 | 4.3 | 345 | 100/100 | 5.0 | +1.2 |
| 9 | P-47 | 14.0 | 4.6 | 346 | 100/100 | 4.8 | +1.6 |
| 10 | P-48 | 12.1 | 4.1 | 366 | 100/100 | 3.6 | +1.4 |
| 11 | P-49 | 12.6 | 4.6 | 352 | 100/100 | 4.0 | +2.5 |
| 12 | P-50 | 12.7 | 4.8 | 368 | 100/100 | 3.8 | +1.7 |

Table 3 (6)

| Comparative Example No. | Example No. | Precursor | Tensile strength at break ($kg/mm^2$) | Elongation at break (%) | Tensile modulus ($kg/mm^2$) | Water resistance of adhesion | Residual stress ($kg/mm^2$) | Viscosity change (%) |
|---|---|---|---|---|---|---|---|---|
| 13 | | P-51 | 12.1 | 3.9 | 388 | 100/100 | 3.9 | +2.0 |
| | 42 | P-1(E) | 14.5 | 4.6 | 392 | 100/100 | 1.4 | -1.0 |
| | 43 | P-5(E) | 14.1 | 4.5 | 390 | 100/100 | 1.3 | -0.8 |
| | 44 | P-1(EM) | 16.0 | 5.0 | 405 | 100/100 | 0.9 | -1.5 |
| | 45 [49] | P-1(EA) | 13.0 [14.9] *1 | 3.9 [4.7] *1 | 385 [410] *1 | 100/100 | 1.5 [1.3] *1 | -2.0 |
| | 46 | P-5(EA) | 14.6 | 4.6 | 398 | 100/100 | 1.2 | -2.1 |
| 14 | | P-1(EAM) | 16.0 | 6.2 | 410 | 100/100 | 0.9 | -2.0 |
| | 47 | P-3(EI) | 13.8 [15.5] *2 | 4.2 [5.0] *2 | 390 [411] *2 | 100/100 | 1.0 [0.8] *2 | -1.8 |
| | 48 | P-9(EI) | 15.3 | 4.2 | 401 | 100/100 | 0.9 | -2.2 |
| 15 | | P-3(EIM) | 17.0 | 5.5 | 415 | 100/100 | 0.6 | -2.5 |

Note: *1 Numerals in [ ] indicate the properties of the composition of Example 49.
*2 Numerals in [ ] indicate the properties of the composition of Example 50.

Table 3 (7)

| Comparative Example No. | Example No. | Precursor | Tensile strength at break (kg/mm2) | Elongation at break (%) | Tensile modulus (kg/mm2) | Water resistance of adhesion | Residual stress (kg/mm2) | Viscosity change (%) |
|---|---|---|---|---|---|---|---|---|
| | | P-1 (A) | 8.0 | 2.2 | 372 | 80/100 | 3.0 | -30 |
| 20 | | P-5 (A) | 8.3 | 2.4 | 370 | 80/100 | 3.1 | -33 |
| | | P-10 (A) | 9.2 | 2.7 | 369 | 80/100 | 3.5 | -29 |
| | | P-19 (A) | 8.9 | 2.1 | 390 | 80/100 | 3.7 | -25 |
| | | P-1 (AM) | 13.5 | 4.4 | 390 | 100/100 | 1.4 | -31 |
| 18 | | P-42 (AM) | 14.1 | 4.7 | 503 | 50/100 | 0.8 | -35 |
| 19 | | P-47 (AM) | 15.5 | 4.9 | 440 | 100/100 | 4.6 | -30 |
| | 52 | P-52 | 13.3 | 4.5 | 386 | 100/100 | 1.5 | +1.0 |
| | 53 | P-53 | 13.7 | 4.4 | 389 | 100/100 | 1.2 | +1.2 |
| 16 | | P-54 | 13.4 | 3.9 | 360 | 80/100 | 4.4 | +1.2 |
| 17 | | P-55 | 14.0 | 4.5 | 355 | 100/100 | 5.0 | +1.4 |

Examples 52 and 53 and Comparative Examples 16 and 17

From each of precursors P-52, P-53, P-54 and P-55, a 30 % NMP solution was prepared. The solution was coated on a rolled copper foil having a thickness of 35 μm and heated in the air at 80 °C for 60

minutes. Then, the coated copper foil was heated in a nitrogen atmosphere first at 140 °C for 30 minutes and then at 400 °C for 60 minutes, thereby obtaining a base board for a flexible printed circuit board, having a coating film of a thickness of about 20 µm. The base boards prepared using precursors P-52 and P-53 exhibited no curling even after etching, which is an essential step for preparing a flexible printed circuit board, and the boards underwent substantially no dimensional change even after immersion in a bath of molten solder at 350 °C, which is also an essential step for preparing a flexible printed circuit board. By contrast, the base boards prepared using precursors P-54 and P-55 were curled, with the polyimide-coated side thereof facing inside, by the above-mentioned heat treatment.

Example 54

Using the photopolymerizable composition described in Example 2, an α-ray shielding film was formed on a 12.7 cm (5-inch) diameter silicon wafer having provided thereon a vast plurality of memory elements, in the following manner. That is, the composition was coated on the silicon wafer in a manner such that the thickness of the film after heat treatment became about 60 µm, by means of a spin coater, and dried at 80 °C for 1 hour. Then, the resultant coating layer was exposed to actinic rays through a photomask so that only portions of the layer corresponding to the memory elements were photopolymerized. Subsequently, the layer was developed with a 3:1 mixture of NMP and isopropyl alcohol and heated first at 140 °C for 1 hour and then at 400 °C for 2 hours, thereby obtaining an α-ray shielding film of a polyimide formed on the memory elements. During the above operation, no problem was encountered. When the wafer was subjected to a pressure cooker testing [see technical standards promulgated by Electronic Industries Association of Japan EIAJ (employed prior to the establishment of Japanese Industrial Standards), No. IC-121: hereinafter referred to as "PCT"] at 133 °C under 3 atm for 100 hours, no change was observed on the wafer.

Comparative Examples 18 and 19

Using each of precursor varnishes P-42 (AM) and P-47 (AM) indicated in Table 1 (1-5), an α-ray shielding film was formed in the following manner. That is, a 0.2 % methanol solution of γ-aminopropyldimethoxymethylsilane was coated on a silicon wafer having provided thereon a vast plurality of memory elements and heated at 200 °C for 15 minutes. Then, the varnish was coated on the wafer in a manner such that the thickness after heat treatment became 60 µm, by means of a spin coater. A desired film thickness was not obtained by one-time coating, so it was inevitably needed to conduct multiple coatings. In the multiple coating, it was difficult to attain a uniform thickness. The coating layer was heated at 90 °C for 1 hour and then at 250 °C for 1 hour. Next, patterning using a conventional photoresist and etching using a mixture of hydrazine and ethylenediamine were performed so that the photoresist was left only on the memory elements. It was observed that the etching speed was greatly influenced by the conditions for the above heat treatment (this adversely affects the reproducibility with respect to the formation of an α-ray shielding film). Subsequently, the photoresist was removed and the wafer was subjected to heat treatment at 400 °C for 2 hours, thereby forming an α-ray shielding film on the memory elements. When the wafer was subjected to PCT at 133 °C under 3 atm for 100 hours, the polyimide film prepared from precursor varnish P-42(AM) exhibited peeling, suggesting that the polyimide film has a problem in long-term reliability. On the other hand, with respect to the polyimide film prepared from precursor varnish P-47(AM), extreme curving of the wafer and peeling of the polyimide film due to the thermal stress were observed after the above final heat treatment.

Example 55

Using the photopolymerizable composition obtained in Example 6, an LSI board having two aluminum circuit layers as shown in Fig. 1 was prepared in the following manner. That is, referring to Fig. 1, an aluminum layer was formed, by a conventional aluminum sputtering method, on a substrate consisting of silicon wafer 4 having accommodated therein an LSI circuit (not shown) and having formed thereon $SiO_2$ layer 3 which had been prepared according to customary CVD (Chemical Vapor Deposition) procedure. The aluminum layer was covered with a conventional photoresist, exposed to actinic rays through a photomask, developed and etched. Then, the photoresist was removed, thereby obtaining a preliminary structure consisting of first aluminum circuit layer 5a formed on the substrate. Subsequently, the photopolymerizable composition as mentioned above was coated on the preliminary structure, exposed to actinic rays through a photomask, developed, and heated first at 140 °C for 30 minutes and then at 400 °C for 1 hour to effect

imidization of the photoinsolubilized precursor in the photopolymerized composition, thereby obtaining first polyimide layer 1a having a thickness of about 1 μm and having via holes.

Subsequently, the surface of polyimide layer 1a was mechanically roughened. Then, formation of second aluminum circuit layer 5b on first polyimide layer 1a and first aluminum circuit layer 5a and in turn formation of second polyimide layer 1b on first polyimide layer 1a and second aluminum circuit layer 5b were carried out in substantially the same manner as described above. Then, SiN layer film 2 for imparting a moisture resistance was formed on second polyimide layer 1b by plasma CVD (Chemical Vapor Deposition), without occurrence of any cracking in SiN coating film 2. Thus, there was obtained a final structure as shown in Fig. 1. The resultant LSI board was subjected to a heat cycle test in accordance with MIL-STD-883C Method 1010.6 (Test Condition: allowed to stand still at 150 °C for 60 min and then at -50 °C for 60 min; 50 cycles). No change was observed. Further, the LSI board was subjected to the above-mentioned PCT at 133 °C under 3 atm for 100 hours. Also, no change was observed.

Comparative Example 20

Using precursor varnish P-5(A) indicated in Table 1(1-5), an LSI board having two aluminum circuit layers as shown in Fig. 1 was produced in the following manner. That is, first aluminum circuit layer 5a was formed by sputtering on the substrate in the same manner as described in Example 55, thereby obtaining a circuit-carrying substrate. Then, a 0.2 % methanol solution of γ-aminopropyldimethyoxymethylsilane was coated on the circuit-carrying substrate and heated at 200 °C for 15 minutes. The above-mentioned precursor varnish was coated on the resultant substrate, and dried at 90 °C for 20 minutes and heated first at 150 °C for 30 minutes and then at 350 °C for 30 minutes. The coating layer was covered with a conventional photoresist, exposed to actinic rays through a photomask, developed and etched. The photoresist was removed, thereby forming first polyimide layer 1a having a thickness of about 1 μm and having via holes, on the circuit-carrying substrate. Subsequently, the surface of polyimide layer 1a was mechanically roughened. The above-described procedure for forming an aluminum layer and a polyimide layer thereon was repeated. Thus, the final structure having the same layer structure as described in Example 55 was obtained. Subsequently, an SiN layer was formed in the same manner as described in Example 55. At this time, formation of cracks was observed in the SiN layer. Further, when the resultant LSI board was subjected to the above-mentioned PCT testing at 133 °C under 3 atm for 24 hours, corrosion was observed in the aluminum circuit layer.

Example 56

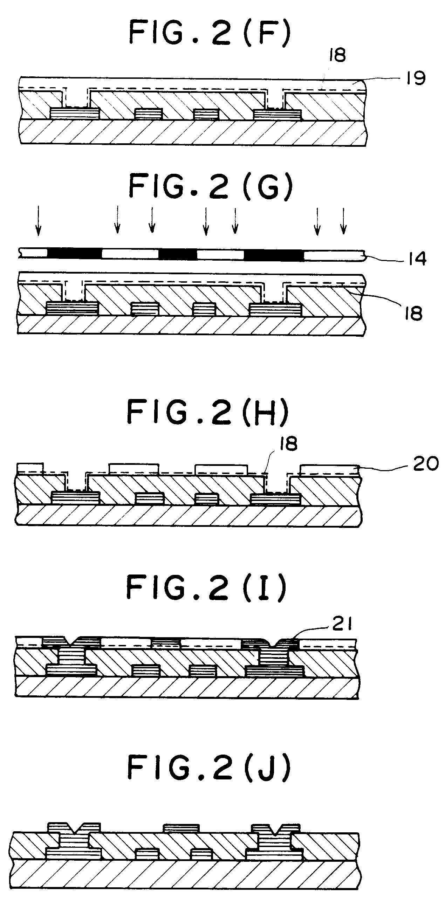

A 50 mm square ceramic substrate having a thickness of 1 mm was degreased and cleaned. Then, a Cr layer having a thickness of 1000 Å and subsequently a Cu layer having a thickness of 2500 Å were formed on the surface of the substrate according to customary sputtering procedure. The Cu layer was covered with a conventional photoresist, exposed to actinic rays through a photomask and developed. The resultant photoinsolubilized photoresist pattern-carrying substrate was immersed in a plating bath of copper sulfate, and copper electroplating was performed at a current density of 50 $mA/cm^2$, thereby obtaining a copper circuit layer of a thickness of 5 μm which has line portions of a line width of 50 μm and round portions (diameter of 100 μm) arranged at intervals of 500 μm for connecting the line portions. After the copper plating, the photoresist was removed by a remover, and then the resultant exposed portions of the Cu and Cr layers were subjected to quick etching with aqueous ammonium persulfate and then with aqueous cerium nitrate. Thus, a structure as shown in Fig. 2 (A), which consists of ceramic substrate 11 and, superimposed thereon, copper circuit layer 12 was obtained.

Next, as shown in Fig. 2 (B), photopolymerizable composition 13 obtained in Example 49 was coated on the above-obtained structure, and dried at 70 °C for 40 minutes using a hot-air drying machine. The resultant structure was exposed, through photomask 14 bearing an image of black dots of 75 μm in diameter arranged at intervals of 500 μm, to actinic rays from a light exposure apparatus having a 250 W extra-high pressure mercury lamp, as shown in Fig. 2 (C). Exposed portion 15 of the composition was photopolymerized. After photopolymerization, the coating composition layer was developed and heated under a nitrogen atmosphere first at 140 °C for 1 hour and then at 400 °C for 2 hours, thereby obtaining a structure as shown in Fig. 2 (D) which had polyimide insulating layer 16 having a thickness of 10 μm and via holes 17.

Referring to Figs. 2 (D) and (E), the surface of polyimide layer 16 and the inner surface of via holes 17 were washed, roughened and subjected to preliminary treatment for electroless copper plating to form electroless plating-receptive layer 18.

Thereafter, in substantially the same manner as described above, photoresist 19 was applied as shown in Fig. 2 (F), exposed through photomask 14 as shown in Fig. 2 (G), and developed to obtain a structure as shown in Fig. 2 (H) which had photoinsolubilized photoresist pattern 20. Electroless copper plating was performed to form a thin copper layer (not shown) on the exposed, electroless plating-receptive layer 18, and then copper electroplating in a plating bath of copper sulfate was conducted in the same manner as described above, to thereby obtain a structure as shown in Fig. 2 (I) which had two-layer copper circuit 21. After the copper plating, the photoresist was removed to obtain a structure as shown in Fig. 2 (J). The above procedure was repeated, thereby obtaining a four-layer circuit board. The thus obtained circuit board (which had 500 via holes) was subjected to heat shock testing in accordance with MIL-STD-883C Method 1010.6 (Test Condition: allowed to stand still at 420 °C for 60 min and then at 23 °C for 60 min; 50 cycles). After the test, the circuit board was examined to evaluate the reliability of plated copper-connection. No failures, such as breakage of circuit, were observed. Further, when the circuit board was subjected to PCT at 133 °C under 3 atm for 100 hours, no change occurred.

## Claims

**1.** A precursor of a low thermal stress polyimide comprising recurring units represented by at least one formula selected from the group consisting of:

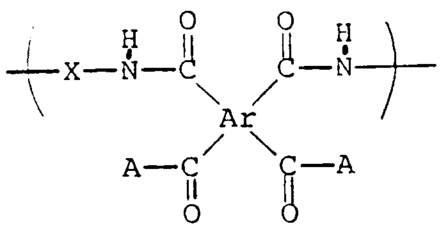

(I) , and

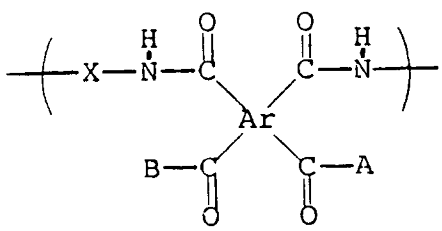

(II)

wherein Ar represents a tetravalent aromatic group having 6 to 30 carbon atoms,
X represents at least one divalent organic group having 6 to 30 carbon atoms, and
each of A and B independently represents a group selected frown the group consisting of:
$-OR^1$,

$$-\overset{H}{N}R^1,$$

$-O^{\ominus}R^{2\oplus}$ and -OH,

wherein each of $R^1$ and $R^2$ independently represents an organic group having 1 to 20 carbon atoms,

provided that A and B are not simultaneously -OH;

at least 20 mole % of said recurring units being units represented by at least one formula selected from the group consisting of:

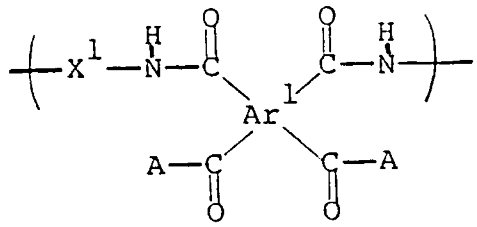

(III), and

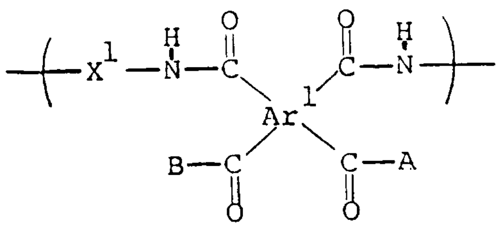

(IV)

wherein $Ar^1$ represents a tetravalent aromatic group selected from the group consisting of:

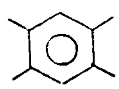 , 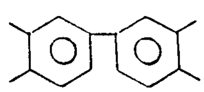 and 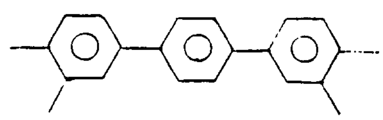 ,

A and B are as defined above, and
$X^1$ represents at least one divalent group selected from the group consisting of:

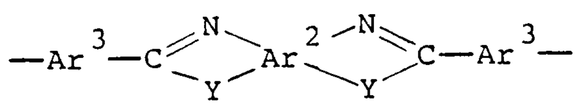 and

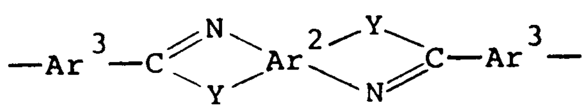 ,

wherein $Ar^2$ represents a tetravalent aromatic group selected from the group consisting of:

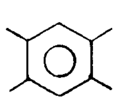 , 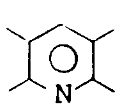 and 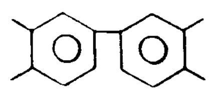 ,

$Ar^3$ represents a divalent aromatic group selected from the group consisting of:

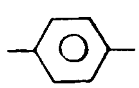 , 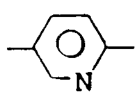 and 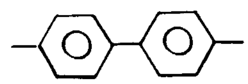 ,

and

Y represents a divalent group selected from the group consisting of -O-, -S-,

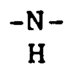 and 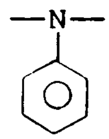 ;

said precursor having a reduced viscosity of from 10 to 200 ml/g as measured at 30 °C with respect to a 1.0 g/dl solution of the precursor in N-methylpyrrolidone.

**2.** A precursor according to claim 1, wherein each of said $R^1$ and $R^2$ independently has an ethylenic double bond, wherein said recurring units are represented by formula (II) and said at least 20 mole % of said recurring units are units represented by formula (IV), and said reduced viscosity is in the range of from 10 to 100 ml/g.

**3.** A precursor according to claim 1, wherein said Ar represents a tetravalent aromatic group selected from the group consisting of:

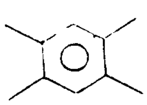 , 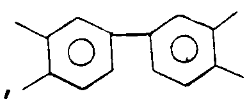 and 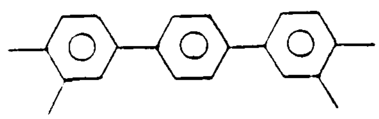 .

**4.** A precursor according to claim 1, containing as said X at least one divalent group selected from the group consisting of:

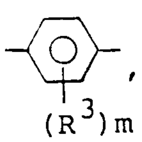 , 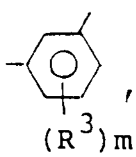 , 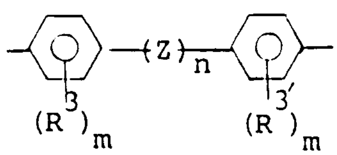 , 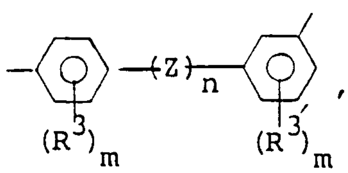 ,

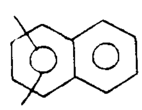 , 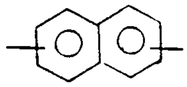 , 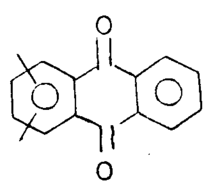 , 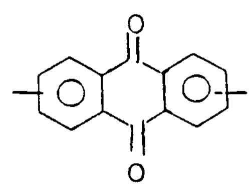 ,

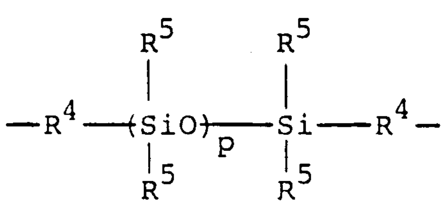 and 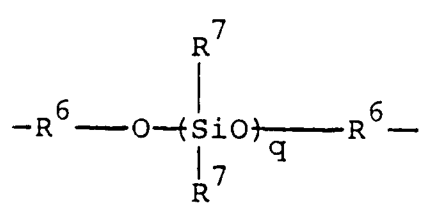

wherein each of $R^3$ and $R^{3'}$ independently represents a monovalent group selected from the group consisting of an alkyl group, an alkoxy group, a fluorinated alkyl group and a fluorinated alkoxy group each having 1 to 5 carbon atoms or a fluorine atom;

Z represents a divalent group selected from the group consisting of:

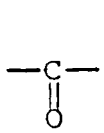, 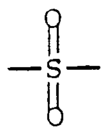, —O—, 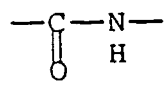, —$CH_2$—, 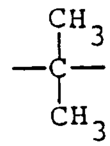, 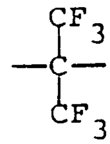,

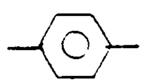, 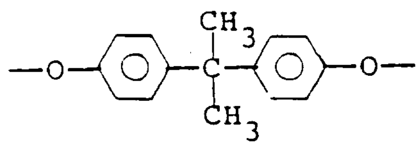, 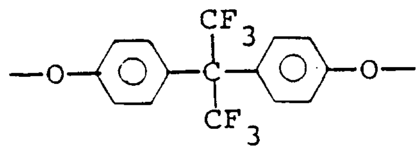

and 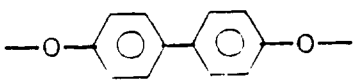;

each of $R^4$ and $R^6$ independently represents a divalent hydrocarbon residue having 1 to 14 carbon atoms;

each of $R^5$ and $R^7$ independently represents a monovalent hydrocarbon residue having 1 to 16 carbon atoms; and

m is an integer of from 0 to 4, n is an integer of 0 or 1, and each of p and q is independently an integer equal to or greater than 1.

**5.** A precursor according to claim 1, wherein the unit of formula (III) is represented by the formula selected from the group consisting of:

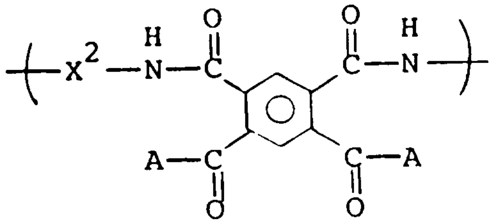

(III-1)

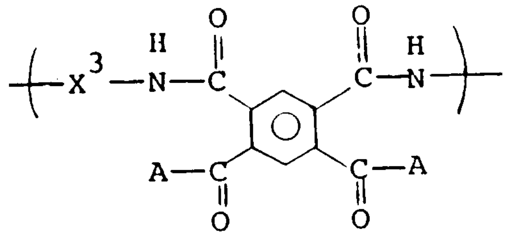

(III-2)

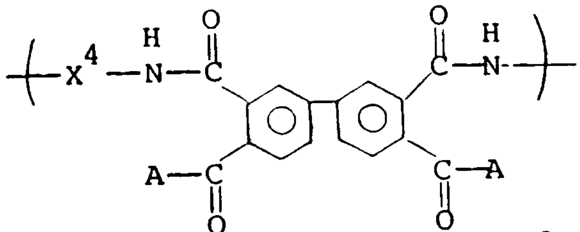

(III-3), and

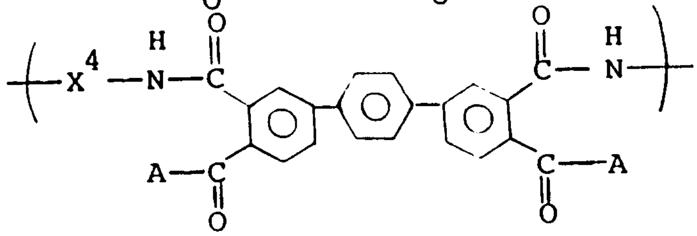

(III-4)

wherein A is as defined above.
$X^2$ represents at least one divalent group selected from the group consisting of:

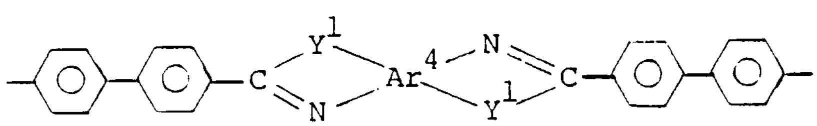

, and

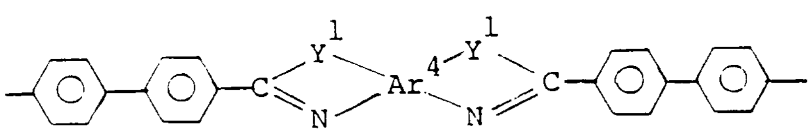

wherein $Ar^4$ represents a tetravalent group selected from the group consisting of:

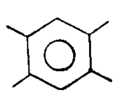

and

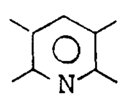

,

and

$Y^1$ represents a divalent group selected from the group consisting of:
-O-, -S- and

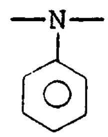 ;

$X^3$ represents at least one divalent group selected from the group consisting of:

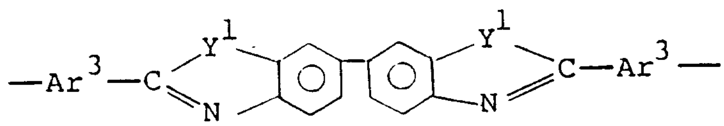 and

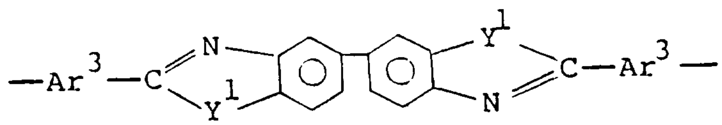

wherein $Ar^3$ and $Y^1$ are as defined above, and $X^4$ represents at least one divalent group selected from the group consisting of:

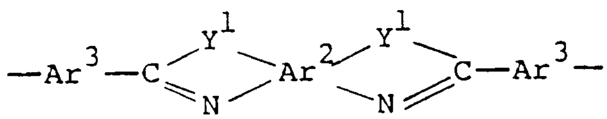 , and

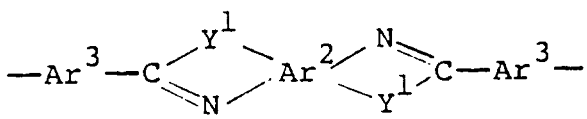

wherein $Ar^2$, $Ar^3$ and $Y^1$ are as defined above;
and the unit of formula (IV) is represented by the formula selected from the group consisting of:

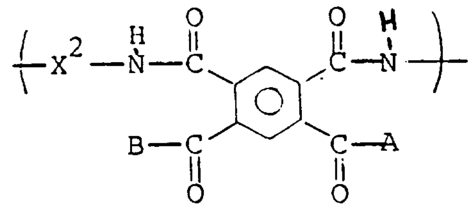

(IV-1)

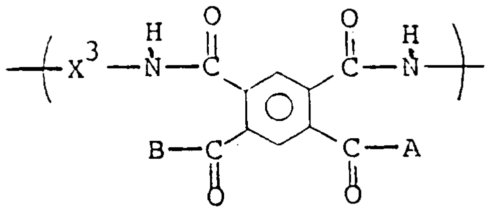

(IV-2)

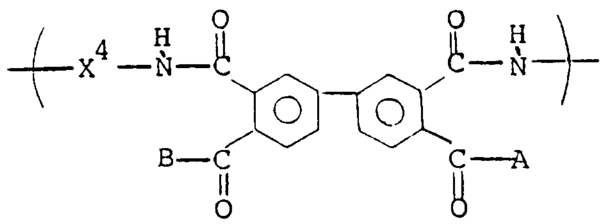

(IV-3), and

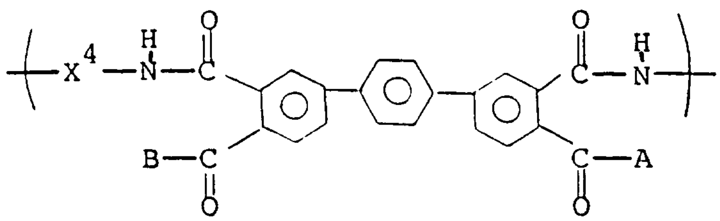

(IV-4)

wherein A, B, $X^2$, $X^3$ and $X^4$ are as defined above.

6. A precursor according to claim 1, wherein the amount of the units represented by at least one formula selected from the group consisting of formulae (III) and (IV) is at least 50 mole %, based on the number of moles of said recurring units.

7. A precursor according to claim 1, wherein $R^1$ of said $-OR^1$ is a monovalent group selected from the group consisting of:

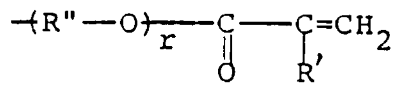
(I-1)

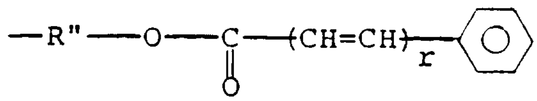
(I-2)

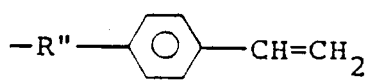
(I-3)

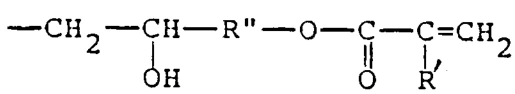
(I-4)

$-R''-CH=CH_2$ (I-5) , and

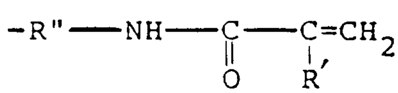
(I-6)

wherein R' represents a hydrogen atom or a methyl group, R'' represents an alkylene group having 1 to 3 carbon atoms, and r is an integer of 1 or 2.

**8.** A precursor according to claim 1, wherein $R^{2\oplus}$ of said $-O^{\ominus}R^{2\oplus}$ is represented by the formula:

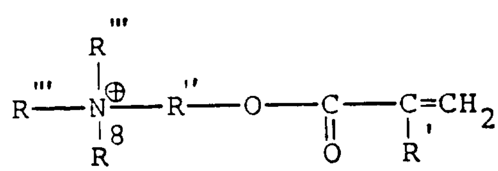
(I-7)

wherein each of R' and $R^8$ independently represents a hydrogen atom or a methyl group, R'' is an alkylene group having 1 to 3 carbon atoms, and R''' is a methyl group or an ethyl group.

**9.** A precursor according to claim 7, wherein said $R^1$ is a monovalent group of formula (I-1) or (I-4).

**10.** A photopolymerizable composition comprising:
(a) a precursor according to claim 2, and
(b) at least one photopolymerization initiator.

**11.** A composition according to claim 10, wherein said photopolymerization initiator is at least one oxime ester compound represented by the formula:

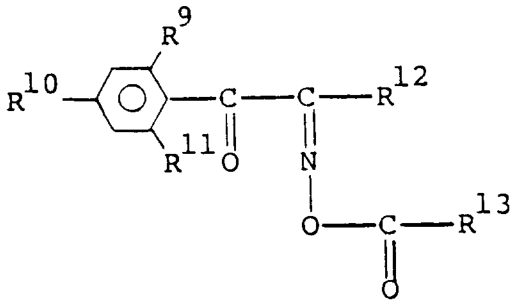

(V)

wherein each of $R^9$, $R^{10}$ and $R^{11}$ represents a hydrogen atom, an alkyl group having 1 to 6 carbon atoms, an alkoxy group having 1 to 6 carbon atoms or a nitro group;

$R^{12}$ represents an aromatic acyl group having 7 to 11 carbon atoms, an aliphatic acyl group having 2 to 7 carbon atoms, an alkoxycarbonyl group having 2 to 7 carbon atoms, an aromatic sulfonyl group having 6 to 10 carbon atoms or an aliphatic sulfonyl group having 1 to 6 carbon atoms; and

$R^{13}$ represents an alkyl group having 1 to 6 carbon atoms, an alkoxy group having 1 to 6 carbon atoms, an aromatic group having 6 to 10 carbon atoms or an aryloxy group having 6 to 10 carbon atoms.

**12.** A composition according to claim 10, wherein said photopolymerization initiator is present in the composition in an amount of from 0.1 to 20 % by weight, based on the weight of the precursor.

**13.** A composition according to claim 10, further comprising a monomer having a molecular weight of from 80 to 1000 and having a terminal group represented by the formula:

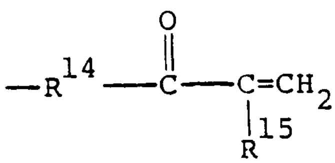

wherein $R^{14}$ represents -O- or -NH-, and $R^{15}$ represents a hydrogen atom or a methyl group.

**14.** A composite structure produced by a process comprising the steps of:

(1) applying to a substrate a polyimide precursor according to claim 1, and

(2) heating the substrate having said precursor thereon to convert said precursor to a polyimide corresponding thereto.

**15.** A composite structure produced by a process comprising the steps of:

(1) applying to a substrate a photopolymerizable composition according to claim 10, thereby forming a photosensitive element comprising said substrate and a photopolymerizable composition layer disposed thereon;

(2) image-wise exposing to actinic radiation said photosensitive element on its side of the photopolymerizable composition through an image-bearing transparency to crosslink the precursor of the exposed portion of the composition while leaving the precursor of the non-exposed portion of the composition non-crosslinked, thereby converting the photopolymerizable composition layer to a layer having photoinsolubilized image portions comprising the crosslinked precursor and non-photoinsolubilized image portions comprising the non-crosslinked precursor;

(3) washing out the non-photoinsolubilized image portions with a developer; and

(4) heating said substrate having thereon the photoinsolubilized image portions composed of the crosslinked precursor to imidize said crosslinked precursor.

## Patentansprüche

**1.** Vorläufer eines Polyimids mit niederer thermischer Spannung, der wiederkehrende Einheiten enthält, die durch mindestens eine aus der nachstehenden Gruppe ausgewählte Formel dargestellt sind

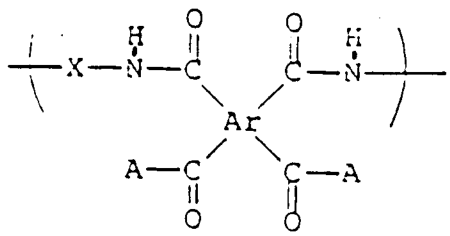

(I), und

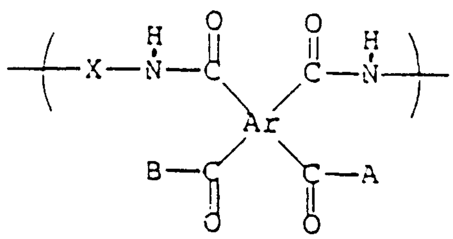

(II)

worin Ar eine vierwertige aromatische Gruppe mit 6 bis 30 Kohlenstoffatomen bedeutet,
X mindestens eine zweiwertige organische Gruppe mit 6 bis 30 Kohlenstoffatomen bedeutet, und
jedes von A und B unabhängig eine aus den nachstehenden ausgewählte Gruppe darstellt :
$-OR^1$,

$$-\overset{H}{N}R^1,$$

$-O^{\ominus}R^{2\oplus}$ und -OH,
wobei jedes von $R^1$ und $R^2$ unabhängig eine organische Gruppe mit 1 bis 20 Kohlenstoffatomen bedeutet,

mit der Maßgabe, daß A und B nicht gleichzeitig -OH bedeuten, wobei mindestens 20 Mol.-% der wiederkehrenden Einheiten Einheiten sind, die durch mindestens eine aus der nachstehenden Gruppe ausgewählte Formel dargestellt sind :

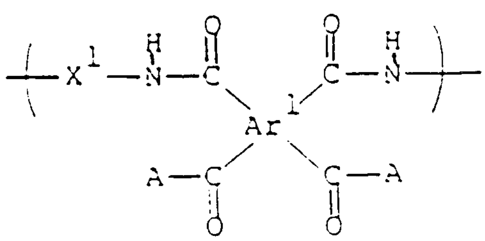

(III), und

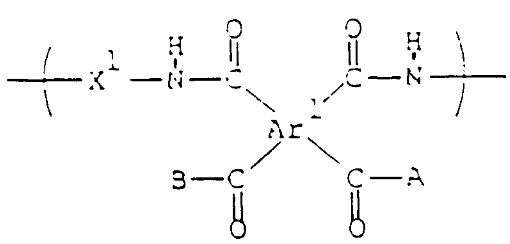

(IV)

worin $Ar^1$ eine vierwertige aromatische Gruppe bedeutet, die aus der Gruppe der nachstehenden ausgewählt ist

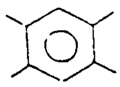, 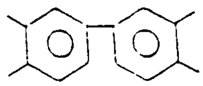 und 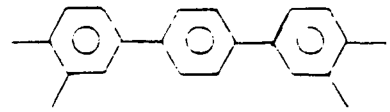 ,

A und B wie vorstehend definiert sind, und

$X^1$ mindestens eine zweiwertige Gruppe bedeutet, die aus der Gruppe der nachstehenden ausgewählt ist :

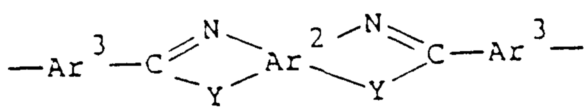 und

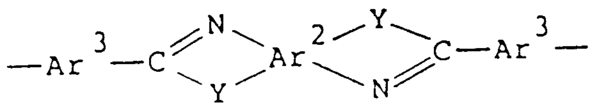 ,

worin $Ar^2$ eine vierwertige aromatische Gruppe bedeutet, die aus der Gruppe der nachstehenden Gruppen ausgewählt ist :

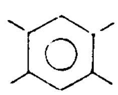, 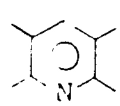 und 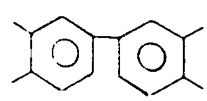

$Ar^3$ eine zweiwertige aromatische Gruppe bedeutet, die aus der Gruppe der nachstehenden Gruppen ausgewählt ist:

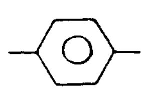, 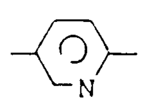 und 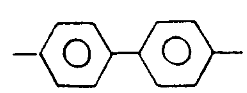 ,

und

Y eine zweiwertige Gruppe bedeutet, die aus der aus -O-, -S-,

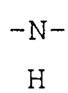 und 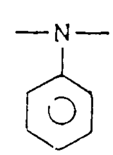

bestehenden Gruppe ausgewählt ist,

wobei dieser Vorläufer eine reduzierte Viskosität von 10 bis 200 ml/g, gemessen bei 30 °C an einer Lösung des Vorläufers von 1,0 g/dl in N-Methylpyrrolidon, hat.

**2.** Vorläufer nach Anspruch 1, wobei jedes von $R^1$ und $R^2$ unabhängig eine ethylenische Doppelbindung aufweist, wobei die wiederkehrenden Einheiten durch Formel (II) dargestellt sind und mindestens 20 Mol.-% der wiederkehrenden Einheiten Einheiten der Formel (IV) sind, und wobei die reduzierte Viskosität im Bereich von 10 bis 100 ml/g liegt.

**3.** Vorläufer nach Anspruch 1, wobei Ar eine vierwertige aromatische Gruppe bedeutet, die aus der Gruppe der folgenden ausgewählt ist :

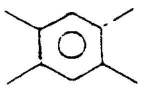 , 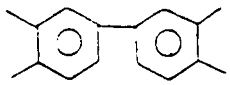 und 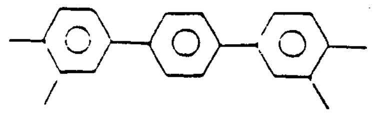 .

**4.** Vorläufer nach Anspruch 1, enthaltend als X mindestens eine Zweiwertige Gruppe, die aus der Gruppe der nachstehenden ausgewählt ist :

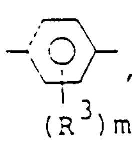 , 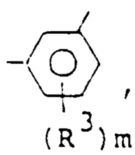 , 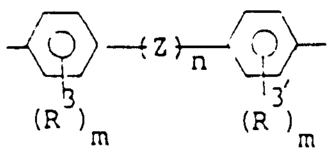 , 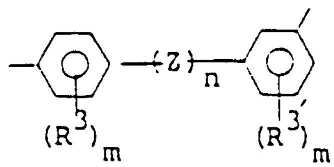 ,

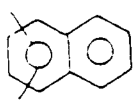 , 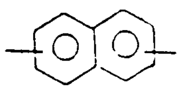 , 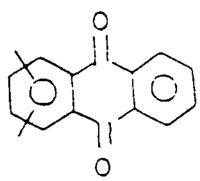 , 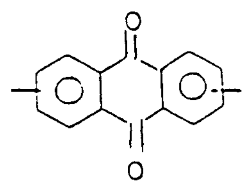 ,

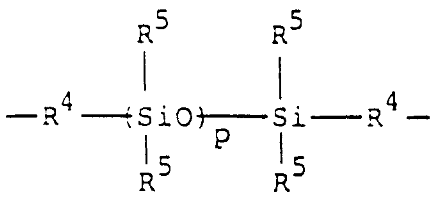 und 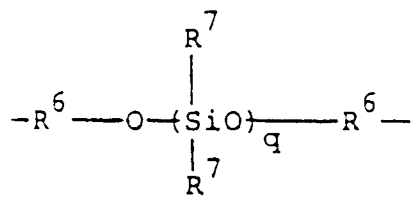

wobei jedes von $R^3$ und $R^{3'}$ unabhängig eine einwertige Gruppe bedeutet, die aus der aus einer Alkylgruppe, einer Alkoxygruppe, einer fluorierten Alkylgruppe und einer fluorierten Alkoxygruppe mit jeweils 1 bis 5 Kohlenstoffatomen oder einem Fluoratom bestehenden Gruppe ausgewählt ist,

Z eine zweiwertige Gruppe bedeutet, die aus der Gruppe der folgenden ausgewählt ist :

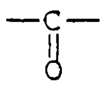, 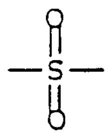, 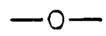, 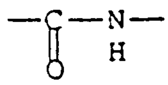, 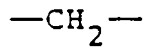, 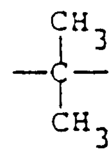, 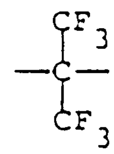,

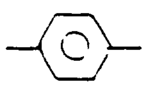, 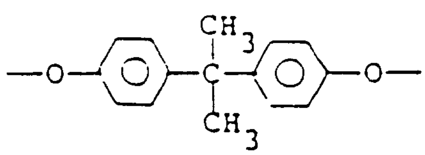, 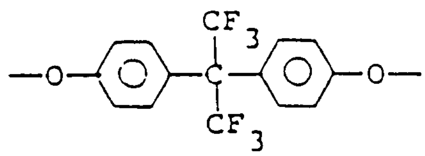

und 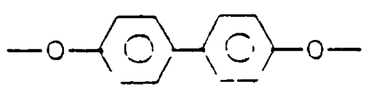;

jedes von $R^4$ und $R^6$ unabhängig einen zweiwertigen Kohlenwasserstoffrest mit 1 bis 14 Kohlenstoffatomen bedeutet,

jedes von $R^5$ und $R^7$ unabhängig einen einwertigen Kohlenwasserstoffrest mit 1 bis 16 Kohlenstoffatomen bedeutet und

m eine ganze Zahl von 0 bis 4 ist, n 0 oder die Zahl 1 ist und jedes von p und q unabhängig eine ganze Zahl gleich oder größer als 1 ist.

**5.** Vorläufer nach Anspruch 1, wobei die Einheit der Formel (III) durch eine aus der nachstehenden Gruppe ausgewählte Formel dargestellt ist :

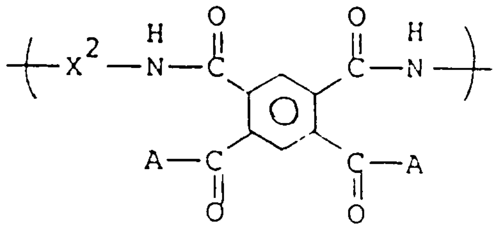

(III-1)

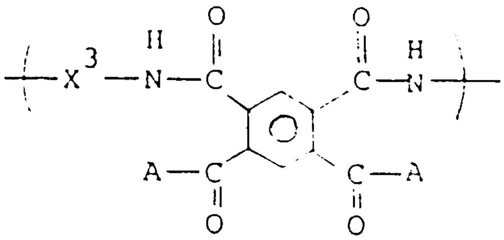

(III-2)

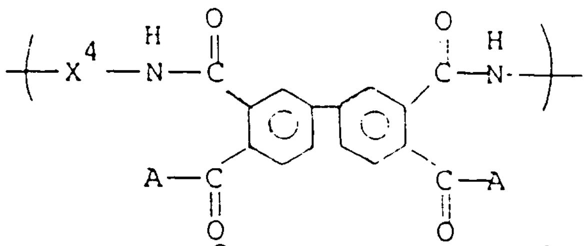

(III-3), und

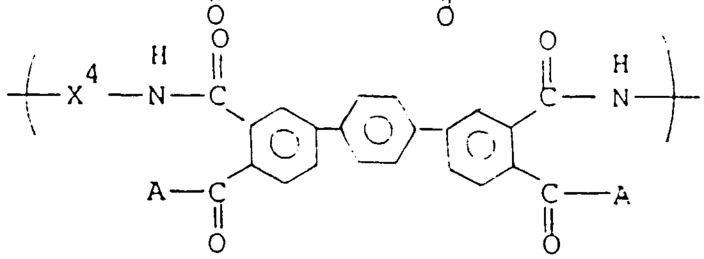

(III-4)

worin A wie vorstehend definiert ist,
$X^2$ mindestens eine aus der Gruppe der nachstehenden ausgewählte zweiwertige Gruppe bedeutet :

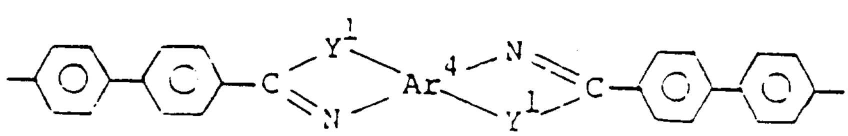

, und

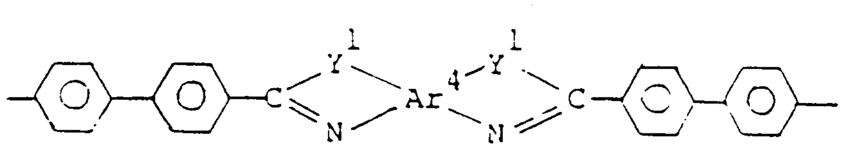

worin $Ar^4$ eine vierwertige Gruppe bedeutet, die unter folgenden Gruppen ausgewählt ist :

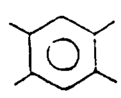

und

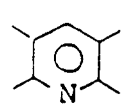

, und

$Y^1$ eine aus der nachstehenden Gruppe ausgewählte zweiwertige Gruppe bedeutet :

-O-, -S- und

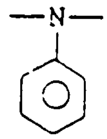

$X^3$ mindestens eine aus der nachstehenden Gruppe ausgewählte zweiwertige Gruppe bedeutet :

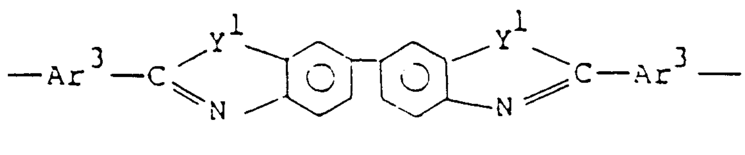 und

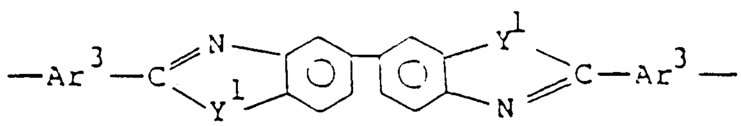

worin $Ar^3$ und $Y^1$ wie oben definiert sind und $X^4$ mindestens eine aus der nachstehenden Gruppe ausgewählte zweiwertige Gruppe bedeutet :

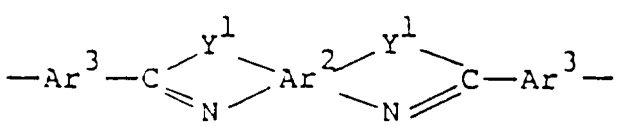 , und

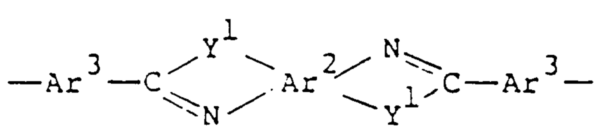

worin $Ar^2$, $Ar^3$ und $Y^1$ wie vorstehend definiert sind,

und die Einheit der Formel (IV) durch eine aus der nachstehenden Gruppe ausgewählte Formel dargestellt wird :

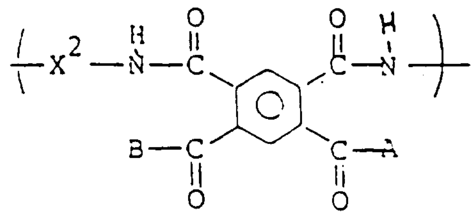

(IV-1)

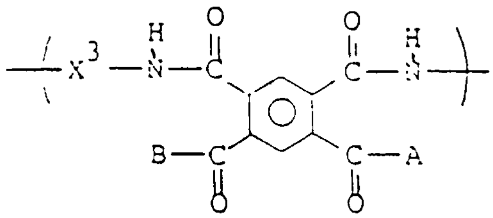

(IV-2)

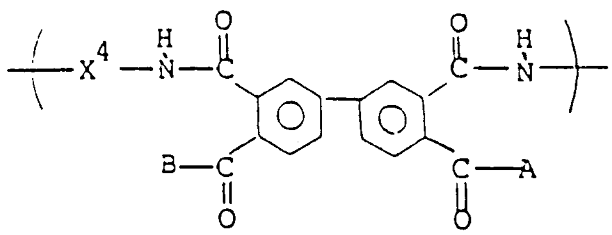

(IV-3), und

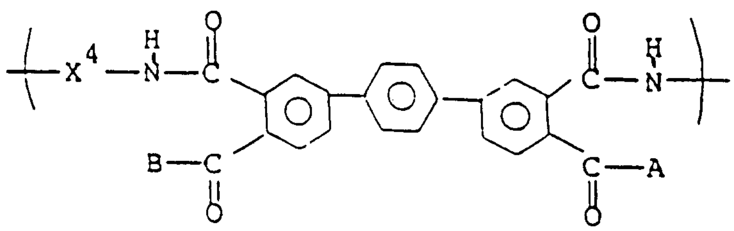

(IV-4)

wobei A, B, $X^2$, $X^3$ und $X^4$ wie vorstehend definiert sind.

**6.** Vorläufer nach Anspruch 1, wobei der Anteil der Einheiten, die durch mindestens eine Formel aus der Gruppe der Formeln (III) und (IV) ausgewählte Formel dargestellt sind, mindestens 50 Mol.-%, bezogen auf die Molzahl der wiederkehrenden Einheiten, beträgt.

**7.** Vorläufer nach Anspruch 1, wobei $R^1$ in $-OR^1$ eine aus der Gruppe der nachstehenden ausgewählte einwertige Gruppe ist :

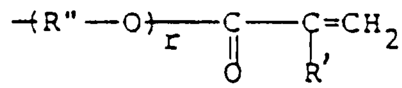

(I-1)

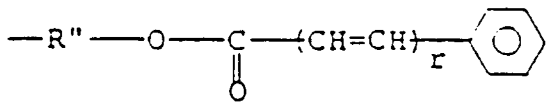

(I-2)

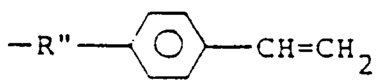

(I-3)

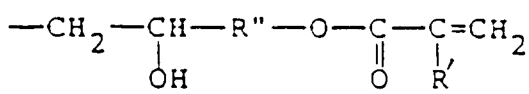

(I-4)

$-R''-CH=CH_2$ (I-5) , und

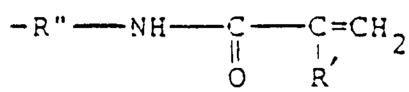

(I-6)

wobei R' ein Wasserstoffatom oder eine Methylgruppe bedeutet, R'' eine Alkylengruppe mit 1 bis 3 Kohlenstoffatomen bedeutet und r eine ganze Zahl 1 oder 2 ist.

**8.** Vorläufer nach Anspruch 1, wobei $R^{2\oplus}$ in $-O^{\ominus}R^{2\oplus}$ durch nachstehende Formel dargestellt ist :

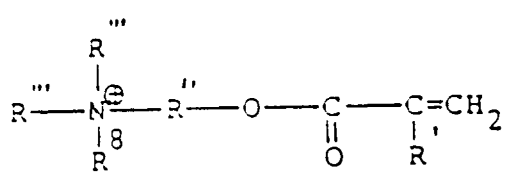

(I-7)

wobei jedes von R' und $R^8$ unabhängig ein Wasserstoffatom oder eine Methylgruppe bedeutet, R'' eine Alkylengruppe mit 1 bis 3 Kohlenstoffatomen ist und R''' eine Methylgruppe oder eine Ethylgruppe ist.

**9.** Vorläufer nach Anspruch 7, wobei $R^1$ eine einwertige Gruppe der Formel (I-1) oder (I-4) ist.

**10.** Photopolymerisierbare Zusammensetzung, enthaltend
(a) einen Vorläufer nach Anspruch 2 und
(b) mindestens einen Photopolymerisationsinitiator.

**11.** Zusammensetzung nach Anspruch 10, wobei der Photopolymerisationsinitiator mindestens eine Oximesterverbindung ist, die durch die Formel

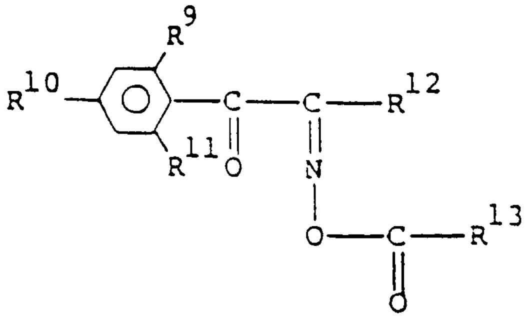

(V)

dargestellt ist,

worin jedes von $R^9$, $R^{10}$ und $R^{11}$ ein Wasserstoffatom, eine Alkylgruppe mit 1 bis 6 Kohlenstoffatomen, eine Alkoxygruppe mit 1 bis 6 Kohlenstoffatomen oder eine Nitrogruppe bedeutet,

$R^{12}$ eine aromatische Acylgruppe mit 7 bis 11 Kohlenstoffatomen, eine aliphatische Acylgruppe mit 2 bis 7 Kohlenstoffatomen, eine Alkoxycarbonylgruppe mit 2 bis 7 Kohlenstoffatomen, eine aromatische Sulfonylgruppe mit 6 bis 10 Kohlenstoffatomen oder eine aliphatische Sulfonylgruppe mit 1 bis 6 Kohlenstoffatomen bedeutet, und $R^{13}$ eine Alkylgruppe mit 1 bis 6 Kohlenstoffatomen, eine Alkoxygruppe mit 1 bis 6 Kohlenstoffatomen, eine aromatische Gruppe mit 6 bis 10 Kohlenstoffatomen oder eine Aryloxygruppe mit 6 bis 10 Kohlenstoffatomen bedeutet.

**12.** Zusammensetzung nach Anspruch 10, wobei der Photopolymerisationsinitiator in der Zusammensetzung in einer Menge von 0,1 bis 20 Gew.-%, bezogen auf das Gewicht des Vorläufers, vorhanden ist.

**13.** Zusammensetzung nach Anspruch 10, die zusätzlich ein Monomeres mit einem Molekulargewicht von 80 bis 1000 enthält, das eine durch die Formel

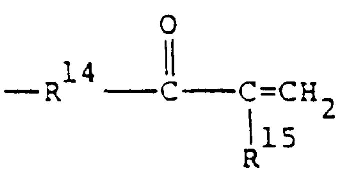

dargestellte endständige Gruppe aufweist, wobei $R^{14}$ -O- oder -NH- bedeutet und $R^{15}$ ein Wasserstoffatom oder eine Methylgruppe bedeutet.

**14.** Verbundstruktur, hergestellt mit Hilfe eines Verfahrens, das folgende Schritte umfaßt :

(1) Auftragen eines Polyimid-Vorläufers nach Anspruch 1 auf ein Substrat, und

(2) Erhitzen des mit dem Vorläufer versehenen Substrats, wobei der Vorläufer in ein entsprechendes Polyimid umgewandelt wird.

**15.** Verbundstruktur, hergestellt mit Hilfe eines Verfahrens, das folgende Schritte umfaßt :

(1) Auftragen einer photopolymerisierbaren Zusammensetzung nach Anspruch 10 auf ein Substrat unter Bildung eines photoempfindlichen Elements, welches das Substrat und eine darauf angeordnete Schicht einer photopolymerisierbaren Zusammensetzung enthält,

(2) bildmäßiges Bestrahlen des photoempfindlichen Elements von der Seite der photopolymerisierbaren Zusammensetzung mit aktinischer Strahlung durch eine bildtragende Bildvorlage, um den Vorläufer in dem bestrahlten Bereich der Zusammensetzung zu vernetzen, während der Vorläufer in dem nicht bestrahlten Bereich der Zusammensetzung unvernetzt bleibt, wobei die Schicht der photopolymerisierbaren Zusammensetzung in eine Schicht umgewandelt wird, die durch Bestrahlung unlöslich gewordene Bildbereiche, die den vernetzten Vorläufer enthalten, und nicht durch Bestrahlung unlöslich gemachte Bildbereiche, die den unvernetzten Vorläufer enthalten, aufweist,

(3) Auswaschen der nicht durch Strahlung vernetzten Bildbereiche mit einem Entwickler und
(4) Erhitzen des Substrats, auf dem sich die durch Bestrahlung unlöslich gemachten Bildbereiche, die aus dem vernetzten Vorläufer bestehen, befinden, wobei der vernetzte Vorläufer imidisiert wird.

## Revendications

**1.** Le précurseur d'un polyamide à faible susceptibilité thermique, comportant des unités récurrentes, représentées par au moins une formule choisie dans le groupe consistant en:

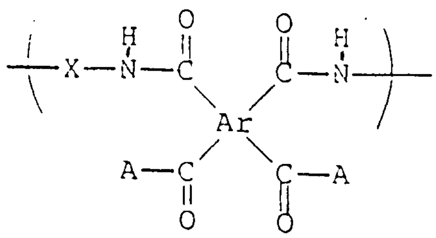

(I), et

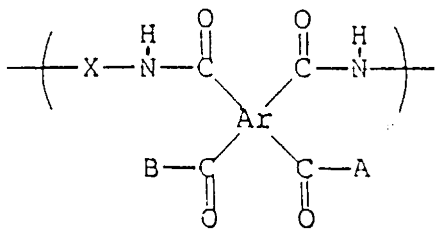

(II)

dans lequel Ar représente un groupe aromatique tétravalent comportant de 6 à 30 atomes de carbone, X représente au moins un groupe organique divalent comportant de 6 à 30 atomes de carbone, et chacun de A et B représente indépendamment l'un de l'autre un groupe choisi dans le groupe consistant en:

$-OR^1$,

$$-\overset{H}{N}R^1,$$

$-O^{(-)}R^{2(+)}$ et -OH,

dans lequel chacun de $R^1$ et $R^2$ représente indépendamment un groupe organique comportant de 1 à 20 atomes de carbone, pourvu que A et B ne soient pas simultanément -OH;

au moins 20% molaire de ces unités récurrentes étant des unités représentées par au moins une formule sélectionnée dans le groupe consistant en:

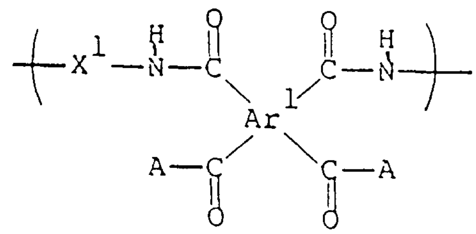

(III), et

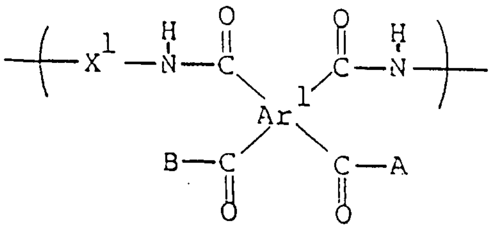

(IV)

dans lequel $Ar^1$ représente un groupe aromatique tétravalent sélectionné dans le groupe consistant en:

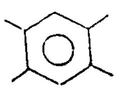 , 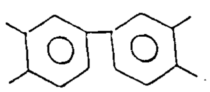 and 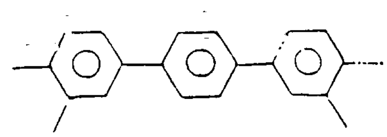

A et B étant définis comme ci-dessus, et
$X^1$ représentant au moins un groupe divalent sélectionné dans le groupe consistant en:

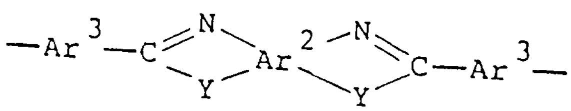

et

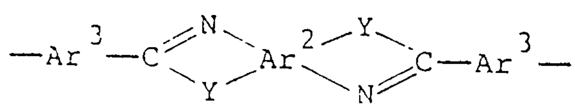 ,

dans lequel $Ar^2$ représente un groupe aromatique tétravalent sélectionné dans le groupe consistant en

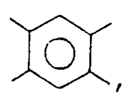 , 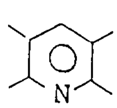 et 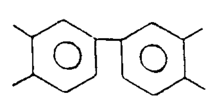

$Ar^3$ représente un groupe aromatique divalent sélectionné dans le groupe consistant en

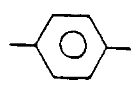 , 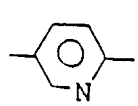 et 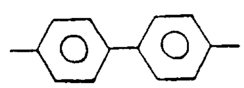 et

Y représente un groupe divalent sélectionné dans le groupe consistant en -O-, -S-,

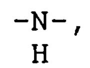 et 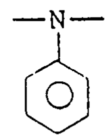

ledit précurseur ayant une viscosité faible entre 10 et 200 ml/g, mesurée à 30 C, sur à une solution à 1,0 g/dl du précurseur dans de la N-méthylpyrrolidone.

**2.** Un précurseur, tel que décrit dans la revendication 1, dans lequel chacun des groupes $R^1$ et $R^2$ possède indépendamment un double lien éthylénique, le dit précurseur comportant partiellement une structure acide polyamidique, et la dite viscosité réduite se situant dans la zone entre 10 et 100 ml/g.

**3.** Un précurseur, selon la revendication 1, dans lequel le dit Ar représente un groupe aromatique tétravalent sélectionné dans le groupe consistant en:

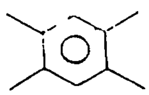 , 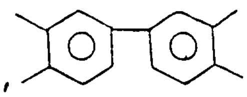 and 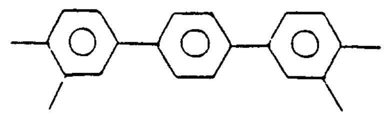 .

**4.** Un précurseur, selon la revendication 1, contenant en X au moins un groupe divalent sélectionné dans le groupe consistant en:

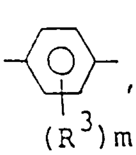 , 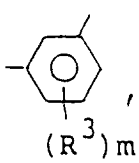 , 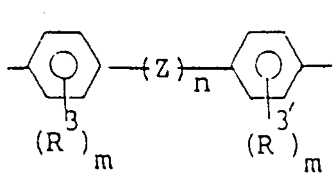 , 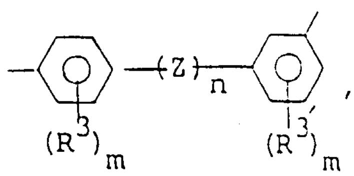 ,

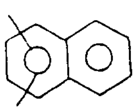 , 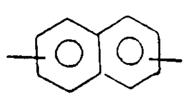 , 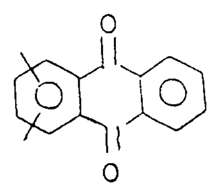 , 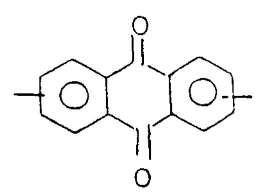

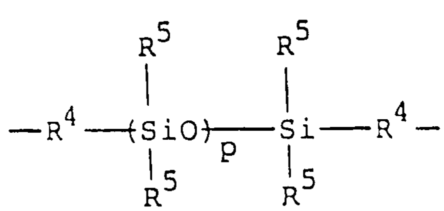 and 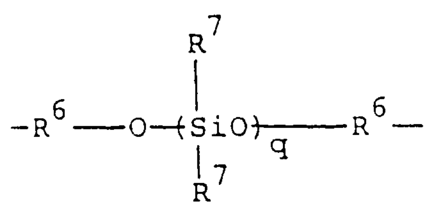

Dans lequel chacun des $R^3$ et $R^{3'}$ représente indépendamment un groupe monovalent sélectionné dans le groupe constant en un groupe alkyle, un groupe alkoxy, un groupe alkyle fluoré et un groupe alkoxy fluoré comportant chacun de 1 à 5 atomes de carbone ou un atome de fluor;
Z représente un groupe divalent sélectionné dans le groupe consistant en:

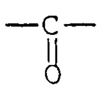, 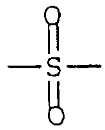, 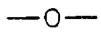, 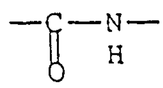, 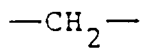, 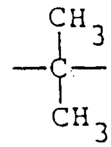, 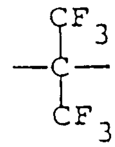,

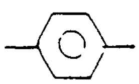, 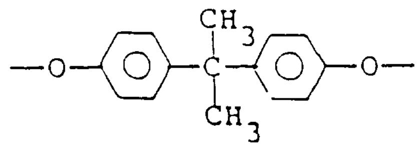, 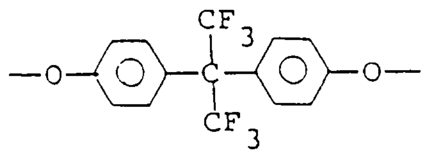

and 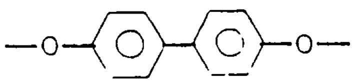;

chacun des $R^4$ et $R^6$ représente indépendamment un radical d'hydrocarbure divalent comportant de 1 à 14 atomes de carbone;
chacun des $R^5$ et $R^7$ représente indépendamment un radical d'hydrocarbure monovalent comportant de 1 à 16 atomes de carbone; et
m est un nombre entier compris de 0 à 4, n est 0 ou 1, et chacun des p et q étant indépendamment un entier supérieur à 1.

**5.** Un précurseur selon la revendication 1, dans lequel l'unité de la formule (III) est représentée par une formule sélectionnée dans le groupe consistant en:

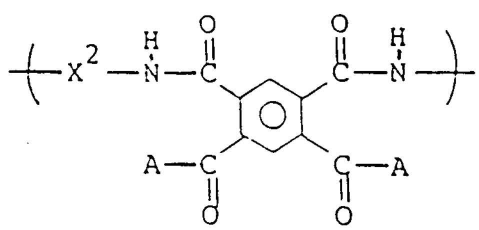

(III-1)

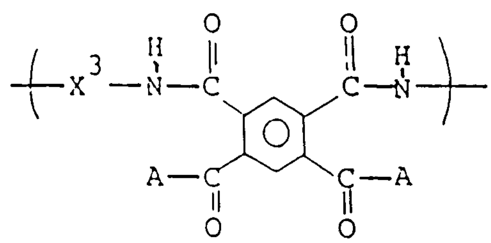

(III-2)

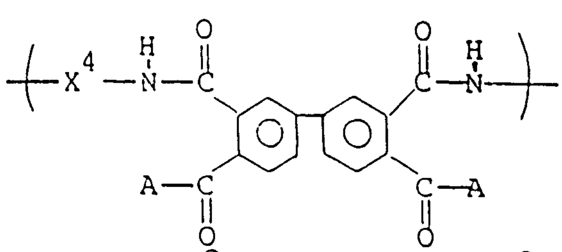

(III-3), and

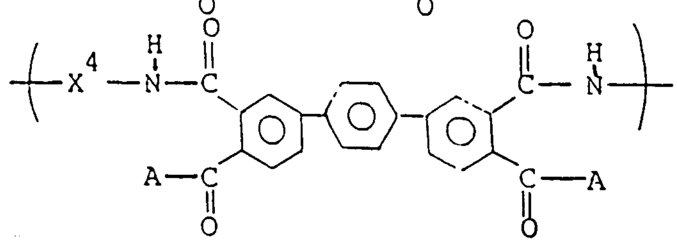

(III-4)

dans lesquels A et B sont définis comme ci-dessus,
$X^2$ représente au moins un groupe divalent sélectionné dans le groupe consistant en:

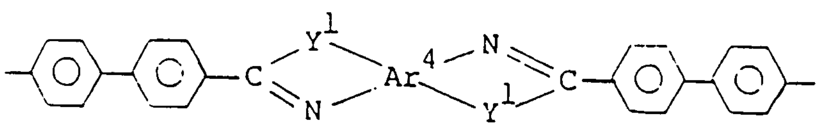

et

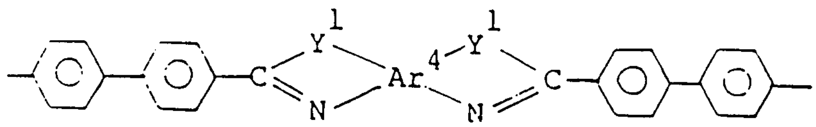

dans lequel $Ar^4$ représente un groupe tétravalent sélectionné dans le groupe consistant en:

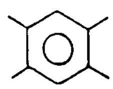

et

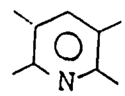

,

et
$Y^1$ représente un groupe divalent sélectionné dans le groupe consistant en:
-O-, -S- and

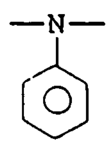

;

et
$X^3$ représente au moins un groupe divalent sélectionné dans le groupe consistant en:

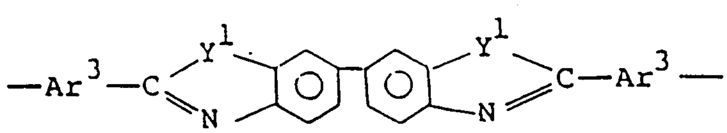

et

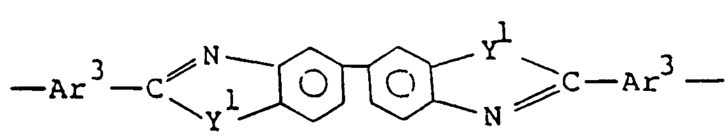

dans lequel $Ar^3$ et $Y^1$ sont définis comme ci-dessus, et
$X^4$ représente au moins un groupe divalent sélectionné dans le groupe consistant en:

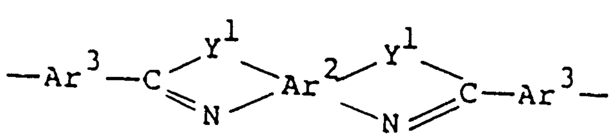

et

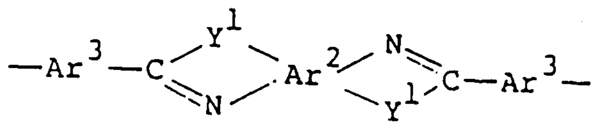

dans lequel $Ar^2$, $Ar^3$ et $Y^1$ sont définis comme ci-dessus, et l'unité de la formule (IV) est représentée

par une formule sélectionnée dans le groupe consistant en:

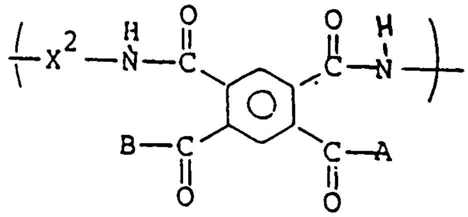

(IV-1)

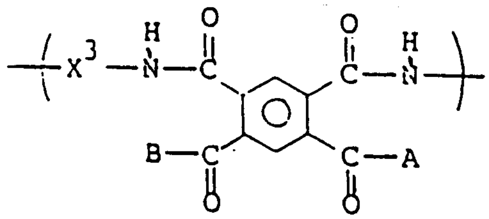

(IV-2)

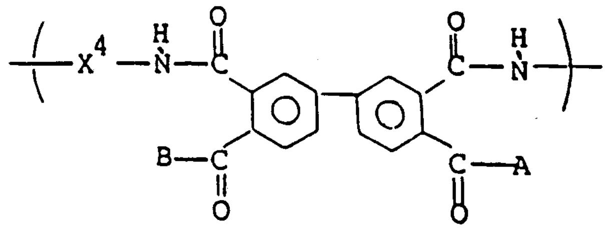

(IV-3), et

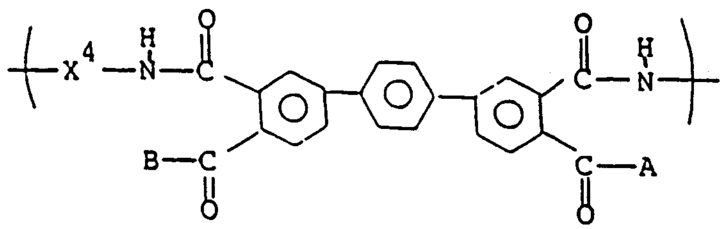

(IV-4)

dans lequel A, B, $X^3$ et $X^4$ sont définis comme ci-dessus.

6. Un précurseur selon la revendication 1, dans lequel la proportion des unités représentées par au moins une des formules sélectionnées dans le groupe de formules (III) et (IV) est d'au moins 50% molaires, basé sur le nombre de moles desdites unités récurrentes.

7. Un précurseur selon la revendication 1, dans lequel $R^1$ du dit $-OR^1$ est un groupe monovalent sélectionné dans le groupe consistant en:

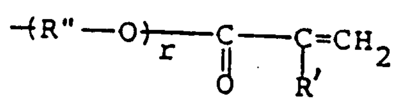

(I-1)

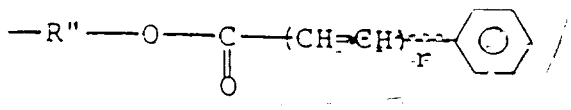

(I-2)

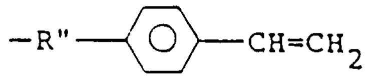

(I-3)

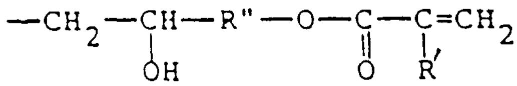

(I-4)

$-R''-CH=CH_2$ (I-5), et

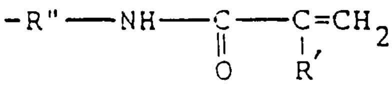

(I-6)

dans lequel R' représente un atome d'hydrogène ou un groupe méthyle, R'' représente un groupe alkylène comportant de 1 à 3 atomes de carbone, et r est 1 ou 2.

**8.** Un précurseur selon la revendication 1, dans lequel $R^{2(+)}$ du dit $-O^{(-)}R^{2(+)}$ est représenté par la formule:

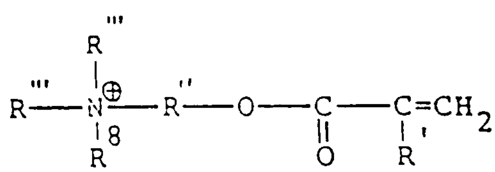

(I-7)

dans laquelle chacun des R' et $R^8$ représente indépendamment un atome d'hydrogène ou un groupe méthyle, R'' est un groupe alkylène comportant de 1 à 3 atomes de carbone, et R''' est un groupe méthyle ou un groupe éthyle.

**9.** Un précurseur selon la revendication 7, dans lequel le dit groupe $R^1$ est un groupe monovalent de formule (I-1) ou (I-4).

**10.** Une composition photopolymérisable comportant:
(a) Un précurseur selon la revendication 2, et
(b) au moins un initiateur de photopolymérisation.

**11.** Une composition selon la revendication 10, dans laquelle le dit initiateur de photopolymérisation est au moins un composé ester d'oxime représenté par la formule:

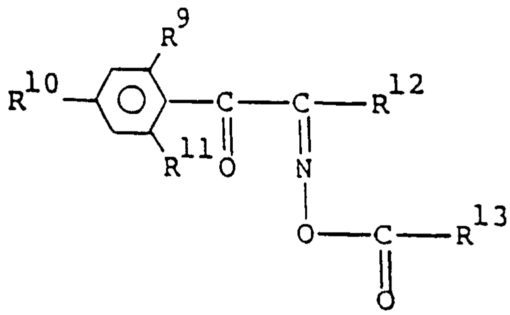

(V)

dans laquelle chacun des $R^9$, $R^{10}$ et $R^{11}$ représente un atome d'hydrogène, un groupe alkyle comportant de 1 à 6 atomes de carbone, un groupe alkoxy comportant de 1 à 6 atomes de carbone, ou un groupe nitré;
$R^{12}$ représente un groupe acyle aromatique comportant de 7 à 11 atomes de carbone, un groupe acyle aliphatique comportent de 2 à 7 atomes de carbone, un groupe alkoxycarbonyle comportant de 2 à 7 atomes de carbone, un groupe sulfonyle aromatique comportant de 6 à 10 atomes de carbone ou un groupe aromatique sulfonyle comportant de 1 à 6 atomes de carbone, et
$R^{13}$ représente un groupe alkyle comportant de 1 à 6 atomes de carbone, un groupe alkoxy comportant de 1 à 6 atomes de carbone, un groupe aromatique comportant de 6 à 10 atomes de carbone, ou un groupe aryloxy comportant de 6 à 10 atomes de carbone.

**12.** Une composition, selon la revendication 10, dans laquelle le dit initiateur de photopolymérisation est présent dans la composition à concurrence de 0,1 à 20% en poids, sur base du poids du précurseur.

**13.** Une composition selon la revendication 10, comportant en outre un monomère ayant un poids moléculaire compris entre 80 et 1000 et comportant un groupe terminal représenté par la formule:

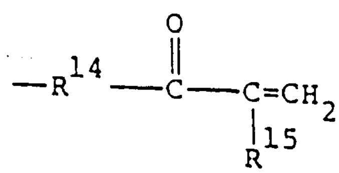

dans laquelle $R^{14}$ représente -O- ou -NH-, et $R^{15}$ représente un atome d'hydrogène ou un groupe méthyle.

**14.** Une structure composite produite par un procédé comportant les étapes suivantes:
(1) l'application sur un substrat d'un précurseur polyamide selon la revendication 1, et
(2) le chauffage de ce substrat portant le dit précurseur afin de convertir le dit précurseur en le polyimide qui lui correspond.

**15.** Une structure composite produite par un procédé comportant les étapes suivantes:
(1) l'application sur un substrat d'une composition photopolymérisable selon la revendication 10, formant ainsi un élément photosensitif comportant le dit substrat et une couche de composition photopolymérisable qui y est disposée;
(2) l'exposition, en forme d'image, à un rayonnement actinique, du dit élément photosensitif, du côté de la composition photopolymérisable, au travers d'un transparent portant une image, afin de polymériser le précurseur de la portion exposée de la composition, tout en laissant le précurseur de la portion non exposée de la composition non polymérisé, convertissant ainsi la couche de composition photo-polymérisable en une couche ayant des portions d'image rendues insolubles par exposition au rayonnement, et des portions d'image non rendues insolubles, comportant le précurseur non polymérisé;
(3) la dissolution des portions d'image non rendues insolubles au moyen d'un révélateur;
(4) le chauffage du dit substrat, portant les portions d'image rendues insolubles par exposition au rayonnement, composées du précurseur polymérisé, afin d'imidiser le dit précurseur polymérisé.

FIG. 1

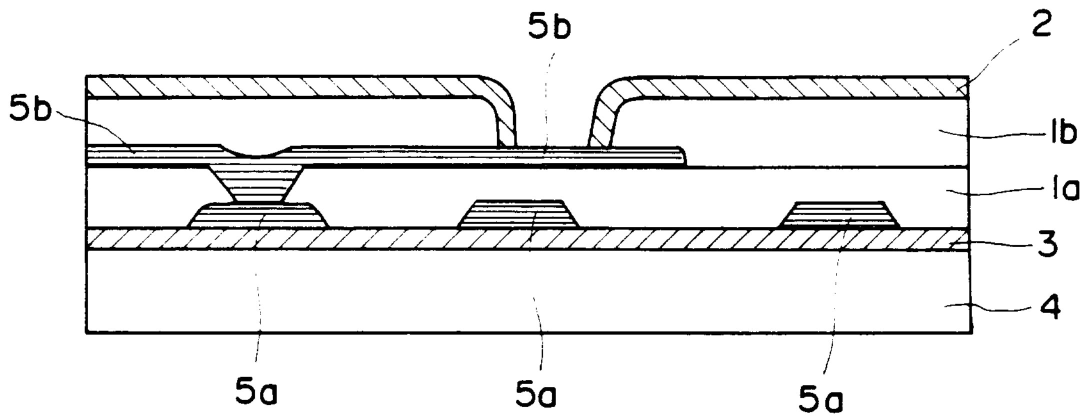


FIG. 2 (A)

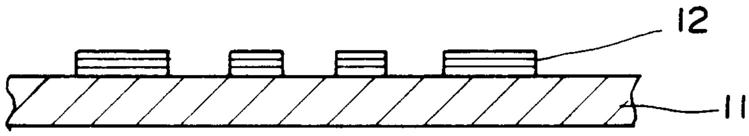


FIG. 2 (B)

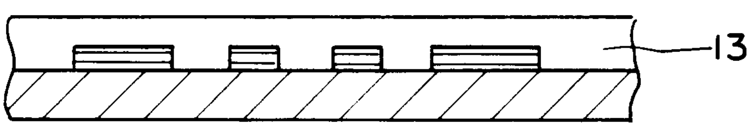

FIG.2(C)

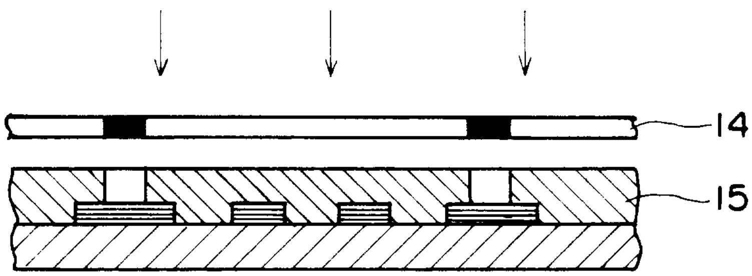


FIG.2(D)

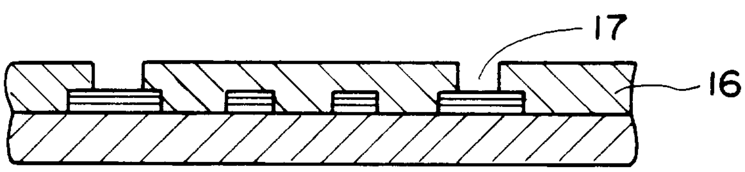


FIG.2(E)

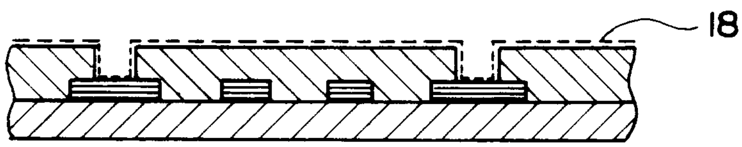

FIG. 2(F)

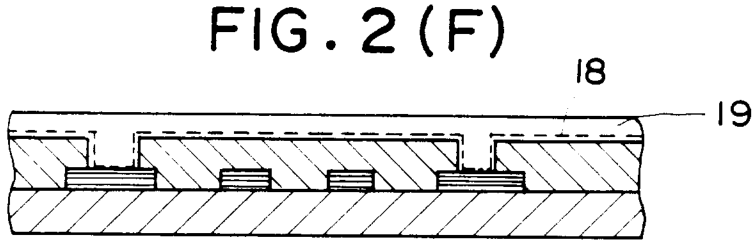


FIG. 2(G)

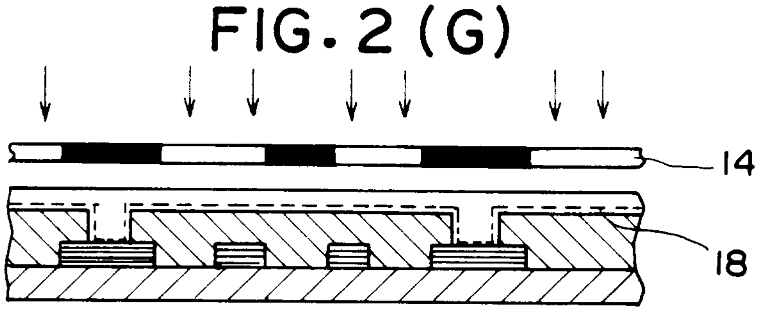


FIG. 2(H)

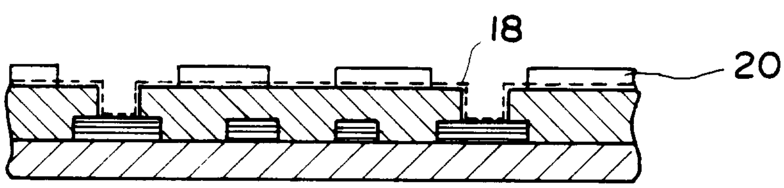


FIG. 2(I)

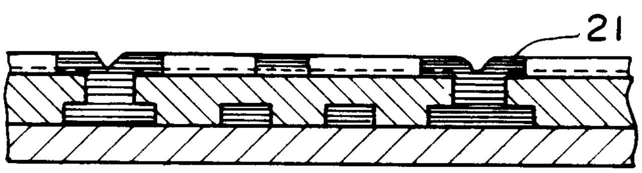


FIG. 2(J)